(19) Europäisches Patentamt
European Patent Office
Office européen des brevets

(11) **EP 2 953 042 B1**

(12) **EUROPÄISCHE PATENTSCHRIFT**

(45) Veröffentlichungstag und Bekanntmachung des Hinweises auf die Patenterteilung:
**23.02.2022 Patentblatt 2022/08**

(21) Anmeldenummer: **14171258.8**

(22) Anmeldetag: **05.06.2014**

(51) Internationale Patentklassifikation (IPC):
*H05K 3/00* (2006.01)        *G06F 30/00* (2020.01)
*G01R 31/28* (2006.01)        *G06F 30/367* (2020.01)
*G06F 30/398* (2020.01)

(52) Gemeinsame Patentklassifikation (CPC):
**G06F 30/398; G06F 30/00; G06F 30/367;**
G01R 31/2848

(54) **Ermitteln eines kürzesten bestimmungsfremden Strompfades in einer elektrischen Baueinheit**

Determination of a shortest improper current path in an electrical unit

Détermination d'un trajet de courant non conforme le plus court dans un composant électrique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**09.12.2015 Patentblatt 2015/50**

(60) Teilanmeldung:
**21209601.0**

(73) Patentinhaber: **Siemens Aktiengesellschaft**
**80333 München (DE)**

(72) Erfinder:
• **Martinek, Michael**
**90411 Nürnberg (DE)**
• **Prus, Magdalena**
**90411 Nürnberg (DE)**
• **Greiner, Günther**
**91341 Röttenbach (DE)**
• **Grosso, Roberto**
**91080 Uttenreuth (DE)**

(56) Entgegenhaltungen:
JP-A- 2003 256 498        JP-A- 2009 054 648
US-A1- 2004 254 749        US-A1- 2006 282 811

• **Dirk Müller ET AL: "Wenn der Strom auf dem Board andere Wege geht", Elektronikpraxis electronica Magazine, 1. Januar 2010 (2010-01-01), Seiten 12-14, XP055152151, Gefunden im Internet: URL:http://www.flowcad.de/datasheets/FlowCAD_PR_Wenn_der_Strom_auf_dem_Board_andere_Wege_geht.pdf [gefunden am 2014-11-11] & Norbert Löhr: "FlowCAD", , 27. April 2012 (2012-04-27), XP055152163, Gefunden im Internet: URL:http://www.flowcad.ch/cms/upload/Webinar/Webinar_Nextra.pdf [gefunden am 2014-11-11]**

**Beschreibung**

Die vorliegende Erfindung betrifft eine Einrichtung zum Ermitteln eines kürzesten bestimmungsfremden Strompfades zwischen wenigstens zwei in einem bestimmungsgemäßen Betrieb mit einem unterschiedlichen elektrischen Potential beaufschlagten, elektrisch leitfähigen Bauteilen einer eine Mehrzahl von elektrisch leitfähigen und elektrisch isolierenden Bauteilen aufweisenden elektrischen Baueinheit. Darüber hinaus betrifft die Erfindung ein Verfahren zum Ermitteln eines kürzesten bestimmungsfremden Strompfades zwischen wenigstens zwei in einem bestimmungsgemäßen Betrieb mit einem unterschiedlichen elektrischen Potential beaufschlagten, elektrisch leitfähigen Bauteilen einer eine Mehrzahl von elektrisch leitfähigen und elektrisch isolierenden Bauteilen aufweisenden elektrischen Baueinheit. Schließlich betrifft die Erfindung ein Rechnerprogrammprodukt.

Elektrische Baueinheiten sind in vielfältigster Weise im Gebrauch und dienen der Durchführung unterschiedlichster Aufgaben und Tätigkeiten. Sie umfassen beispielsweise elektromechanische Einrichtungen, elektronische Einrichtungen, elektrochemische Einrichtungen, Kombinationen hiervon und/oder dergleichen. Im Allgemeinen dienen sie ferner der Energiewandlung von elektrischer Energie in eine andere physikalische Energieform oder umgekehrt. Darüber hinaus ist eine Vielzahl unterschiedlichster Steuerungen bekannt, die auf Basis elektrischer Baueinheiten realisiert sind. Für den bestimmungsgemäßen zuverlässigen Betrieb sind Fragen für die elektrische Sicherheit derart relevant, dass diesbezüglich umfangreiche Normen vorliegen, die von den elektrischen Baueinheiten einzuhalten sind. Relevante Normen für elektrische Baueinheiten sind beispielsweise die DIN EN 60664 bzw.

VDE 0110, DIN EN 61800-5-1 bzw. VDE 01160-105-1, UL 840 und/oder dergleichen. Darüber hinaus gibt es noch eine Vielzahl weiterer Normen, die die elektrische Sicherheit von elektrischen Baueinheiten betreffen.

Ein wesentlicher Aspekt der elektrischen Sicherheit bei elektrischen Baueinheiten betrifft minimale Abstände zwischen elektrischen Bauteilen der elektrischen Baueinheiten, die im bestimmungsgemäßen Betrieb mit unterschiedlichem elektrischen Potential beaufschlagt sind, zwischen denen also eine elektrische Spannung anliegt. So sieht die Normung insbesondere vor, dass zwischen solchen elektrischen Bauteilen Mindestabstände bzw. Mindeststrecken einzuhalten sind, und zwar minimale Luftstrecken sowie minimale Kriechstrecken, die beispielsweise die Ausbreitung bestimmungsfremder Strompfade über Oberflächen von elektrisch isolierenden Bauteilen der elektrischen Baueinheit berücksichtigen. Insgesamt geht es bei der elektrischen Sicherheit vorzugsweise also darum, bestimmungsfremde Strompfade durch Einhalten der Normen in der elektrischen Baueinheit zu vermeiden und auf diese Weise einen zuverlässigen, bestimmungsgemäßen Betrieb der elektrischen Baueinheit zu ermöglichen. Dies kann ferner umfassen, Personen während des bestimmungsgemäßen Betriebs der elektrischen Baueinheit vor Einwirkungen elektrischer Energie weitgehend zu schützen.

Im Stand der Technik ist es diesbezüglich bisher üblich, zu diesem Zweck Prototypen der elektrischen Baueinheit zu erstellen und diesen aufwendig hinsichtlich Kriech- und Luftstrecken im Sinne der entsprechenden anwendbaren Normung zu prüfen. Stellt sich während einer solchen Prüfung ein Mangel heraus, so ist die Konstruktion der elektrischen Baueinheit entsprechend zu überarbeiten und ein neuer Prototyp herzustellen, der einer erneuten Prüfung zugrundegelegt wird. Darüber hinaus erweist es sich als sehr aufwendig, die Einhaltung der Vielzahl der gegebenenfalls relevanten Normen zu prüfen.

Eine Verbesserung hierzu offenbart die US 2004/0254749 A1, die ein Isolationsverifikationssystem, ein Verfahren sowie ein Speichermedium hierfür offenbart. Ferner offenbart die US 2006/0282811 A1 eine Leiterplattenentwurfsunterstützungseinrichtung, ein Verfahren sowie ein Programmmedium hierfür. Schließlich offenbart Dirk Müller et al. in Elektronikpraxis, electronica Magazine, Januar 2010, Seiten 12 bis 14, einen Artikel "Wenn der Strom auf dem Board andere Wege geht".

In dem Artikel "FINDING THE SHORTEST PATH FOR QUALITY ASSURANCE OF ELECTRIC COMPONENTS" der Proceedings of DETC'02 ASME 2002 Design Engineering Technical Conference als auch dem Spark Analysis Extension Paper von Pro/Engineer wird ebenfalls eine Abstands- und Kriechanalyse aufgezeigt.

Es ist die Aufgabe der Erfindung, die Ermittlung bestimmungsfremder Strompfade, insbesondere unter Berücksichtigung der Normung, zu verbessern.

Als Lösung schlägt die Erfindung eine Einrichtung gemäß dem unabhängigen Anspruch 1 vor. Darüber hinaus schlägt die Erfindung ein Verfahren gemäß dem weiteren unabhängigen Anspruch 2 vor. Schließlich schlägt die Erfindung auch ein Rechnerprogrammprodukt gemäß dem weiteren unabhängigen Anspruch 19 vor. Weitere Ausgestaltungen ergeben sich anhand von Merkmalen der abhängigen Ansprüche.

Vorrichtungsseitig schlägt die Erfindung insbesondere eine Einrichtung zum Ermitteln eines kürzesten bestimmungsfremden Strompfades zwischen wenigstens zwei in einem bestimmungsgemäßen Betrieb mit einem unterschiedlichen elektrischen Potential beaufschlagten elektrisch leitfähigen Bauteilen einer eine Mehrzahl von elektrisch leitfähigen und elektrisch isolierenden Bauteilen aufweisenden elektrischen Baueinheit vor, mit:

   a) einer Bauteilerfassungseinheit zum Erfassen von allen Bauteilen der Baueinheit und deren Geometrie,
   b) einer Anordnungserfassungseinheit zum Erfassen der Anordnung der Bauteile in der Baueinheit zueinander,

c) einer Werkstofferfassungseinheit zum Erfassen von Werkstoffeigenschaften der erfassten Bauteile und/oder Zuordnen von Werkstoffeigenschaften zu den Bauteilen,

d) einer Leitfähigkeitsermittlungseinheit zum Ermitteln der elektrisch leitfähigen Bauteile anhand der Werkstoffeigenschaften sowie deren elektrisches Potential im bestimmungsgemäßen Betrieb,

e) einer Auswähleinheit zum Auswählen eines im bestimmungsgemäßen Betrieb mit einem ersten elektrischen Potential beaufschlagten ersten elektrisch leitfähigen Bauteils,

f) einer Strahlerzeugungseinheit zum Erzeugen einer Mehrzahl von geraden und/oder richtungsändernden Strahlen, deren Startpunkt das erste Bauteil bildet, indem für die digitalisiert gerastert erfassten Bauteile konvexe Bauteilkanten ermittelt werden und die Strahlen ermittelt werden, die unmittelbar eine konvexe Bauteilkante treffen, und wobei ein Punkt des Strahles mit dem kürzesten Abstand zwischen dem ersten elektrischen Bauteil und der konvexen Bauteilkante als Schnittpunkt ermittelt wird, bei dem ein Silhouettenkriterium erfüllt ist, wobei das Silhouettenkriterium angibt, ob sich ein Kantenpunkt auf einer Silhouettenkante der Szene befindet, wodurch Strahlen leicht ermittelt und von der weiteren Bearbeitung ausschließbar sind, die unmittelbar auf ein Bauteil auftreffen,

g) einer Ermittlungseinheit zum Ermitteln in Abhängigkeit von der Geometrie und Anordnung der erfassten Bauteile, welche der Strahlen ein zweites elektrisches Bauteil der Baueinheit treffen, welches anhand seiner Werkstoffeigenschaften als elektrisch leitfähig klassifiziert ist, wobei die Ermittlungseinheit ausgebildet ist, einen Auftreffpunkt des jeweiligen Strahls am zweiten Bauteil zu ermitteln, sofern es einen gibt,

h) einer Längenermittlungseinheit zum Ermitteln von Streckenlängen vom jeweiligen Startpunkt zum jeweiligen Auftreffpunkt derjenigen Strahlen, die ausgehend vom ersten Bauteil das zweite Bauteil treffen, und

i) einer Auswerteeinheit zum Ermitteln und Ausgeben der kürzesten der ermittelten Streckenlängen als kürzester bestimmungsfremder Strompfad.

Verfahrensseitig schlägt die Erfindung insbesondere ein Verfahren zum Ermitteln eines kürzesten bestimmungsfremden Strompfades zwischen wenigstens zwei in einem bestimmungsgemäßen Betrieb mit einem unterschiedlichen elektrischen Potential beaufschlagten elektrisch leitfähigen Bauteilen einer eine Mehrzahl von elektrisch leitfähigen und elektrisch isolierenden Bauteilen aufweisende elektrische Baueinheit vor, mit folgenden Schritten:

a) Erfassen von allen Bauteilen der Baueinheit und deren Geometrie,

b) Erfassen der Anordnung der Bauteile in der Baueinheit zueinander,

c) Erfassen von Werkstoffeigenschaften der erfassten Bauteile und/oder Zuordnen von Werkstoffeigenschaften zu den Bauteilen,

d) Ermitteln der elektrisch leitfähigen Bauteile anhand der Werkstoffeigenschaften sowie deren elektrisches Potential im bestimmungsgemäßen Betrieb,

e) Auswählen eines im bestimmungsgemäßen Betrieb mit einem ersten elektrischen Potential beaufschlagten ersten elektrisch leitfähigen Bauteils,

f) Erzeugen einer Mehrzahl von geraden und/oder richtungsändernden Strahlen, deren Startpunkt das erste Bauteil bildet, indem für die digitalisiert gerastert erfassten Bauteile konvexe Bauteilkanten ermittelt werden und die Strahlen ermittelt werden, die unmittelbar eine konvexe Bauteilkante treffen, und wobei ein Punkt des Strahles mit dem kürzesten Abstand zwischen dem ersten elektrischen Bauteil und der konvexen Bauteilkante als Schnittpunkt ermittelt wird, bei dem ein Silhouettenkriterium erfüllt ist, wobei das Silhouettenkriterium angibt, ob sich ein Kantenpunkt auf einer Silhouettenkante der Szene befindet, wodurch Strahlen leicht ermittelt und von der weiteren Bearbeitung ausgeschlossen werden, die unmittelbar auf ein Bauteil auftreffen,

g) Ermitteln in Abhängigkeit von der Geometrie und Anordnung der erfassten Bauteile, welche der Strahlen ein zweites elektrisches Bauteil der Baueinheit treffen, welches anhand seiner Werkstoffeigenschaften als elektrisch leitfähig klassifiziert ist, wobei ein Auftreffpunkt des jeweiligen Strahls am zweiten Bauteil ermittelt wird, sofern es einen gibt,

h) Ermitteln von Streckenlängen vom jeweiligen Startpunkt zum jeweiligen Auftreffpunkt derjenigen Strahlen, die ausgehend vom ersten Bauteil das zweite Bauteil treffen, und

i) Ermitteln und Ausgeben der kürzesten der ermittelten Streckenlängen als kürzester bestimmungsfremder Strompfad.

Schließlich schlägt die Erfindung insbesondere ein Rechnerprogrammprodukt umfassend ein Programm für eine Rechnereinheit mit Programmcodeabschnitten eines Programms zum Ausführen der Schritte des erfindungsgemäßen Verfahrens vor, wenn das Programm durch die Rechnereinheit ausgeführt wird, sodass die Rechnereinheit wenigstens einen kürzesten bestimmungsfremden Strompfad in einer Baueinheit ermittelt.

Die Erfindung ermöglicht es auf diese Weise, eine automatische Prüfung in Bezug auf den kürzesten bestimmungsfremden Strompfad, insbesondere Prüfung zur Einhaltung sämtlicher Normen, zu realisieren. Besonders vorteilhaft erweist es sich, dass sich die Erfindung bereits in der Konstruktionsphase der elektrischen Baueinheit integrieren lässt, sodass bereits während der Konstruktion der elektrischen Baueinheit das Einhalten der durch die Normung vorgegebenen Vorschriften realisiert werden kann. Dadurch kann das aufwendige Anfertigen von Prototypen mit anschließender Überprüfung der Einhaltung der anwendbaren Vorschriften reduziert oder sogar eingespart werden, sodass allenfalls nur noch ein einziger Prototyp angefertigt zu werden braucht, der bereits sämtliche Vorschriften hinsichtlich bestimmungsfremder Strompfade, insbesondere in Bezug auf die Normung, einhält. Dadurch kann der Aufwand für die Konstruktion und die Prüfung erheblich reduziert werden.

Zugleich ermöglicht es die Erfindung erstmals, eine automatische Prüfung zur Ermittlung bestimmungsfremder Strompfade, insbesondere zur Einhaltung sämtlicher Normen zugleich, vorzusehen. Hierdurch kann der Aufwand für die Konstruktion weiter reduziert werden. Die Erfindung ermöglicht es dadurch, nicht nur Kosten einzusparen, sondern eine Konstruktion der elektrischen Baueinheit auch hinsichtlich des Zeitaufwandes erheblich zu straffen. Dadurch können Entwicklungszeiten reduziert werden.

Die Ermittlung des kürzesten bestimmungsfremden Strompfades ermöglicht es, diesen mit den durch die Normung vorgegebenen Mindestlängen bzw. Mindeststrecken für den bestimmungsgemäßen Betrieb der elektrischen Baueinheit zu vergleichen und eine Entscheidung zu treffen, ob die entsprechende Norm bzw. Vorschrift eingehalten wird. Dies betrifft insbesondere das Einhalten von Kriech- und Luftstrecken, die durch die Norm vorgegeben sind. Solche Strecken dürfen durch die Konstruktion bzw. den Aufbau elektrischer Baueinheiten nicht unterschritten werden.

Ein bestimmungsfremder Strompfad ist ein Weg vorzugsweise innerhalb der elektrischen Baueinheit, auf dem ein Stromfluss während des bestimmungsgemäßen Betriebs der elektrischen Baueinheit erfolgen kann. Der bestimmungsfremde Strompfad entsteht folglich zwischen wenigstens zwei elektrisch leitfähigen Bauteilen der elektrischen Baueinheit, die mit einem unterschiedlichen elektrischen Potential beaufschlagt sind, zwischen denen also eine elektrische Spannung anliegt. Der bestimmungsfremde Strompfad kann beispielsweise über eine Luftstrecke, aber auch entlang einer Oberfläche wenigstens eines elektrisch isolierenden Bauteils der elektrischen Baueinheit erfolgen, wodurch eine Kriechstrecke ausgebildet wird. Die Kriechstrecke kann auch über mehrere vorzugsweise aneinandergrenzende Bauteile ausgebildet sein.

Eine Baueinheit ist vorzugsweise eine Gesamtheit aus einem oder mehreren Bauteilen, die aufgrund ihrer Konstruktion eine gewünschte Funktion bereitstellen kann. Ein Bauteil ist somit ein Bestandteil der Baueinheit, welches mit den weiteren Bauteilen zumindest teilweise zusammenwirkt, um die gewünschte

Funktion der Baueinheit bereitstellen zu können. Ein Bauteil kann beispielsweise eine Leiterplatte, insbesondere eine Leiterbahn auf der Leiterplatte, ein elektronisches Bauteil wie zum Beispiel ein Widerstand, eine Spule, ein Kondensator, ein Transistor, ein integrierter Schaltkreis, aber auch ein mechanisches Element wie ein Gehäuse, ein Befestigungsmittel wie eine Schraube, ein Niet, eine Klammer, Kombinationen hiervon oder dergleichen sein.

Je nach Art des Weges, das heißt, durch einen Luftweg oder einen Weg entlang einer Oberfläche des elektrisch isolierenden Bauteils, handelt es sich um eine Luftstrecke bzw. eine Kriechstrecke. Für diese bestimmungsfremden Strompfade legt die Normung Mindestlängen bzw. Mindeststrecken fest. In der Regel erfolgt der bestimmungsfremde Strompfad entlang eines kürzesten Weges bzw. einer kürzesten Strecke zwischen den elektrisch leitfähigen Bauteilen. Dieser kürzeste Weg soll die Mindeststrecke, die durch die Normung vorgeschrieben ist, nicht unterschreiten. Zu diesem Zweck wird mit der Erfindung zunächst der kürzeste bestimmungsfremde Strompfad ermittelt, der dann mit einer Mindeststreckenlänge, die durch die anwendbare Normung vorgegeben ist, verglichen werden kann. Auf diese Weise kann die Entscheidung getroffen werden, ob die elektrische Baueinheit diesbezüglich die entsprechende anwendbare Normung einhält.

Es wird vorgeschlagen, dass für die insbesondere digitalisiert gerastert erfassten Bauteile konvexe Bauteilkanten ermittelt werden. Die Ermittlung konvexer Bauteilkanten dient vorzugsweise dem Zweck, einen bestimmungsfremden Strompfad durch die Luft ermitteln zu können, bei dem Bauteile im unmittelbaren direkten Weg des Strahls zwischenliegen. In einem solchen Fall kann unter bestimmten Umständen eine Bauteilkante von einem Strahl getroffen sein und - ähnlich wie der Sattelpunkt - als Startpunkt zum Erzeugen einer Mehrzahl von Kantenstrahlen dienen. Auch hier ergibt sich die entsprechende Luftstrecke durch die Summe der durch die beiden Strahlen vorgegebenen Streckenlängen.

Eine konvexe Bauteilkante ist insbesondere eine Kante eines Bauteils, die durch wenigstens zwei aneinandergrenzende Oberflächen des Bauteils ausgebildet ist und die bei Betrachtung der Oberflächen von außen einen Winkel zwischen den die Bauteilkante bildenden Oberflächen des Bauteils von größer als 180° ausbildet. Im gegenteiligen Fall wird eine konkave Bauteilkante ausgebildet.

Es wird zudem vorgeschlagen, dass die Strahlen ermittelt werden, die unmittelbar eine konvexe Bauteilkante treffen. Dadurch können für die Ermittlung von Luftstrecken auch Bauteile berücksichtigt werden, die sich im unmittelbaren, direkten Weg des Strahls befinden. Dabei wird davon ausgegangen, dass ein Strahl, der ein Bauteil trifft, an diesem endet. Eine Sonderbehandlung ergibt sich lediglich für die bereits zuvor erwähnten Sattelpunkte sowie auch für die Bauteilkanten im vorliegenden Fall.

Darüber hinaus wird vorgeschlagen, dass ein Punkt des Strahles mit dem kürzesten Abstand zwischen dem ersten elektrischen Bauteil und der konvexen Bauteilkante als Schnittpunkt ermittelt wird, bei dem ein Silhouettenkriterium erfüllt ist. Das Silhouettenkriterium ist ein bauteilbezogenes Kriterium und bezieht sich auf die Gesamtheit der konvexen Kanten eines jeweiligen Bauteils. Dadurch können Strahlen leicht ermittelt und von der weiteren Bearbeitung ausgeschlossen werden, die unmittelbar auf ein Bauteil auftreffen. Lediglich Strahlen, die die konvexen Bauteilkanten treffen, werden berücksichtigt.

Dem Grunde nach ermöglicht es die Erfindung also, Kriech- und/oder Luftstrecken einer elektrischen Baueinheit vorzugsweise bereits während der Konstruktion zu ermitteln, sodass die Baueinheit auf Einhaltung anwendbarer Normen geprüft werden kann. Dabei erweist sich die Erfindung insofern als vorteilhaft, dass sie nicht nur geeignet ist, Kriechstrecken oder Luftstrecken zu ermitteln, sondern sie kann vorteilhafterweise auch derart eingesetzt werden, dass sie gleichzeitig Kriech- und Luftstrecken ermitteln kann. Dies ist durch das im Folgenden noch detailliert dargestellte erfinderische Prinzip ermöglicht.

Zunächst sieht die Erfindung vor, dass mittels einer Bauteileerfassungseinheit alle Bauteile der Baueinheit sowie auch deren Geometrie, das heißt, die Geometrie der Bauteile, vorzugsweise digitalisiert gerastert, erfasst werden. Zu diesem Zweck kann die Bauteileerfassungseinheit eine Eingabeeinheit aufweisen, die es ermöglicht, das jeweilige Bauteil einzeln zu erfassen, beispielsweise indem ein digitales gerastertes Erfassen vorgesehen ist. Dies kann beispielsweise mittels optischer Sensoren, Röntgensensoren, Kombinationen hiervon oder dergleichen erfolgen. Besonders vorteilhaft erweist es sich, wenn das digitalisierte gerasterte Erfassen auf einen das Bauteil darstellenden Datensatz zurückgreifen kann, der beispielsweise bei einer rechnergestützten Konstruktion entwickelt worden ist. In einem solchen Fall kann von dem rechnergestützten System der entsprechende Datensatz abgerufen und mittels der Bauteileerfassungseinheit über eine Schnittstelle erfasst werden. Für die weitere Verarbeitung kann vorgesehen sein, dass der erhaltene Datensatz digital gerastert abgetastet wird, um eine Adaption an weitere Abläufe gemäß der Erfindung erreichen zu können. Beispielsweise kann dies anhand einer Transformation erfolgen. So kann vorzugsweise ein gerastertes Netzwerk des Bauteils erzeugt werden. Beispielsweise ist das Netzwerk durch ein Dreiecksnetz gebildet, welches insbesondere mit einem NX-Vernetzer wie dem NASTRAN-Vernetzer erzeugt werden kann, der speziell für Simulationen und Finite-Elemente-Methoden konzipiert worden ist.

Mit einer Anordnungserfassungseinheit kann die Anordnung der Bauteile in der Baueinheit zueinander erfasst werden, das heißt, es kann beispielsweise erfasst werden, welche Bauteile aneinander angrenzen und aneinander angrenzende Oberflächen aufweisen. Auf diese Weise kann die Lage der Bauteile in der Baueinheit ermittelt werden. Vorzugsweise kann vorgesehen sein, dass entsprechende Daten gespeichert werden, sodass sie für eine spätere weitere Verarbeitung zur Verfügung stehen. Weiterhin sieht die Erfindung die Werkstofferfassungseinheit vor, mittels der Werkstoffeigenschaften der erfassten Bauteile erfasst werden können und/oder Werkstoffeigenschaften den erfassten Bauteilen zugeordnet werden können. Das Erfassen der Werkstoffeigenschaften kann beispielsweise mittels Sensoren erfolgen, die die erforderlichen Werkstoffeigenschaften erfassen können. Bei Bereitstellung von Datensätzen aus einer rechnergestützten Konstruktion kann vorgesehen sein, dass die Werkstoffeigenschaften bereits in den Datensätzen enthalten sind, so dass eine gesonderte Erfassung nicht erforderlich ist. In diesem Fall reicht es aus, die jeweilige Werkstoffeigenschaft dem jeweiligen Bauteil zuzuordnen. Darüber hinaus kann auch vorgesehen sein, dass die Werkstoffeigenschaften zu den Bauteilen von einem Konstrukteur zugewiesen werden, sodass sie dem jeweiligen Bauteil zugeordnet sind. Dies kann beispielsweise über eine externe Eingabeeinheit erfolgen, über die der Konstrukteur die entsprechende Werkstoffeigenschaft eingibt und dem jeweiligen Bauteil zuordnet.

Darüber hinaus umfasst die Einrichtung der Erfindung die Leitfähigkeitsermittlungseinheit, die geeignet ist, elektrisch leitfähige Bauteile anhand der Werkstoffeigenschaften zu ermitteln. Vorzugsweise kann sie auch deren elektrisches Potential im bestimmungsgemäßen Betrieb ermitteln. Die Leitfähigkeitsermittlungseinheit kann zu diesem Zweck auf die den jeweiligen Bauteilen zugeordneten Werkstoffeigenschaften zurückgreifen. Darüber hinaus können ergänzende Daten vorgesehen sein, aus denen die jeweilige Beaufschlagung eines Bauteils mit einem elektrischen Potential im bestimmungsgemäßen Betrieb hervorgeht. Natürlich kann auch vorgesehen sein, dass zu diesem Zweck der Konstrukteur entsprechende Daten über die Eingabeeinheit bereitstellt.

Die Erfindung sieht ferner vor, dass mittels einer Auswähleinheit ein im bestimmungsgemäßen Betrieb mit einem ersten elektrischen Potential beaufschlagtes erstes elektrisch leitfähiges Bauteil ausgewählt wird. Das Beaufschlagen mit einem elektrischen Potential umfasst, dass das entsprechende Bauteil zum Beispiel von außerhalb der Baueinheit mit dem elektrischen Potential beaufschlagt wird. Es kann aber auch vorgesehen sein, dass das elektrische Potential innerhalb der Baueinheit erzeugt wird, beispielsweise bei einer Energiewandlungsfunktion oder dergleichen. Vorzugsweise ist das ausgewählte Bauteil ein elektrisch leitfähiges Bauteil, welches mit einem kleinsten oder einem größten elektrischen Potential beaufschlagt ist. Häufig eignet sich eine solche Auswahl auch dazu, ein elektrisches Bezugspotential festzulegen. Die Auswahl kann beispielsweise anhand einer Liste der Bauteile erfolgen, indem das erste in der Liste geführte elektrisch leitfähige Bauteil ausgewählt wird. Darüber hinaus kann die Auswahl natürlich auch nach anderen Kriterien erfolgen, beispielsweise unter Berücksichtigung einer Größe des Bauteils, einer Lage in der elektrischen Baueinheit und/oder dergleichen.

Die Einrichtung umfasst ferner als einen wesentlichen Aspekt der Erfindung die Strahlerzeugungseinheit, mittels der eine Mehrzahl von Strahlen erzeugt werden kann, die sich gerade, richtungsändernd oder auch gekrümmt ausbreiten, beispielsweise infolge einer Abhängigkeit von Ausbreitungsbedingungen wie Gewichtung durch Werkstoffeigenschaften oder dergleichen. Die Strahlen können von der Strahlerzeugungseinheit vorzugsweise derart erzeugt werden, dass deren Startpunkt das erste Bauteil bildet. Die Strahlerzeugungseinheit ist dem Grunde nach eine Recheneinheit, die auch als Rechner, der durch ein Programm gesteuert ist, eine elektronische Schaltung oder dergleichen zumindest teilweise gebildet sein kann. Die Strahlerzeugungseinheit erzeugt keine physikalischen Strahlen, sondern virtuelle Strahlen, deren Startpunkt durch das erste Bauteil gebildet ist und die sich vorzugsweise in sämtliche Raumrichtungen sich ausbreiten. Bei einem punktförmigen bzw. kugelförmigen ersten Bauteil erfolgt die Erzeugung von Strahlen vorzugsweise kugelsymmetrisch in sämtliche Raumrichtungen. Diese Strahlen stellen potentielle Wege dar, auf denen ein Strompfad erfolgen könnte. Vorzugsweise ist eine Dichte der erzeugten Strahlen homogen in Bezug auf die Oberfläche des Bauteils, die den Startpunkt bildet. Natürlich kann auch eine abweichende Dichte von Strahlen über der Oberfläche des Bauteils vorgesehen sein, beispielsweise, wenn es sich aufgrund der Geometrie des ersten Bauteils als zweckmäßig erweist, durch externe Vorgaben, beispielsweise aufgrund von Eingaben des Konstrukteurs, und/oder dergleichen. Vorzugsweise ist der Strahl gerade hinsichtlich seines Strahlverlaufs. Er kann aber auch richtungsändernd sein, beispielsweise wenn sich Werkstoffeigenschaften im Strahlenverlauf ändern. Ferner kann der Strahl auch als Linie mit einem Anfangspunkt gebildet sein und eine Krümmung, einen oder mehrere Knicke, Kombinationen hiervon oder dergleichen aufweisen, um den gekrümmten Strahl zu bilden. Schließlich kann auch eine Kombination der vorgenannten Möglichkeit auftreten. Insbesondere stellen die Strahlen mögliche Wege zwischen einem Startpunkt und einem Auftreffpunkt dar, auf denen unter Umständen bestimmungswidrig ein elektrischer Strom fließen könnte.

Mit der Ermittlungseinheit wird sodann ermittelt, welche Strahlen ein zweites elektrisch leitfähiges Bauteil treffen. Die Ermittlungseinheit dient insbesondere zum Ermitteln in Abhängigkeit von der Geometrie und Anordnung der erfassten Bauteile, welche der Strahlen ein zweites elektrisches Bauteil der Baueinheit treffen, welches anhand seiner Werkstoffeigenschaften als elektrisch leitfähig klassifiziert ist. Es wird folglich ein Auftreffpunkt am zweiten Bauteil ermittelt, sofern es einen gibt. Breitet sich der Strahl in eine Richtung aus, in der die Baueinheit kein weiteres Bauteil aufweist, wird kein Auftreffpunkt ermittelt. Natürlich können durch einen Strahl auch mehrere zweite elektrische Bauteile getroffen werden, die im bestimmungsgemäßen Betrieb auf unterschiedlichem elektrischem Potential liegen, beispielsweise dann, wenn eine Kante eines Bauteils gestriffen wird oder dergleichen. Die Strahlen, die das zweite elektrisch leitfähige Bauteil treffen, werden erfasst und vorzugsweise entsprechende Daten für die weitere Verfahrensführung gespeichert.

Mittels der Längenermittlungseinheit wird eine Streckenlänge vom jeweiligen Startpunkt bis zum jeweiligen Auftreffpunkt derjenigen Strahlen ermittelt, die ausgehend vom ersten Bauteil das zweite Bauteil treffen. Bei der Längenermittlungseinheit handelt es sich somit um eine Einheit, die eine metrische Länge entlang des Strahls zwischen dem ersten und dem zweiten Bauteil, und zwar zwischen den jeweiligen relevanten Punkten, dem Startpunkt und dem Auftreffpunkt, ermittelt. Vorzugsweise wird diese ermittelte Streckenlänge der jeweiligen Strahlen gespeichert. Für die Längenermittlung unerheblich sind dabei solche Strahlen, die das zweite Bauteil nicht treffen. Vorzugsweise werden diese Strahlen außer Acht gelassen.

Mittels der Auswerteeinheit wird nunmehr die mit der Längenermittlungseinheit ermittelte kürzeste Streckenlänge zwischen dem ersten und dem zweiten Bauteil ermittelt und als kürzester bestimmungsfremder Strompfad ausgegeben. Sie dient auch dem Ermitteln und Ausgeben der kürzesten der ermittelten Streckenlängen. Dieser kürzeste bestimmungsfremde Strompfad steht nunmehr einer weiteren Behandlung, insbesondere einem Vergleich mit durch Normung vorgegebenen Mindeststreckenlängen, zur Verfügung. Somit ermöglicht es die Erfindung, beispielsweise Kriech- und/oder Luftstrecken auf Einhaltung anwendbarer Normen zu prüfen.

Gemäß einer Weiterbildung der Erfindung wird vorgeschlagen, dass das zweite elektrische Bauteil eines ist, das im bestimmungsgemäßen Betrieb mit einem zweiten elektrischen Potential beaufschlagt wird. Hierdurch kann die Erfindung hinsichtlich des Aufwands weiter optimiert werden, weil ein Fokus auf elektrische Bauteile unterschiedlichen elektrischen Potentials gelegt werden kann, das heißt, elektrische Bauteile, zwischen denen eine elektrische Spannung im bestimmungsgemäßen Betrieb anliegt.

Eine weitere Ausgestaltung der Erfindung schlägt vor, dass jedem erfassten Bauteil ein eindeutiges Identifikationskennzeichen zugeordnet wird. Dadurch ist es möglich, jedes erfasste Bauteil der elektrischen Baueinheit eindeutig zu erfassen. Das Identifikationskennzeichen kann beispielsweise aus einem Zeichencode gebildet sein, der beispielsweise einem Datensatz des erfassten Bauteils zugeordnet ist oder diesen sogar identifiziert.

Gemäß einer weiteren Ausgestaltung der Erfindung wird vorgeschlagen, dass unmittelbar aneinandergrenzende Bauteile mit gleichen Werkstoffeigenschaften zu einem gemeinsamen Bauteil verbunden werden. Hierdurch kann eine weitere Vereinfachung der Durchführung der Erfindung erreicht werden, weil insgesamt die Anzahl der Bauteile, die zu behandeln sind, reduziert werden kann. In diesem Fall kann zum Beispiel vorgesehen sein, dass das durch die verbundenen Bauteile gebildete gemeinsame Bauteil ein eigenes Identifikationskennzeichen erhält, welches aus einer Kombination der Identifikationskennzeichen der verbundenen Bauteile gebildet sein kann. Darüber hinaus kann natürlich auch vorgesehen sein, dass das gemeinsame Bauteil ein neues Identifikationskennzeichen erhält. Zugleich kann vorgesehen sein, dass die Identifikationskennzeichen der das gemeinsame Bauteil bildenden Bauteile gelöscht werden.

Eine Weiterbildung der Erfindung sieht vor, dass die Strahlen derart ermittelt werden, dass sie überwiegend entlang einer Oberfläche wenigstens eines der elektrisch isolierenden Bauteile der elektrischen Baueinheit verlaufen und dass die Streckenlängen der Strahlen gewichtet unter Berücksichtigung der Werkstoffeigenschaften ermittelt werden. Diese Ausgestaltung erlaubt es insbesondere, Kriechstrecken der elektronischen Baueinheit zu ermitteln. Mit der Kriechstreckenermittlung kann das Einhalten anwendbarer Normen durch Vergleichen der ermittelten Kriechstrecken mit durch die Normung vorgegebenen Minimalwerten für die Kriechstrecken durchgeführt werden. Dabei können Werkstoffeigenschaften, insbesondere bezüglich der Oberflächen der elektrisch isolierenden Bauteile, berücksichtigt werden, die gegebenenfalls auch Einfluss auf die Richtung der Strahlen nehmen können. Der Kriechweg wird durch die Werkstoffeigenschaften der jeweiligen Oberfläche gewichtet berücksichtigt. Beispielsweise kann durch Änderung von Werkstoffeigenschaften entlang eines Strahlverlaufs eine Beugung des jeweiligen Strahls die Folge sein und eine entsprechende Beeinflussung des Strahlverlaufs und damit der Streckenlänge zur Folge haben.

Vorteilhaft wird jedem erfassten Bauteil ein CTI-Wert zugeordnet. Der CTI-Wert der CTI (Comparative Tracking Index)-Wert ist eine Werkstoffgröße, die ein Maß für die Kriechstromfestigkeit bereitstellt. Die Kriechstromfestigkeit kennzeichnet die Isolationsfestigkeit einer Oberfläche eines Isolierstoffs, insbesondere unter äußeren Einwirkungen, beispielsweise von Feuchtigkeit, Verunreinigungen und/oder dergleichen. Sie definiert einen maximalen Strom, den sogenannten Kriechstrom, der unter genormten Prüfbedingungen in einer definierten Prüfanordnung sich einstellt. Die Kriechstromfestigkeit wird mit dem CTI-Wert bestimmt. Dieser CTI-Wert ist ein Maß dafür, bis zu welcher Spannung das geprüfte Material an der Oberfläche keine signifikante elektrische Leitfähigkeit aufweist, wenn beispielsweise 50 Tropfen einer genormten Elektrolytlösung aufgetropft werden. Dieser Wert kann in die Gewichtung des Ermittelns der Streckenlänge berücksichtigt werden.

Gemäß einer weiteren Ausgestaltung der Erfindung wird vorgeschlagen, dass ein elektrisch leitfähiges Bauteil, das im bestimmungsgemäßen Betrieb elektrisch von seiner Umgebung isoliert ist, als Startpunkt zum Erzeugen einer Mehrzahl von weiteren Strahlen dient. Insbesondere eignet sich diese Ausgestaltung für den Fall, dass ein Strahl auf ein elektrisch leitfähiges und elektrisch nicht beaufschlagtes Bauteil trifft, beispielsweise ein Metallniet, eine Metallschraube, die der Befestigung dient oder dergleichen, die selbst nicht an ein elektrisches Potential angeschlossen ist. Ein solches Bauteil kann in dem bestimmungsfremden Strompfad eingeschlossen sein und deshalb, aufgrund seiner elektrischen Leitfähigkeit, als Startpunkt von weiteren Strahlen dienen. Eine Kriech- bzw. Luftstrecke ergibt sich dann durch die Summe der Streckenlänge des eintreffenden Strahls sowie eines entsprechenden ausgehenden Strahls mit seinem weiteren Auftreffpunkt.

Es kann ferner vorgesehen sein, dass bei einem elektrisch isolierenden Bauteil ein Sattelpunkt ermittelt wird. Ein Sattelpunkt ist ein Punkt, bei dem der Strahlverlauf unterschiedliche Wege annehmen kann. Bei einer auf Dreiecken basierenden Rasterung ergibt sich ein Sattelpunkt an solchen Stellen, bei denen die Winkelsumme angrenzender Dreiecke größer als 360° ist. Trifft ein Strahl auf einen Sattelpunkt, so kann er sich innerhalb eines Winkelbereichs verzweigen. Für die Möglichkeiten der Verzweigung kann vorgesehen sein, dass der Sattelpunkt als Ausgangspunkt weiterer Strahlen dient.

So wird ferner vorgeschlagen, dass zu jedem Sattelpunkt ein toter Winkel ermittelt wird und der Sattelpunkt als Startpunkt zum Erzeugen einer Mehrzahl von Sattelpunktstrahlen in einem durch den toten Winkel bestimmten Bereich dient. Der tote Winkel ergibt sich dadurch, dass in Bezug auf den eintreffenden Strahl in beide Richtungen um den Sattelpunkt jeweils 180° abgetragen werden. Der verbleibende Restwinkel, der zugleich auch 360° überschreitet, bildet den sogenannten toten Winkel. Innerhalb dieses toten Winkels werden vom Sattelpunkt ausgehend Sattelpunktstrahlen ausgesendet. Treffen diese auf das zweite Bauteil, so ergibt sich die Streckenlänge durch die Streckenlänge des eintreffenden Strahls sowie die entsprechende Streckenlänge des Sattelpunktstrahls in Summe.

Weiterhin wird vorgeschlagen, dass beim Ermitteln der kürzesten ermittelten Streckenlänge als kürzester bestimmungsfremder Strompfad ein Sprung mit einer vorgegebenen maximalen Sprungweite berücksichtigt wird. Diese Ausgestaltung erlaubt es, Besonderheiten bezüglich der Kriechstromausbreitung zu berücksichtigen. Dadurch kann die Ermittlung von Kriechstrecken weiter verbessert werden.

Eine weitere Ausgestaltung der Erfindung sieht vor, dass die kürzeste ermittelte Streckenlänge mit einem vorgegebenen Vergleichswert verglichen wird und bei Unterschreiten des Vergleichswerts eine Meldung ausgegeben wird. Diese Ausgestaltung erlaubt es, vorzugsweise automatisch eine Prüfung auf Einhalten von Mindeststreckenlängen vorzusehen. Der vorgegebene Vergleichswert kann deshalb beispielsweise eine Mindeststreckenlänge sein, die durch eine anwendbare Norm oder dergleichen vorgegeben ist. Anstelle der Norm können natürlich auch konstruktive andere Gründe Mindestwerte für Streckenlängen vorsehen, die als Vergleichswert dienen können. Bei Unterschreiten des Vergleichswerts kann eine Meldung beispielsweise optisch, akustisch oder dergleichen ausgegeben werden. Zu diesem Zweck können eine entsprechende Anzeigefunktion, ein akustisches Wiedergabemittel wie ein Lautsprecher, ein Summer, aber auch eine Anzeigeeinheit und/oder dergleichen zum Einsatz kommen. Besonders vorteilhaft erweist sich diese Ausgestaltung in Verbindung mit einer rechnergestützten Konstruktion, wobei vorgesehen sein kann, dass automatisch die Stelle der elektrischen Baueinheit markiert wird, an der die Unterschreitung des Vergleichswerts ermittelt worden ist. Dies erlaubt es dem Konstrukteur, unmittelbar festzustellen, an welcher Stelle die elektrische Baueinheit entsprechend zu überarbeiten ist.

Insbesondere wird vorgeschlagen, dass die Strahlen, die das zweite elektrisch leitfähige Bauteil unmittelbar treffen, ermittelt werden. Diese Strahlen bilden demnach die direkte unmittelbare Luftstrecke zwischen dem ersten und dem zweiten elektrischen Bauteil ab. Dabei ist zu berücksichtigen, dass diese Strahlen nicht durch weitere Bauteile der elektrischen Baueinheit in ihrer Ausbreitungsrichtung behindert sind. Eine Weiterbildung sieht vor, dass der Schnittpunkt als Startpunkt zum Erzeugen einer Mehrzahl von Kantenstrahlen dient, wobei vorzugsweise nur Strahlen in einem vorgebbaren Bereich erzeugt werden. Die Kantenstrahlen gehen von der konvexen Kante aus und haben wenigstens eine Richtungskomponente des entsprechenden eintreffenden Strahls, wodurch ein Bereich vorgegeben ist, in dem die Kantenstrahlen ausgesendet werden. Eine Weiterbildung sieht vor, dass der vorgegebene Bereich durch einen Ausbreitungskegel oder ein Ausbreitungsfrustum gebildet ist. Dadurch kann der vorgegebene Bereich weiter eingegrenzt werden, sodass die Durchführung der Erfindung vereinfacht werden kann.

Mit der Erfindung wird ferner ein Rechnerprogrammprodukt umfassend ein Programm für eine Rechnereinheit vorgeschlagen, mit Programmcodeabschnitten eines Programms zum Ausführen der Schritte des Verfahrens der Erfindung, wenn das Programm durch die Rechnereinheit ausgeführt wird, sodass die Rechnereinheit wenigstens einen kürzesten bestimmungsfremden Strompfad in einer Baueinheit ermittelt. Das Rechnerprogrammprodukt umfasst weitere rechnerausführbare Komponenten, die, wenn das Programm auf der Rechnereinheit ausgeführt wird, dazu dienen, das erfindungsgemäße Verfahren auszuführen. Das vorgenannte Rechnerprogrammprodukt kann als rechnerlesbares Speichermedium ausgebildet sein.

Darüber hinaus kann das Programm direkt in einen internen Speicher der Rechnereinheit ladbar sein. So ist es beispielsweise möglich, dass das Programm aus einem Netzwerk von einer Quelle wie beispielsweise einem Server heruntergeladen wird und in einen internen Speicher der Rechnereinheit geladen wird, sodass der Rechner das Programm ausführen kann.

Weitere Vorteile und Merkmale sind der folgenden Beschreibung von Ausführungsbeispielen anhand der Figuren zu entnehmen. In den Figuren bezeichnen gleiche Bezugszeichen gleiche Merkmale und Funktionen.

Es zeigen:

| | |
|---|---|
| FIG 1 | eine schematische Darstellung eines Entwicklungsablaufs gemäß dem Stand der Technik, |
| FIG 2 | eine schematische Darstellung eines Entwicklungsablaufs unter Einbindung der Erfindung, |
| FIG 3 | eine schematische Blockdarstellung einer Einrichtung gemäß der Erfindung, |
| FIG 4 | eine schematische Darstellung einer Transformation eines Bauteils, |
| FIG 5 | eine schematische Darstellung einer untransformierten Geometrie für einzelne Bauteile, |
| FIG 6 bis 8 | drei schematische Darstellungen unterschiedlicher Konfigurationen eines Surface-Parameters, FIG 6 stellt eine Standardeinstellung dar, FIG 7 0,1 und FIG 8 0,01, |
| FIG 9 bis 11 | drei schematische Darstellungen unterschiedlicher Konfigurationen eines Curve-Parameters, FIG 9 stellt eine Standardeinstellung dar, FIG 10 0,1 und FIG 11 0,01, |
| FIG 12 | schematisch ein Beispiel für eine Vernetzung eines Originalbauteiles, wobei in der oberen Darstellung ein Bauteil und in der unteren Darstellung das gerasterte Bauteil gezeigt sind, |
| FIG 13 | eine schematische Darstellung vor einer Verschmelzung von Dreiecksnetzen zweier aneinandergrenzender Bauteile, |
| FIG 14 | eine schematische Darstellung einer Schraube als Bauteil mit einer Mutter als weiterem Bauteil vor einer Verschmelzung, wobei in einer linken Ansicht eine schematische perspektivische der Schraube mit der Mutter und in einer rechten Ansicht eine digital gerasterte Darstellung gezeigt ist, |
| FIG 15 | eine schematische Darstellung einer zur Netzgruppen-Erkennung verwendeten Baueinheit, wobei unterschieden wird zwischen elektrisch leitenden Bauteilen, isolierenden Bauteilen und weiteren Bauteilen, die keinem CTI-Wert zugeordnet sind, |
| FIG 16 | eine schematische Darstellung geodätischer Strahlen ausgehend von einer Punktquelle, |
| FIG 17 | eine schematische Darstellung geodätischer Strahlen ausgehend von einer polygonalen Quelle, |
| FIG 18 | eine schematische Darstellung eines geodätischen Strahls in zwei nebeneinander angeordneten Ansichten der einmal knapp links und einmal knapp rechts an einem Sattelpunkt vorbeiläuft, wobei dahinter ein toter Winkel entsteht, der nur von Strahlen erreicht werden kann, die sich am Sattelpunkt verzweigen, |
| FIG 19 | eine schematische Darstellung einer Bestimmung eines toten Winkels an einem Sattelpunkt für einen einfallenden Strahl, |
| FIG 20 | eine schematische Darstellung eines Schemas zur geodätischen Distanzfeldberechnung, |
| FIG 21 | eine schematische Darstellung der Detektion von defekten Slots, wobei rechts Slots einer Dreieckskante und die dazugehörigen Strahlen dargestellt sind, die letztlich den Distanzvektor bilden, wobei ein Slot wird lediglich von einem nicht-optimalen Strahl getroffen wird, und links ein Plot der Distanzen entlang der Kante dargestellt ist, wobei der defekte Slot eindeutig als Ausreißer erkennbar ist, |
| FIG 22 | eine schematische Darstellung einer Snelliusschen Brechung links und rechts geodätische Strahlen |

an einem Materialübergang, wobei ein Material in diesem Beispiel um den Faktor 2 leitfähiger als das andere ist,

FIG 23    eine schematische Darstellung eines optimalen Pfads zwischen zwei Punkten, wobei es an der Grenzkante zum besseren Isolator zu einer kritischen Reflexion kommt,

FIG 24    eine schematische Darstellung von M-Vertex an einer konvexen Materialgrenze bei Übergang in ein schlechter leitendes Material, wobei der entstehende Winkelbereich kein toter Winkel ist, da sich die dem M-Vertex nähernden Strahlen schneiden,

FIG 25    eine schematische Darstellung von M-Vertex an einer konvexen Materialgrenze bei Übergang in ein besser leitendes Material, wobei ein toter Winkel entsteht,

FIG 26    eine schematische Darstellung eines Strahls, der auf einen M-Vertex trifft und mit einer der Grenzkanten zum besser leitenden Material einen Winkel größer dem kritischen Winkel bildet, wobei der Strahl diese Kante jederzeit wieder in Richtung schlechter leitendes Material verlassen kann, weshalb sie in eine reflection list aufgenommen werden muss,

FIG 27 und 28    zwei schematische Darstellungen für einen Sprung zwischen zwei Flehen bei der Kriechstromermittlung,

FIG 29    eine schematische Darstellung zur Ermittlung eines Landepunktes $J_2$ aus einem Schnitt einer Sprungebene und einer konvexen Kante,

FIG 30    eine schematische Darstellung zur Ermittlung zur Konstruktion eines Absprungpunktes $J_1$,

FIG 31    eine schematische Darstellung zur Ermittlung eines Kegels, der durch Rotation der Strahlgerade um die Sprungkante entsteht, wobei sich ein Landepunkt h des Sprunges aus dem Schnitt der Kontur und der Ebene, auf die gesprungen werden soll, ergibt,

FIG 32    eine schematische Darstellung, die einen resultierenden Sprung zeigt,

FIG 33    eine schematische Darstellung eines weiterführenden Strahls, der um eine Absprungkante rotiert wird, wobei ein Schnittpunkt zwischen dem dadurch entstandenen Kegel und der Landekante den Punkt, auf den gesprungen werden kann, ergibt, sofern dieser nicht weiter als $_X$ vom Absprungpunkt entfernt ist,

FIG 34    eine schematische Darstellung eines resultierenden Pfads unter Berücksichtigung der lokalen Optimalitätskriterien,

FIG 35    eine schematische Darstellung eines global optimalen Pfads ausgehend von FIG 34,

FIG 36    eine schematische Darstellung für einen nicht möglichen Sprung bei einer Kriechstreckenermittlung, weil sich ein entsprechendes Kreissegment eines Zylinders oberhalb der Flächen befindet,

FIG 37    eine schematische Darstellung für einen nicht möglichen Sprung bei einer Kriechstreckenermittlung, weil sich ein entsprechendes Kreissegment des Zylinders unterhalb der Flächen befindet,

FIG 38    eine schematische Darstellung für einen möglichen Sprung bei einer Kriechstreckenermittlung, weil das Kreissegment exakt in der Fläche liegt und vom entsprechenden Punkt auf der Kante zu jedem Punkt in diesem Bereich gesprungen werden kann,

FIG 39    eine schematische Darstellung eines Pfades, der genau auf eine zur Ausbreitungsfläche senkrecht stehende Kante zuläuft und verzweigt,

FIG 40    eine schematische Darstellung von möglichen Verzweigungswegen für einen Pfad, der genau auf eine zur Ausbreitungsfläche senkrecht stehende Kante zuläuft,

FIG 41    eine schematische Darstellung von Pfaden ausgehend von einer Punktquelle und einen Sprung von einer Fläche zu einer Kante und einen Sprung von einer Fläche zu einer Fläche,

FIG 42    eine schematische Darstellung einer resultierenden Proxy-Geometrie zur FIG 41,

FIG 43    eine schematische Darstellung bei der einem Start-Dreieck Dreiecke als potentielle Sprungpartner zugewiesen werden, wobei es sich dabei um Dreiecke handelt, zu denen potentiell gesprungen werden kann,

FIG 44    eine schematische Darstellung von einer Berechnung für mögliche Sprünge, wobei für einen ankommenden Strahl nur die potentiellen Sprungpartner im entsprechenden Winkelbereich in Betracht gezogen werden,

FIG 45    zwei nebeneinander angeordnete, schematische Darstellungen für kürzeste Pfade zwischen einer Quelle und einem Ziel, wobei die Leitfähigkeit von Isolatoren durch ihre Helligkeit dargestellt ist, je heller desto leitfähiger, wobei elektrisch leitende Objekte als elektrisch leitende Komponenten dargestellt sind, wobei links eine schematisch perspektivische Ansicht und recht eine zugeordnete gerastert digitalisierte Darstellung gezeigt ist,

FIG 46    eine schematische Darstellung für einen Extremfall einer Distanzabfrage an einer Kante,

FIG 47    eine schematische Darstellung eines Gesamtschemas zur Berechnung von Kriechstrecken gemäß der Erfindung,

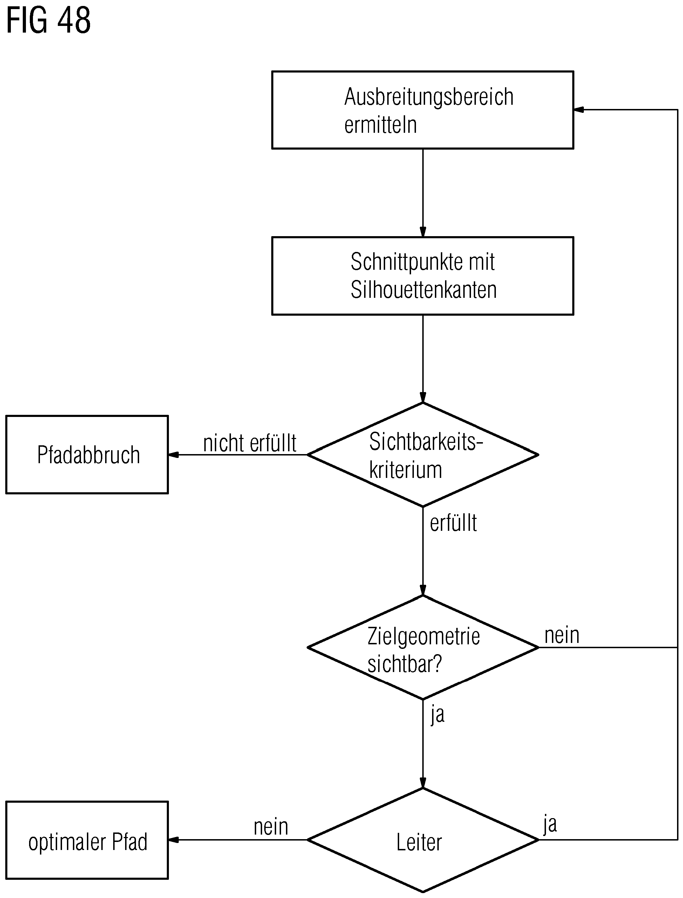

FIG 48    eine schematische Darstellung eines allgemeinen Lösungskonzept für eine Luftstreckenanalyse gemäß der Erfindung,

FIG 49 eine schematische Darstellung einer Reduzierung eines originalen Dreiecksnetzes auf seine konvexen Kanten, ausgehend von einer Dreiecksnetzrasterung in einer oberen Darstellung zu einer Silhouettendarstellung unten,

FIG 50 eine schematische Darstellung eines Ausbreitungskegels an einem Kantenpunkt Pk, der von einem fortgesetzten Vektor T und dessen Geodäte auf einer Oberfläche aufgespannt wird,

FIG 51 eine schematische Darstellung eines Ausbreitungsfrustums an einem Sattelpunkt, wobei eine Linie ein weiterführender Vektor ist, und die weiteren Linien dessen Geodäten auf den anliegenden Oberflächen sind und eine Linie eine Schnittkante der zwei anliegenden Oberflächen beschreibt,

FIG 52 eine schematische Darstellung eines Ausbreitungskegel mit zwei sichtbaren und einem nicht sichtbaren Schnittpunkt,

FIG 53 eine schematische Darstellung eines Silhouettenkriteriums, wobei bezüglich eines Punktes die markierte Kanten nur das Silhouettenkriterium erfüllen, Kanten nur das Sichtbarkeitskriterium und weitere Kanten beide Kriterien erfüllen,

FIG 54 eine schematische Darstellung eines Schemas einer Strahlpropagierung für eine Luftstreckenanalyse gemäß der Erfindung.

FIG 55 links eine schematische Darstellung von möglichen Pfadverläufen von einer Quelle zu einem Zielpunkt und rechts eine dazugehörige Baumstruktur, wobei die Wurzel der Quelle entspricht und die inneren Knoten Schnittpunkte mit konvexen Kanten sind, die das Sichtbarkeits- und das Silhouettenkriterium erfüllen, wobei die Blattknoten Zielpunkte bzw. Schnittpunkte sind, die das Silhouettenkriterium nicht erfüllen oder die die maximale Luftstreckendistanz überschritten haben,

FIG 56 eine schematische Darstellung von Kantenslots, und zwar eine Unterteilung von konvexen Kanten an Hindernisobjekten bzw. einer Zielgeometrie in Slots,

FIG 57 eine schematische Darstellung von Flächenelementen, und zwar eine Unterteilung von konvexen Kanten an Hindernisobjekten bzw. einer Zielgeometrie in Flächenelemente,

FIG 58 eine schematische Darstellung der Entstehung eines Distanzfeldes auf Objektkanten ausgehend von einer Quelle,

FIG 59 eine schematische Darstellung der Entstehung eines Distanzfeldes auf einem Zielobjekt ausgehend von einer Quelle,

FIG 60 eine schematische Darstellung einer polygonalen Quelle und ihrer zu emittierenden Strahlen an Kanten, Ecken und Flächen, wobei der Übersichtlichkeit halber die Strahlen nur auf einer der fünf Flächen des Polygons aufgezeigt sind,

FIG 61 bis 63 drei schematische Darstellungen von Ausbreitungspartnern polygonaler Quellen,

FIG 64 eine schematische Darstellung wie FIG 13 jedoch nach einer Verschmelzung,

FIG 65 eine schematische Darstellung wie FIG 14 jedoch nach einer Verschmelzung, wobei die Schraube durch die Verschmelzung in zwei Bereiche aufgeteilt wurde, zwischen denen keine direkte Verbindung im Dreiecksnetz besteht, und

FIG 66 eine schematische Darstellung wie FIG 45, bei der ergänzend ein elektrisch leitfähiges Bauteil vorgesehen ist.

Luft- und Kriechstrecken sind Pfade an denen sich ein elektrischer Strom zwischen zwei verschiedenen elektrischen Potentialen entwickeln kann. Solche Pfade sind als bestimmungsfremde Strompfade unerwünscht. Diese können erheblichen Schaden am Bauteil und dessen Umgebung anrichten. Es gibt daher strenge DIN Normen, welche den Mindestabstand zweier elektrischer Leiternetze vorgeben. Diese Normen müssen in jedem Fall eingehalten werden, was jedoch selten bereits beim ersten Entwurf des Bauteils der Fall ist.

Im Folgenden werden unter anderem die Begriffe "Geodäsie" und "Geodäte" genutzt. Diese Begriffe sollen in dieser Offenbarung nicht als auf die Vermessung von Erdoberflächen basierend verstanden werden, sondern vielmehr im Sinne einer metrischen Ermittlung von Kriech- und Luftstrecken, insbesondere in Sinne der Normung. Die Erfindung basiert deshalb nicht auf Verfahren der Erdvermessung, die in Sinne der Erfindung auch nicht anwendbar wären.

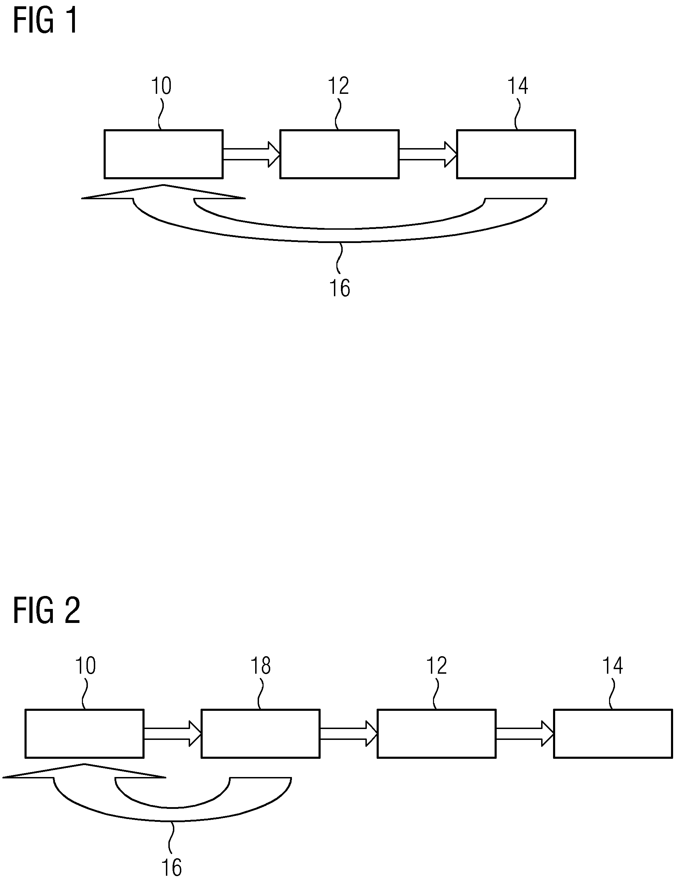

FIG 1 zeigt in einer schematischen Darstellung einen Entwicklungsablaufs gemäß dem Stand der Technik. Eine Konstruktion erfolgt mittels eines CAD-Design-Entwicklungstools 10. Daraus wird ein Prototyp 12 als Baueinheit erstellt. Dieser wird sodann einer TÜV/LGA-Prüfung 14 unterzogen. Da eine automatische Prüfung zur Einhaltung aller Normen bislang nicht möglich war, wurden Normverletzungen erst im Rahmen der notwendigen TÜV/LGA-Prüfung 14 festgestellt, nachdem bereits ein fertiger Prototyp des Bauteils hergestellt wurde. Um den Fehler zu beheben, muss das Teil in den CAD-Daten unter Berücksichtigung der Normverletzung 16 umkonstruiert 10, das heißt, ein neuer Prototyp 12 gebaut und eine erneute TÜV/LGA-Prüfung 14 durchgeführt werden. Diese Schleife kann sich mehrmals wiederholen und kostet dem Unternehmen viel Zeit und Geld. FIG 1 veranschaulicht die bisherige Vorgehensweise.

FIG 2 zeigt einer schematischen Darstellung einen Entwicklungsablaufs unter Einbindung der Erfindung. Der Entwicklungsablauf basiert auf der Darstellung gemäß FIG 1. Gemäß der Erfindung ist jedoch zwischen dem CAD-Design-Entwicklungstool 10 und der Erstellung 12 der Prototyps eine Einrichtung gemäß der Erfindung geschaltet, hier LuKri-Analyzers 18 genannt. Diese ermittelt aus den CAD-Daten die zu untersuchende Baueinheit und prüft die Baueinheit auf Einhalten der Anforderungen in Bezug auf Kriech- und Luftstrecken. Wird eine Verletzung dieser Vorschriften festgestellt, erfolgt eine Rückmeldung an das CAD-Design-Entwicklungstool 10. Daraufhin wird die Konstruktion entsprechend überarbeitet. Dieser Zyklus wird solange wiederholt, bis eine normgerechte Konstruktion vorliegt. Erst dann wird der Prototyp erstellt 12.

Ziel des LuKri-Analyzers 18 ist es, den Prozess der Qualitätssicherung bei elektrischen Baueinheiten zu optimieren, indem er eine vollständige Luft- und Kriechstreckenanalyse automatisch an den CAD-Daten vornimmt. Die Entwickler der Baueinheit bekommen unmittelbare Ergebnisse über mögliche Normverletzungen und können diese umgehend und gezielt korrigieren, ohne dass der aufwändige Bau eines Prototypen notwendig ist. FIG 2 veranschaulicht die Einbindung des LuKri-Analyzer 18 in den Prozess der Qualitätssicherung.

Die Vorteile für den Entwickler sind deutlich geringere Kosten und eine erhebliche Zeitersparnis bei der Herstellung elektrischer Baueinheiten.

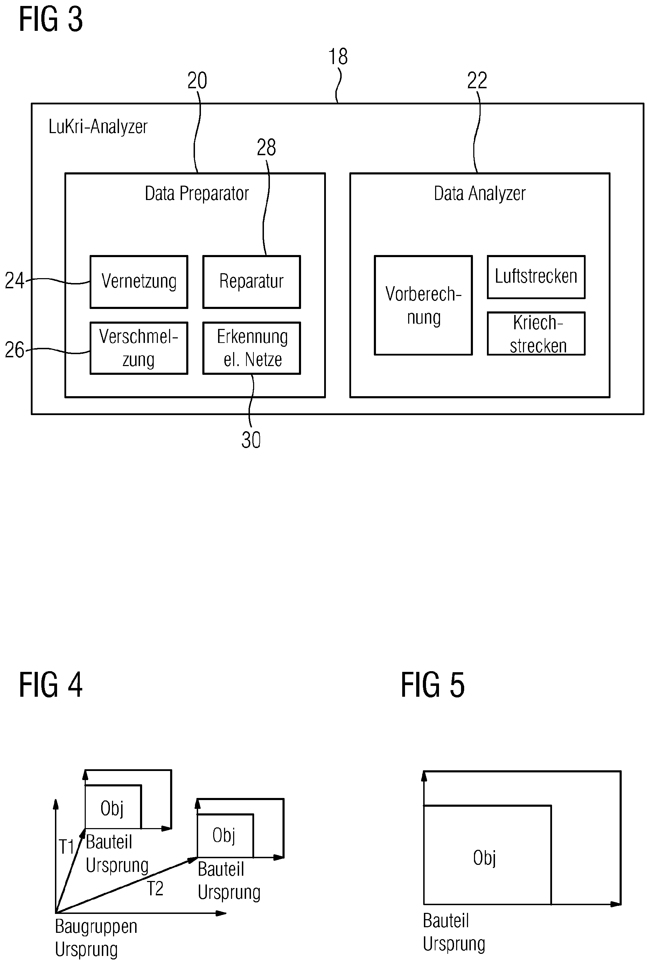

Der schematische Aufbau des LuKri-Analyzers 18 ist in FIG 3 dargestellt. Er besteht aus zwei Hauptkomponenten 20, 22, dem Data-Preparator 20, der für die Aufbereitung der Daten zuständig ist und dem eigentlichen Data-Analyzer 22, der die Luft- und Kriechstreckenanalyse durchführt.

Die Vernetzung ist zwar Teil des Programms "Data Preparator" 20, wird aber von NX-Funktionen durchgeführt. Ermöglicht wird dies durch die umfangreiche Programmschnittstelle (API) von NX, die es externen Programmen erlaubt auf NX-Funktionen zuzugreifen, ohne eine NX-Session zu öffnen. Die Einbettung der NX-Funktionen zur Vernetzung in den Data Preparator 20 werden im Folgenden beschrieben.

Mit 24 ist die Vernetzung von Volumenkörpern bezeichnet. Das implementierte Verfahren traversiert die gesamte Hierarchie eines übergebenen Parts. Je Bauteil werden die Objekte nacheinander vernetzt und mit dem in den Attributen übergebenen CTI-Wert versehen. Die Vernetzung erfolgt Objektweise. Das bedeutet für Bauteile, die aus mehreren Volumenkörpern bestehen, dass diese separat vernetzt werden.

Da jedes Bauteil im Kontext einer übergeordneten Baugruppe relativ zu deren Ursprung positioniert wird, muss eine Transformation (FIG 4) aus der Baueinheit extrahiert und auf das einzelne Bauteil angewendet werden. Wird ein einzelnes Bauteil vernetzt, ist diese relative Positionierung nicht nötig. FIG 4 zeigt eine relative Transformation innerhalb von Baugruppen. Eine untransformierte Geometrie für einzelne Bauteile ist schematisch in FIG 5 dargestellt.

Die Vernetzung 24 ist ein verlustbehafteter Prozess. Durch die Diskretisierung einer analytisch definierten Oberfläche sind Ungenauigkeiten nicht zu vermeiden. Je feiner ein Netz aufgelöst ist, desto besser passt es sich der analytisch definierten Oberfläche an.

Durch Angabe von Schwellwerten kann die Genauigkeit des Vernetzers gegen die Laufzeit, die zur Vernetzung benötigt wird, abgewogen werden. Folgende Parameter finden bei der Vernetzung Anwendung:

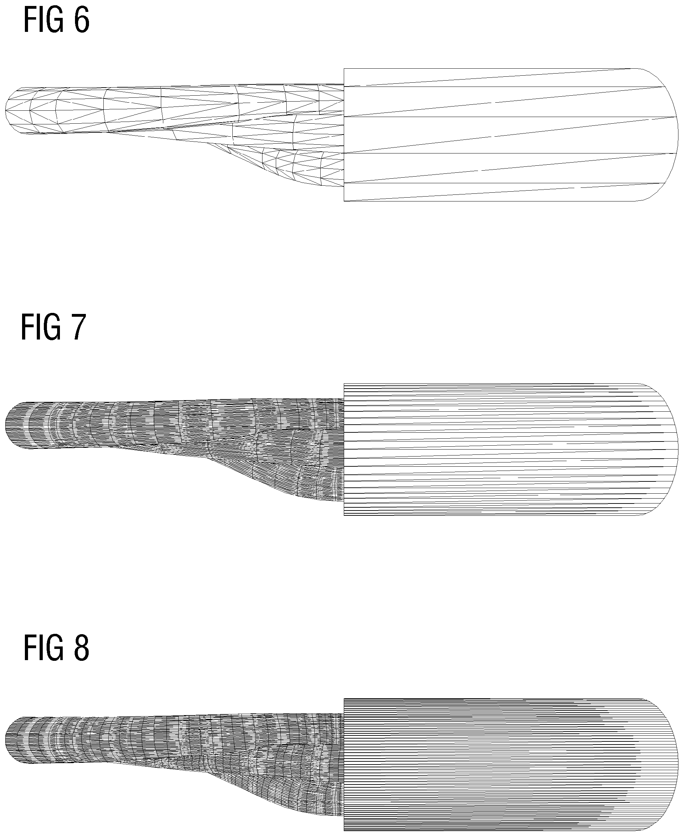

Surface Distance Tolerance: Dieser Schwellwert benennt die maximal erlaubte Distanz zwischen der analytisch definierten Oberfläche zum Dreiecksnetz (FIG 6 bis 8).

Surface Angular Tolerance: Dieser Schwellwert benennt die maximal erlaubte Abweichung des Normalenvektors der analytisch definierten Oberfläche zur Normale des Dreieckes (vergleiche FIG 6 bis 8).

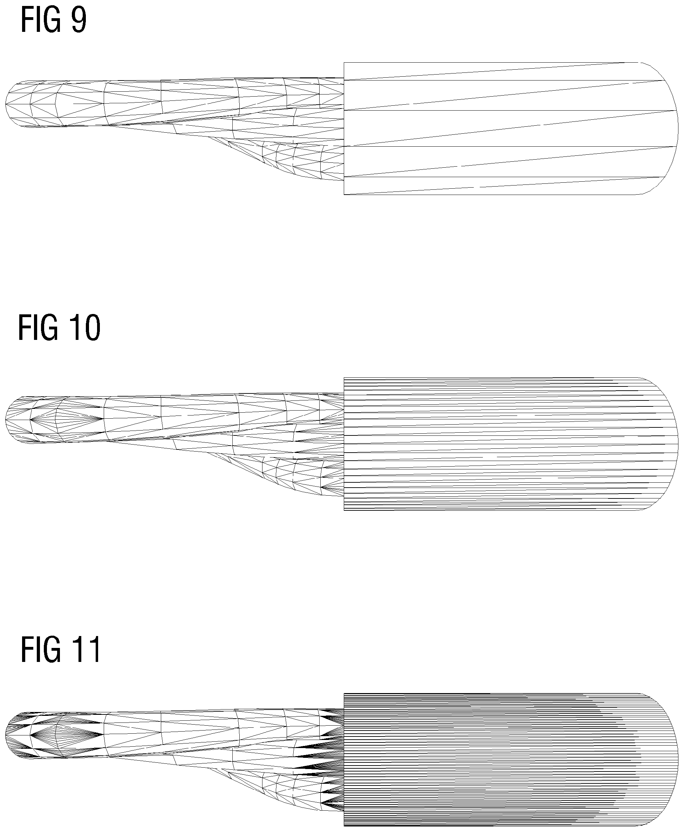

Curve Distance Tolerance: Dieser Schwellwert benennt die maximal erlaubte Distanz einer Dreieckskante zur analytischen Oberfläche (vergleiche FIG 9 bis 11).

Curve Angular Tolerance: Dieser Schwellwert benennt die maximal erlaubte Abweichung einer Dreieckskante zur analytischen Tangente der Kurve (vergleiche FIG 9 bis 11).

Maximum Facet Size: Dieser Schwellwert benennt die maximal erlaubte Kantenlänge eines Dreieckes.

Numher Storage Type: Dieser Wert bestimmt die Genauigkeit, mit der die Fließkommazahlen des Vernetzers aufgelöst werden. Mögliche Werte sind UF_FACET_TYPE_FLOAT und UF FACET_TYPE_DOUBLE.

Die für die Vernetzung zur Verfügung stehenden Parameter bieten eine hohe Variation zwischen Genauigkeit und Speicherverbrauch. Die Vernetzung darf auf der einen Seite nicht zu grob sein damit bei gekrümmten Flächen nicht allzu große Abweichungen von der Original-Geometrie auftreten, auf der anderen Seite führt eine feine Vernetzung zu hohen Datenmengen, was bei der enormen Komplexität der Originalbauteile schnell an die Grenzen der technischen Machbarkeit führen kann. Für die uns vorliegenden Datensätze haben sich folgende Parametereinstellungen als sinnvoll erwiesen:

Surface Distance Tolerance: 0.2

Surface Angular Tolerance 0.2

Curve Distance Tolerance 0.8

Curve Angular Tolerance 0.2

Maximum Facet Size 10

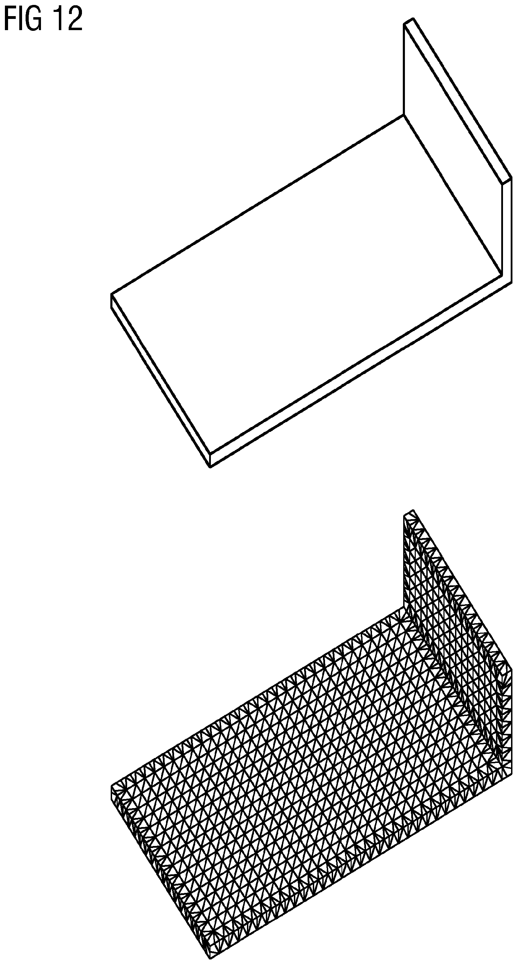

Ein Beispiel für eine Vernetzung eines Originalteiles als Bauteil der Baueinheit ist in FIG 12 zu sehen. In der oberen Darstellung der FIG 12 ist das Bauteil in einer perspektivischen Ansicht gezeigt. In der unteren Darstellung der FIG 12 ist eine digital gerasterte Erfassung des Bauteils aus der oberen Ansicht gezeigt. Hier wurde eine Schienen-Unterbaugruppe, die das Bauteil bildet, mit einer Gesamtzahl von etwa 300.000 Dreiecken vernetzt.

Das Dreiecksnetz wurde - wie zuvor beschrieben - mit dem NX-Vernetzer 24 zur Visualisierung erzeugt und ist qualitativ nicht so hochwertig wie beispielsweise Netze des NASTRAN-Vernetzers, der speziell für Simulationen und Finite Element Methoden konzipiert wurde. Allerdings ist die Laufzeit des NASTRAN-Vernetzers für die Größe der zu verarbeitenden Bauteile nicht praktikabel, wohingegen das Visualisierungsnetz in unter einer Minute erzeugt werden kann. Dieser Schritt wird mit Reparatur 28 bezeichnet. Es beinhaltet jedoch noch eine Reihe degenerierter Dreiecke, das heißt, Dreiecke die keine Fläche besitzen. Für eine Visualisierung spielen diese degenerierten Dreiecke keine Rolle, für eine Luft- und Kriechstreckenanalyse müssen sie jedoch entfernt werden, was durch Methoden wie edge-flips und edge-collapses erreicht werden kann. Diese Methoden wurden im Programm "Data Preparator" implementiert und sind mit 28 gekennzeichnet.

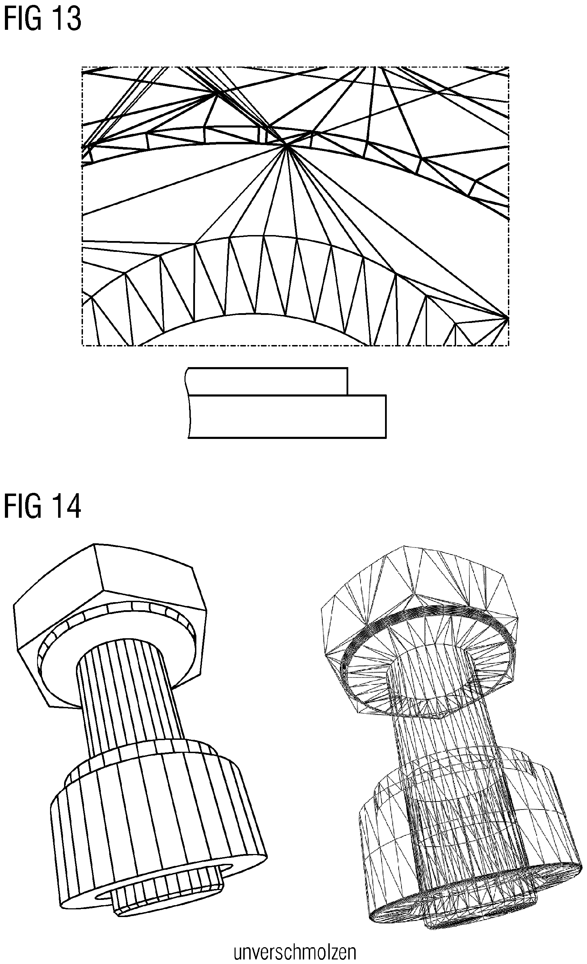

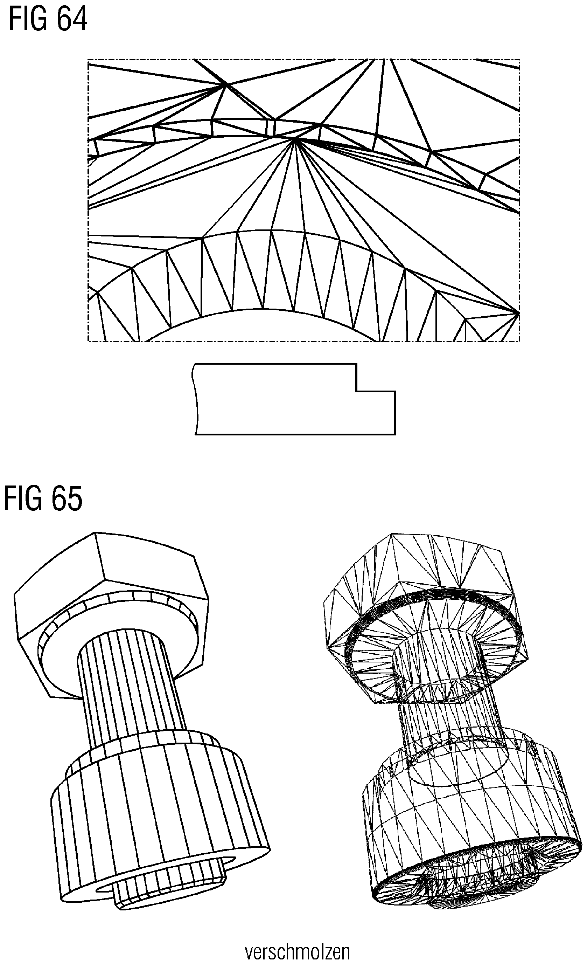

Die zu analysierenden Baueinheiten bestehen aus vielen Einzelbauteilen, die im CAD-System 10 aneinandergebaut und vom Vernetzer 24 separat vernetzt werden. Es besteht also zwischen zwei benachbarten Bauteilen keine topologische Verbindung im Dreiecksnetz. Das Ziel dieses Vorverarbeitungsschritts ist es, die topologische Verbindung herzustellen. Dieser Schritt ist vorliegend mit Verschmelzung 26 bzw. Verbindung bezeichnet. Dies hat zwei große Vorteile. Zum einen vereinfacht es die Berechnung von Kriechstrecken, da sich das Verfahren dann auch am Kontaktbereich zweier Bauteile effizient über benachbarte Dreiecke bewegen kann, und zum anderen können die Kontaktflächen, die im unverschmolzenen Zustand doppelt vorkommen, komplett gelöscht werden, ohne die Analyse zu beeinflussen. Dadurch lässt sich die Anzahl der Dreiecke, und somit der Speicherbedarf reduzieren. FIG 13 und FIG 64 zeigen ein Beispiel für eine Verschmelzung 26. In einer Darstellung der FIG 13 sind zwei aneinandergrenzende Bauteile vor der Verschmelzung dargestellt, und zwar im unteren Bereich eine Seitenansicht der beiden zu verschmelzenden Bauteile und im oberen Bereich eine zugeordnete digital gerasterte Darstellung. FIG 64 zeigt die beiden Darstellungen der FIG 13 entsprechend nach der Verschmelzung.

Ein wichtiger Aspekt ist die Unterscheidung zwischen verklebten und unverklebten Bauteilen. Grundsätzlich ist dies jedoch nur von Belang, wenn es sich bei den zu verschmelzenden Bauteilen um zwei Isolatoren handelt. Sobald mindestens eines der beiden Teile ein Leiter ist, kann auf jeden Fall der Kontaktbereich verschmolzen werden, da sich die Ströme durch leitende Bauteile hindurch bewegen, ohne eine zählbare Strecke zurück zu legen. Handelt es sich jedoch um zwei nicht verklebte Isolatoren, so dürfen diese nicht verschmolzen werden, da sich sonst kein Pfad zwischen den Kontaktbereichen entwickeln kann. Für komplexe Bauteile ist dieser Schritt eine sehr aufwändige Sache und bedarf robuster Verfahren, die eine Vielzahl von Spezialfällen abdecken. Treffen beispielsweise zwei gekrümmte Flächen aufeinander, die jeweils unterschiedlich vernetzt wurden, ist die Wahrscheinlichkeit sehr hoch, dass sich die diskreten Linienzüge, welche die Krümmung annähern, überkreuzen. Oft sind auch benachbarte Teile in den CAD-Daten nicht perfekt berührend. Von daher muss also mit einer Reihe von Toleranzparametern gearbeitet werden.

Für die Luft- und Kriechstreckenanalyse ist die korrekte Identifikation von Netzgruppen innerhalb der Baueinheit von enormer Wichtigkeit, da sowohl Luft- als auch Kriechstrecken in Anwesenheit von elektrischen Leitern drastisch verkürzt sein können. Dieser Schritt wird als Erkennung der Netze 30 bezeichnet. Konkret müssen in diesem Schritt alle elektrisch leitenden und sich berührenden Teile zu einem elektrischen Netz zusammengefasst werden. Da im vorangegangen Schritt alle Bauteile, die sich berühren, miteinander verschmolzen 26 wurden, vereinfacht sich die Netzerkennung signifikant. Die Erkennung der elektrischen Netzgruppen 30 wird vorliegend in zwei Teilschritten durchgeführt:

1. Identifikation topologisch zusammenhängender Dreiecksnetze mit elektrisch leitenden Materialeigenschaften und

2. Zusammenfassung topologisch getrennter Teilgruppen zu einer einzelnen elektrisch leitenden Netzgruppe.

Im ersten Schritt wird ein sogenannter Seedfill Algorithmus angewandt, um topologisch zusammenhängende Dreiecke gleichen Materials bzw. aus dem gleichen Werkstoff zu finden. Zunächst wird ein einzelnes Dreieck ausgewählt, welches in der Baueinheit als Leiter definiert ist. Von diesem Dreieck aus werden alle seine unmittelbaren und topologisch verbundenen Nachbarn betrachtet und auf gleiche Materialeigenschaften bzw. Werkstoffeigenschaften, in diesem Fall auf elektrische leitende Eigenschaften, überprüft. Falls die Materialeigenschaften übereinstimmen, werden die einzelnen Nachbarn der Teilgruppe hinzugefügt und wiederum deren Nachbarn dem gleichen Test unterzogen. Dies erfolgt so lange, bis alle topologisch zusammenhängenden Dreiecke überprüft wurden. Ist eine Teilgruppe gefunden, so wird ein weiteres Dreieck mit leitenden Eigenschaften ausgewählt, welches noch keiner Teilgruppe angehört und der Seed-Fill Algorithmus von diesem Dreieck ausgehend ausgeführt.

Das Resultat dieser Aneinanderreihung des Seedfill-Algorithmus ist eine Menge an elektrisch leitenden Teilgruppen bzw. Bauteilen, die aus verschiedenen Einzelteilen bestehen. Durch die Verschmelzung 26 kann es vorkommen, dass ein einzelnes, leitendes Bauteil topologisch getrennt wurde, was in FIG 14 dargestellt ist. Dort ist eine schematische Darstellung einer Schraube als Bauteil mit einer Mutter als weiterem Bauteil vor einer Verschmelzung gezeigt, wobei in einer linken Ansicht eine schematische perspektivische der Schraube mit der Mutter und in einer rechten Ansicht eine digital gerasterte Darstellung gezeigt ist. FIG 65 zeigt eine schematische Darstellung wie FIG 14 jedoch nach einer Verschmelzung, wobei die Schraube durch die Verschmelzung in zwei Bereiche aufgeteilt wurde, zwischen denen keine direkte Verbindung im Dreiecksnetz besteht. Der Seedfill-Algorithmus findet in diesem einfachen Fall zwei elektrische Teilgruppen, die jedoch zu einem Bauteil gehören und damit zu einem elektrischen Netz zusammengefügt werden müssen. In FIG 14 ist ganz links die Schraube mit einer aufgeschraubten Mutter schematisch in perspektivischer Ansicht dargestellt. Unmittelbar rechts daneben ist die die Schraube mit der Mutter als im Dreiecksnetz digital gerastert dargestellt. Die beiden rechten Darstellungen zeigen ein Problem bei der Verschmelzung. Der von der Mutter umfasste Bereich der Schraube ist mit der Mutter verschmolzen, wohingegen die anderen Bereiche der Schraub weiterhin von der Mutter separiert sind. In der ganz rechten Darstellung ist dies im Dreiecksnetz dargestellt, wohingegen die unmittelbar links daneben vorgesehen Darstellung die Schraube, die Mutter und ein abgetrenntes Schraubenende zeigt. Vorzugsweise sollten die Schraube und die Mutter jedoch zu einem einzigen Bauteil verschmolzen werden.

In einem zweiten Schritt werden daher alle Paare von leitenden Teilgruppen daraufhin geprüft, ob sie Dreiecke beinhalten, die die gleiche Bauteil-Identifikation besitzen. In diesem Fall werden sie zu einem elektrischen Netz zusammengefasst.

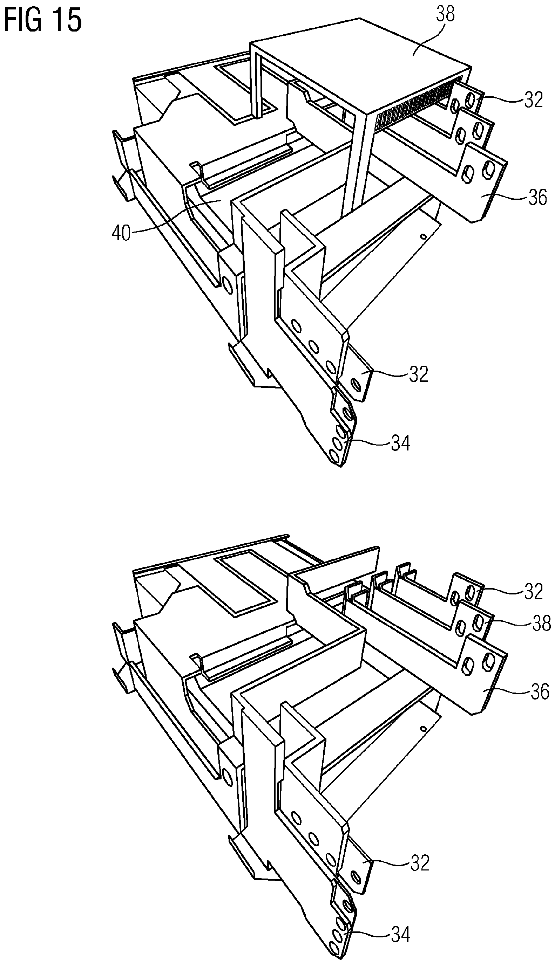

FIG 15 zeigt oben ein Beispiel für eine gesamte Baueinheit, wobei zwischen leitenden Bauteilen 32, 34 und isolierenden Bauteilen 36, 38 sowie einzelnen Bauteilen 40, die im NX-Datensatz keinem CTI-Wert zugeteilt wurden, unterschieden wird. In der Ansicht rechts daneben sind nur die leitenden Bauteile dargestellt, die in zusammenhängende elektrische Netze unterteilt wurden. Hierbei entspricht jeder Farbwert einer unterschiedlichen elektrischen Netzgruppe. Für das exemplarische Bauteil wurden insgesamt 132 zusammenhängende elektrische Netzgruppen gefunden.

Ein verbleibender Aspekt ist die Zuordnung von elektrischen Potentialen an elektrische Netze, da diese letztendlich die Quellen für die Luft- und Kriechstreckenberechnung darstellen.

Im Folgenden wird die Analyse der Kriechstrecken auf den vorverarbeiteten Daten beschrieben.

Der Analyse liegt ein Algorithmus zugrunde, der auf der Verfolgung einzelner, von einer Quelle ausgehender Strahlen basiert, die einen Kriechstrom simulieren, indem sie sich gemäß einer Distanzmetrik für Kriechstrecken fortbewegen. Zu dieser Metrik gehören folgende Aspekte:

- Die Pfad kann sich vorwiegend auf Oberflächen bewegen.

- Verschiedene Isolatorklassen haben je nach CTI-Wert eine unterschiedliche Anfälligkeit für Kriechströme und müssen für die Streckenberechnung unterschiedlich gewichtet werden.

- Der Strom kann sich bis zu einer vorgegebenen Distanz auch durch die Luft bewegen.

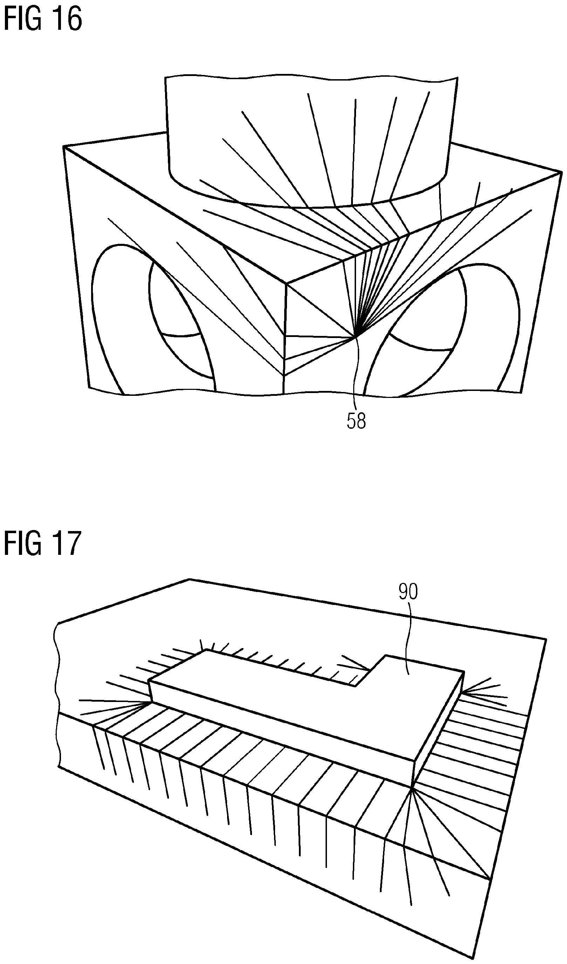

Um ein dichtes Distanzfeld zu erhalten, sind sehr viele dieser Strahlen nötig, die den Ausbreitungsbereich möglichst gut abdecken. Dabei ist das Verfahren sowohl für Punktquellen als auch für polygonale Quellen anwendbar. Während man an Punkten einen Winkelbereich abtasten muss, werden an Kanten polygonaler Quellen die Kanten selbst abgetastet und von jedem Abtastpunkt ein Strahl in Richtung der Normale geschossen. FIG 16 zeigt ein Beispiel für Strahlen ausgehend von einer Punktquelle 58, wohingegen FIG 17 Strahlen ausgehend von einer polygonalen Quelle 90 zeigt.

Trifft ein Strahl auf eine Kante des Dreiecksnetzes, so hinterlässt er dort als Auftreffpunkt einen "Fußabdruck" mit diversen Distanzinformationen, im folgenden Distanzvektor genannt. Da eine Stelle von unterschiedlichen Strahlen getroffen werden kann, ist es wichtig, dass am Ende nur die Information des kürzesten Strahles bzw. der kürzesten Streckenlänge zwischen Startpunkt und Auftreffpunkt dort verbleibt. Um dies zu realisieren werden diskrete Bereiche auf dem Netz eingeführt, an denen jeweils ein Distanzvektor gespeichert wird. Dieser wird aktualisiert, wenn der entsprechende Bereich von einem kürzeren Strahl getroffen wird. Die diskreten Bereiche werden Slots genannt und unterteilen eine Kante in uniforme Abschnitte, deren Maximalgröße global festgelegt ist. Wird ein Slot von einem Strahl getroffen, so beinhaltet der dort gespeicherte Distanzvektor $D_s = (d, p_s, Q)$ folgende Elemente:

Die bislang zurückgelegte Distanz des Strahles d.

Die genaue Position $p_s$ des Treffers innerhalb des Slots.

Quelleninformation Q.

Die Position $p_s$ des Treffers innerhalb eines Slots ist notwendig, um beim späteren Abfragen des Distanzwertes an beliebiger Stelle einer Kante genau zu wissen, wo sich auf dieser Kante die exakten Werte befinden. Dadurch lässt sich der maximale Fehler bei jeder Distanzabfrage exakt bestimmen und kontrollieren.

Die Quelleninformation Q beinhaltet den exakten Ursprung des Strahls und die Richtung, mit der die Quelle verlassen wurde. Dies ist notwendig, um den Verlauf des Strahles, der den Slot auf kürzestem Weg getroffen hat, zu rekonstruieren. Außerdem hat die Quelleninformation noch den Vorteil, dass sie eine zielgerichtete Verbesserung des Distanzfeldes erlaubt, wie später noch ausgeführt wird.

Die Distanzinformationen werden nicht nur für jeden Slot gespeichert, sondern auch für jeden Vertex des Dreiecksnetzes. Der Distanzvektor $D_v = (d, d_t, \Phi_v, Q)$ an einem Vertex unterscheidet sich geringfügig von den Distanzvektoren an Slots und besteht im Einzelnen aus folgenden Komponenten:

Die bislang zurückgelegte Distanz d.

Die Treffungenauigkeit ε des Strahles.

Der Winkel $\Phi_v$, mit dem der Vertex getroffen wurde.

Quelleninformation Q.

Da ein exakter Vertex-Treffer bei einer Berechnung mit doppelter Fließkommagenauigkeit unwahrscheinlich bis unmöglich ist, sollte am Ende der Strahl als Vertex-Treffer gelten, der diesem am nächsten kam. In der Implementierung wird jeder Strahl, der den letzten bzw. den ersten Slot einer Kante trifft, als potentieller Vertex-Treffer gehandelt. Die Distanz, mit der ein Strahl den Vertex verfehlt hat, ist die Treffungenauigkeit ε. Sein Distanzvektor D aktualisiert den momentan an dem Vertex gespeicherten Distanzvektor $D_v$, wenn dessen Komponenten d* und ε* folgende Bedingung erfüllen:

$$(\varepsilon^* < \varepsilon \wedge d^* < d + \varepsilon + \varepsilon^*) \vee (d^* + \varepsilon^* + \varepsilon < d)$$

Der Ausdruck ε* < ε ist die wichtigste Bedingung für eine Aktualisierung. Sie besagt, dass der neue Strahl näher am Vertex ist als der Bisherige. Allerdings darf dieses Kriterium nicht exklusiv gelten, da es vorkommen kann, dass ein nicht-optimaler Strahl, der erst über Umwege in die Nähe des Vertex gekommen ist, zufällig ein geringeres ε aufweist. Um zu verhindern, dass ein nicht-optimaler Strahl zu einer Aktualisierung des Distanzvektors führt, muss zusätzlich die Distanz d* des Kandidaten-Vektors kleiner sein als die momentan gespeicherte Distanz d plus der Summe der beiden Treffungenauigkeiten ε und ε*. Umgekehrt uss natürlich gewährleistet werden, dass ein nicht-optimaler Distanzvektor von einem optimalen überschrieben wird, selbst wenn dieser eine schlechtere

Treffungenauigkeit hat, was durch den finalen Ausdruck

$$d^* + \varepsilon^* + \varepsilon < d$$

erreicht wird.

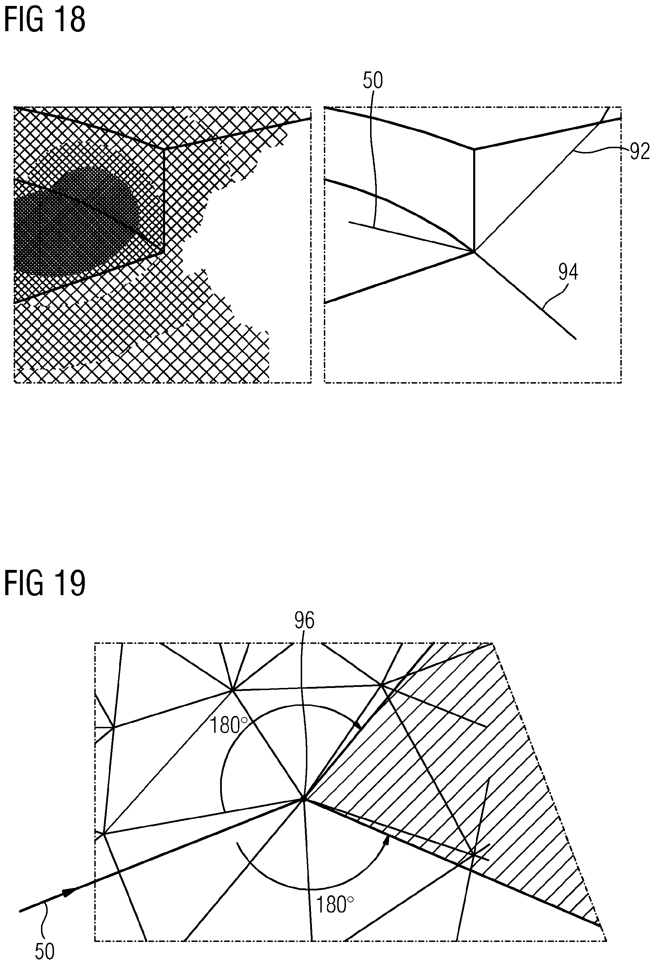

Im Folgenden wird eine Behandlung von Sattelpunkten beschrieben. Der Verlauf eines einzelnen geodätischen Pfades ist in der Regel eindeutig. Eine Ausnahme bilden Punkte, deren angrenzende Dreiecke eine Winkelsumme größer 360° aufweisen, sogenannte Sattelpunkte. Trifft ein geodätischer Strahl 50 auf einen Sattelpunkt 96, so kann er sich innerhalb eines Winkelbereiches verzweigen. Ohne spezielle Behandlung solcher Punkte würde hinter jedem Sattelpunkt ein toter Winkel entstehen, wie in FIG 18 zu sehen ist. Um diese toten Winkel aufzulösen, müssen Sekundärstrahlen, auch Sattelpunktstrahlen 92, 94 genannt, ausgehend vom Sattelpunkt 96 in den entsprechenden Winkelbereich hinein geschossen werden, die als Startdistanz die bislang zum Sattelpunkt 96 zurückgelegte Distanz mit auf den Weg bekommen. Die exakte Bestimmung des Winkelbereiches führt uns zunächst auf die Frage, wie man überhaupt einen Strahlenwinkel $\Phi$ an einem Vertex spezifiziert.

Jeder Vertex hat einen umschließenden Fächer von Dreiecken. Man definiert nun eine vom Vertex ausgehende Kante als Referenzkante mit Winkel 0° und bestimmt den Winkel eines beliebigen vom Vertex ausgehenden Strahles, indem man die Dreieckswinkel des Fächers ausgehend von der Referenzkante gegen den Uhrzeigersinn aufsummiert, bis man das Dreieck erreicht, in dem sich der Strahl befindet. Von diesem Dreieck addiert man lediglich den Winkelanteil dazu, den der Strahl innerhalb des Dreiecks einnimmt. Die Gesamtheit Φ aller Dreieckswinkel des Fächers klassifiziert die Art des Vertex.

Im Fall eines Sattelpunktes ist Φ > 360° und es stellt sich heraus, dass die Größe des toten Winkels exakt dem Winkelüberschuss Φ - 360° entspricht. Die genauen Grenzen des toten Winkels erhält man, indem man vom Winkel eines ankommenden Strahles jeweils 180° addiert bzw. subtrahiert. Dies ist in FIG 19 dargestellt.

Hierbei wird auch deutlich, warum der Winkel Φ, mit dem der Vertex getroffen wurde, im Distanzvektor gespeichert werden muss, da er eine nachträgliche Berechnung des toten Winkels erlaubt. Zwar könnte man sich diese Speicherung sparen, wenn man für jeden potentiellen Sattelpunkttreffer umgehend den toten Winkel bestimmt und Sekundärstrahlen innerhalb dieses Bereiches emittiert, jedoch ist diese Methode eher ineffizient. Wie man sich leicht vorstellen kann, wird ein Distanzvektor an einem Vertex sehr oft überschrieben bis letztlich der optimale Wert gefunden ist. Jede Aktualisierung würde alle Sekundärstrahlen, die vom vorherigen Vertex-Treffer ausgingen, nichtig machen. Anstatt also umgehend Sekundärstrahlen zu emittieren, wird für jeden potentiellen Sattelpunkttreffer eine Referenz auf den entsprechenden Distanzvektor in eine Liste gespeichert, der sogenannten saddlepointlist. Erst nach dem vollständigen Emittieren von Primärstrahlen werden alle Sattelpunkte in der Liste abgearbeitet, indem jeweils der tote Winkel bestimmt wird und anschließend Sekundärstrahlen mit der gleichen Winkeldichte wie an der Quelle innerhalb des toten Winkel geschossen werden.

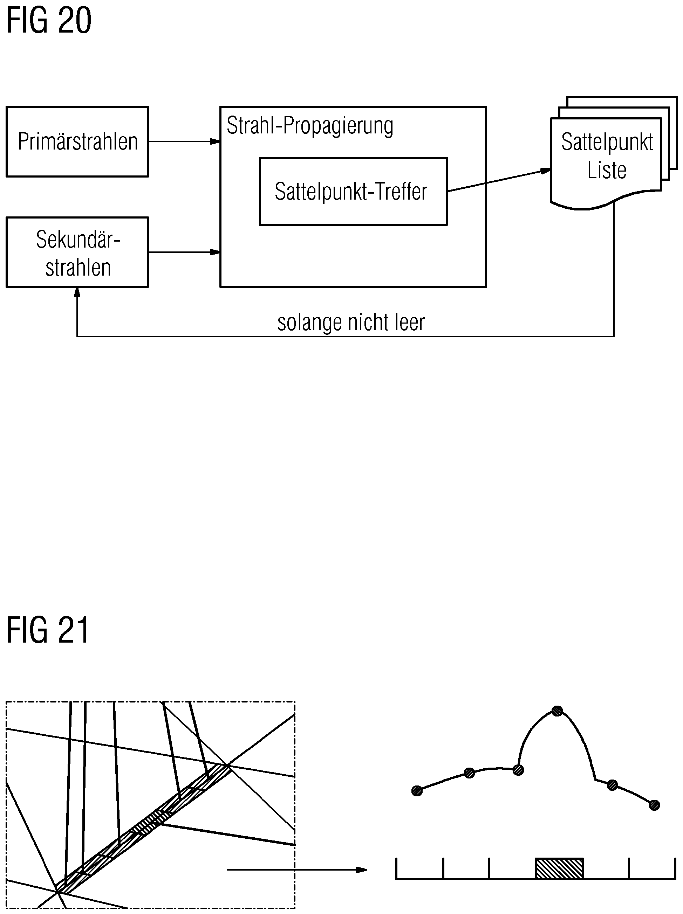

Während ihrer Abarbeitung kann die Liste zwischenzeitlich auch anwachsen, zum Beispiel wenn sich Sattelpunkte in einem für Primärstrahlen toten Winkel befanden. Um die Anzahl der benötigten Iterationen zu minimieren, ist es hilfreich, die Liste stets nach dem Abstand der Sattelpunkte zur Quelle zu sortieren. FIG 20 gibt eine schematische Darstellung des Strahlenschuss-Algorithmus zur Berechnung geodätischer Distanzfelder.

Um ein geschlossenes Distanzfeld mit eindeutigem maximalem Fehler zu gewährleisten, muss jeder Slot mindestens einmal von einem optimalen Strahl getroffen worden sein. Ob dies tatsächlich der Fall ist, kann mit Hilfe der Distanzvektoren jederzeit überprüft und korrigiert werden. Ein nicht getroffener Slot ist an der Tatsache zu erkennen, dass sein Distanzvektor noch mit den Initialwerten gefüllt ist. Es kann aber auch passieren, dass ein Slot nur von einem nicht-optimalen Strahl getroffen wurde, wir sprechen in diesem Fall von einem defekten Slot. Zur Erkennung von defekten Slots benötigt man die Distanzvektoren der benachbarten Slots auf der entsprechenden Kante, und gegebenenfalls die Distanzvektoren an den beiden Endpunkten. Da ein Distanzfeld stets eine glatte Funktion darstellt (im Normalfall verhalten sich die Werte entlang einer Linie quadratisch), muss man an jeder Kante eine quadratische Funktion anlegen können, auf der alle Distanzwerte liegen. Werte, die deutlich oberhalb dieser Funktion liegen, gehören definitiv zu defekten Slots. Dieser Zusammenhang wird in Abbildung 15 verdeutlicht.

FIG 21 zeigt eine Detektion von defekten Slots. Rechts sind schematisch Slots einer Dreieckskante und die dazugehörigen Strahlen dargestellt, die letztlich den Distanzvektor bilden. Ein Slot wird lediglich von einem nicht-optimalen Strahl getroffen. Links ist ein Plot der Distanzen entlang der Kante schematisch dargestellt. Der defekte Slot ist eindeutig als Ausreißer erkennbar.

Sowohl defekte als auch nicht getroffene Slots kommen zustande, wenn die lokale Strahlendichte zu gering war. Anstatt die Distanzberechnung global mit einer höheren Dichte zu wiederholen, kann man aus den Quelleninformationen benachbarter Slots einen Bereich eingrenzen innerhalb dessen neue Strahlen emittiert werden, um die betroffenen Slots zielgerichtet zu reparieren. Schließlich beinhaltet die Quelleninformation nicht nur die Position der Quelle des Strahles, sondern auch dessen ausgehende Richtung. Ein erneutes Schießen von Strahlen in einem schmalen Bereich um diese Richtung mit erhöhter Dichte führt letztendlich zur Reparatur der benachbarten Slots.

Dieselbe Maßnahme kann auch zur Verbesserung der Werte an Vertices angewandt werden. Da Sekundärstrahlen an Sattelpunkten den dort aufgetretenen Fehler mitführen, ist ein geringer Fehler an Sattelpunkten von großer Bedeutung, Der maximale Fehler an einem Vertex entspricht der Treffungenauigkeit, die jederzeit anhand des dort gespeicherten Distanzvektors bekannt ist. Ist an einem Sattelpunkt die Treffungenauigkeit größer als ein gewünschter Maximalwert, kann dieser durch das oben beschriebene zielgerichtete re-sampling auf eine beliebige Genauigkeit verbessert werden. Eine genaue Fehleranalyse des Verfahrens im Folgenden noch beschrieben, zunächst wird die Erweiterung des Strahlenschuss-Algorithmus zur Behandlung von unterschiedlichen Materialien erläutert.

Die Berechnung von geodätischen Distanzen unter Berücksichtigung von verschiedenen Materialbeschaffenheiten ist 1971 von Mitschel und Papadimitriou unter dem Begriff weighted region problem erstmals formuliert worden. Das Problem gilt als ungemein komplexer als das Berechnen von reinen geodätischen Distanzen auf ungewichteten Oberflächen und die Bestimmung exakter Lösungen gilt als unmöglich. Mit dem Strahlenschuss-Algorithmus ist nun jedoch eine Basis geschaffen, die eine konservative Annäherung an die exakte Lösung mit beliebiger Genauigkeit ermöglicht.

Ein geodätischer Pfad, der eine Kriechstrecke repräsentiert, verhält sich an einem Übergang zweier Materialien mit den durch die Werkstoffeigenschaften begründeten Gewichten $\lambda_1$ und $\lambda_2$ gemäß dem Snelliusschen Brechungsgesetz. Dabei berechnet sich der Winkel $\theta_2$ des gebrochenen Strahls aus dem einfallenden Winkel $\theta_1$ und den Materialparametern aus folgender Formel:

$$\theta_2 = \sin^{-1}\left(\frac{\sin\theta_1}{\lambda_1}\lambda_2\right)$$

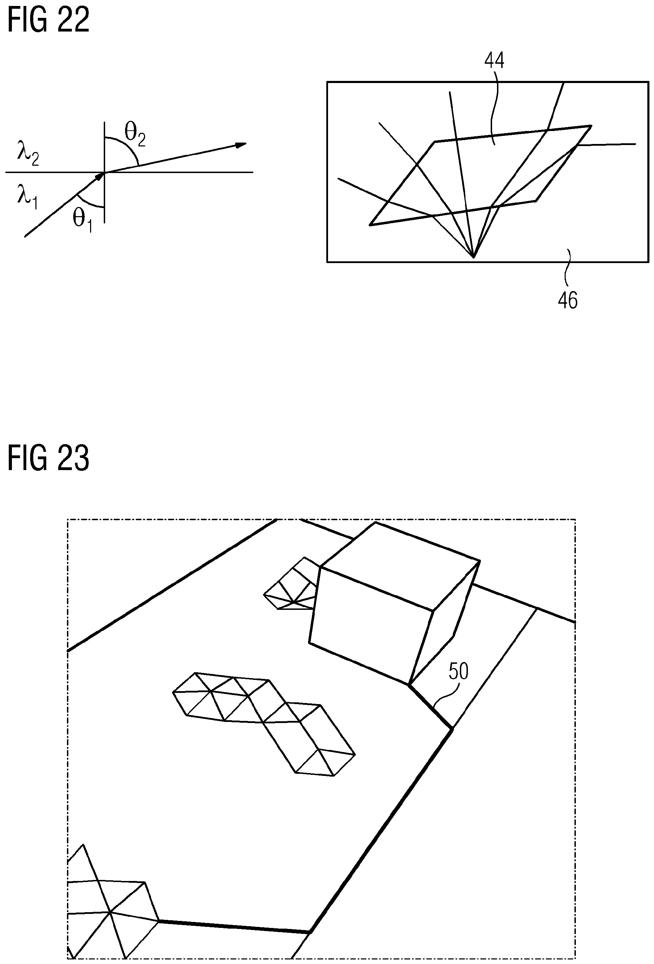

Dieser Zusammenhang ist in FIG 22 links dargestellt. Links ist in FIG 22 eine Snelliusschen Brechung dargestellt, und zwar geodätische Strahlen an einem Materialübergang. Das Material 44 ist in diesem Beispiel um den Faktor 2 leitfähiger als das Material 46. Das Flächengewicht A gibt im speziellen Fall der Kriechstreckenanalyse die Leitfähigkeit eines Isolators an, wobei nur die relativen Werte zwischen den Materialien von Bedeutung sind. Es ist also gleichgültig, ob man mit $\lambda1 = 100$ und $A2 = 300$ rechnet oder $\lambda1 = 1.0$ und $A2 = 3.0$, entscheidend ist in diesem Beispiel nur, dass Material 2 dreimal so leitfähig ist wie Material 1.

Die Brechung eines Strahles kann mit dem vorgestellten Algorithmus einfach umgesetzt werden, da ohnehin nur einzelne Strahlen verfolgt werden. Das rechte Teilbild von FIG 22 zeigt eine Reihe von einzelnen Strahlen, die mit dem implementierten Verfahren gebrochen wurden.

Ein wichtiger Effekt, der an einer Materialgrenze auftritt, ist die sogenannte kritische Reflexion. Ein Strahl, der von einem Material mit Parameter $\lambda_1$ in ein Material mit Parameter $\lambda_2 > \lambda_1$ übergeht, besitzt einen kritischen Winkel $\theta_c$, der sich genau dann ergibt, wenn der reflektierte Strahl genau entlang der Grenzkante weiter verlaufen würde, also wenn $\theta_2 = 90$ Grad.

Eingesetzt in Formel 1 ergibt sich für den kritischen Winkel $\lambda_c$ folgende Berechnungsvorschrift:

$$\theta_c = \sin^{-1}\left(\frac{\lambda_2}{\lambda_1}\right)$$

Ein an der Grenzkante entlang verlaufender Strahl kann diese jederzeit wieder im kritischen Winkel in Richtung des Materials mit kleinerem $\lambda$, in der Kriechstreckenberechnung also in Richtung des besseren Isolators, verlassen, ohne seine Optimalitätseigenschaft zu verlieren. Dieses Verlassen der Grenzkante nennt man kritische Reflexion. FIG 23 zeigt ein Beispiel eines kürzesten Pfades zwischen zwei Punkten, der eine kritische Reflexion aufweist.

Die Entstehung dieses Pfades ist intuitiv so zu erklären: Anstelle des direkten Weges von der Quelle zum Ziel ist es für den Strahl billiger einen Umweg in Kauf zu nehmen und dafür einen Großteil der Strecke auf dem für ihn günstigeren Untergrund zurückzulegen. Das optimale Verhältnis zwischen Umweg und direkter Strecke ist exakt durch die Größe der kritischen Winkels gegeben.

Eine weitere Sonderstellung in der Berechnung von Distanzen auf unterschiedlichen Oberflächen sind die Eckpunkte der Materialübergänge. Damit sind Vertices gemeint, die mindestens zwei anliegende Dreiecke unterschiedlichen Materials besitzen. Wir nennen diese Vertices im Folgenden M-Vertices.

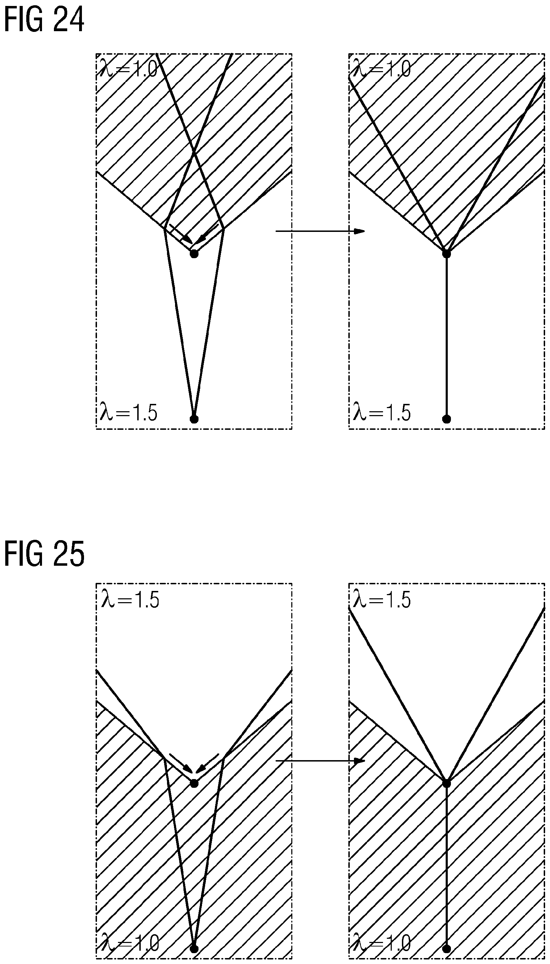

Trifft ein geodätischer Pfad auf einen M-Vertex, verhält er sich ähnlich wie an einem Sattelpunkt. In bestimmten Konstellationen können tote Winkel entstehen, die durch eine Verzweigung des Strahles am entsprechenden M-Vertex aufzulösen sind. Um den Winkelbereich einer möglichen Verzweigung zu ermitteln, bestimmt man zunächst die beiden refraktierten Strahlen, die sich ergeben, würde man sich dem M-Vertex einmal von links und einmal von rechts nähern. Schneiden sich die beiden Strahlen nicht, so bildet der Bereich dazwischen den toten Winkel. Dies hängt maßgeblich davon ab, ob die Materialgrenzen einen konvexen oder einen konkaven Bereich um den M-Vertex bilden. Beim Übergang von einem besser leitenden zu einem schlechter leitenden Material müssen die Materialgrenzen einen konkaven Bereich bilden, damit ein toter Winkel entsteht. Umgekehrt muss ein konvexer Grenzbereich für die Entstehung eines toten Winkels vorliegen. FIG 24 und 25 zeigen zwei verschiedene Szenarien für den Eintritt von Strahlen an einer konvexen Materialgrenze. Bei einem konkaven Materialübergang wäre das Verhalten genau umgekehrt.

Falls an einem Vertex mehr als nur 2 verschiedene Materialien aufeinander treffen, wird für jedes Material ein toter Winkel gemäß obiger Vorschrift berechnet. Die Gesamtheit der Verzweigungsbereiche ergibt sich aus der Vereinigungsmenge der einzelnen toten Winkel. Dabei kann es passieren, dass der gesamte Verzweigungsbereich aus mehreren isolierten Winkelbereichen besteht. Ist der Vertex zusätzlich noch ein Sattelpunkt, so muss der daraus entstehende tote Winkel in diese Vereinigungsmenge mit aufgenommen werden.

Die Behandlung von M-Vertices ist vorliegend identisch zur Behandlung von Sattelpunkten und benötigt daher keine zusätzlichen Strukturen. Trifft ein Strahl auf einen M-Vertex, so bricht er die Propagierung ab und speichert eine Referenz auf den entsprechenden Distanzvektor in der saddlepoint-list zur späteren Behandlung. Lediglich die Abarbeitung der Liste nach dem Schießen von Primärstrahlen muss geringfügig geändert werden. Das Verfahren muss beim Entnehmen eines Vertex aus der Liste prüfen, ob es sich um einen Sattelpunkt, einen M-Vertex, oder beides handelt, und dann die entsprechende Routine zur Bestimmung der toten Winkel aufrufen, innerhalb derer Sekundärstrahlen geschossen werden.

Für die Behandlung von kritischen Reflexionen müssen weitere Strukturen in den Algorithmus integriert werden. Zunächst fasst man alle zusammenhängenden, geodätisch kollinearen Grenzkanten zu sogenannten boundary groups (BG) zusammen. Trifft ein Strahl eine BG im kritischen Winkel, so wird die BG zur späteren Behandlung von Reflexionen in eine Liste (reflection list) gespeichert. Zusätzlich benötigt man die Quelleninformation des Strahles sowie die Information, wo exakt die BG getroffen wurde und in welche Richtung sich der Strahl auf der BG weiter ausbreitet. Falls sich bereits ein identischer Eintrag in der reflection list befindet, ist selbstverständlich die bislang zurückgelegte Strecke ausschlaggebend für eine Aktualisierung.

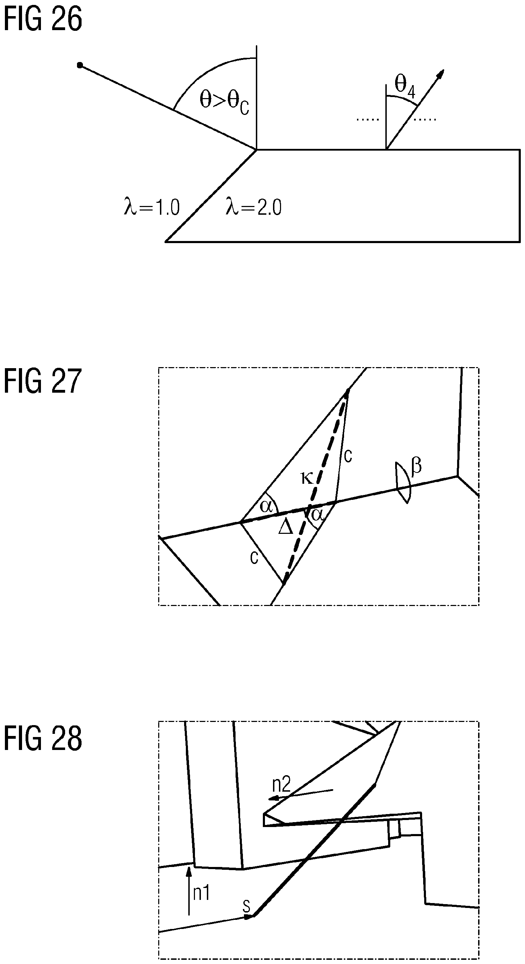

Es sei noch angemerkt, dass BG nicht ausschließlich durch das Auftreffen eines Strahles im kritischen Winkel in die reflection list aufgenommen werden können. Auch der Treffer eines M-Vertex kann zu einer Aktualisierung der reflection list führen, falls der Strahl von einem schlechter leitenden Matrial kommt und er mit einer der Grenzkanten einen Winel größer oder gleich dem kritischen Winkel bildet. Dieses Szenario wird in FIG 26 dargestellt.

Bei der Abarbeitung der reflection list werden ausgehend vom exakten Auftreffpunkt entlang der gegebenen Richtung Sekundärstrahlen in das schlechter leitende Material geschossen. Der Austrittswinkel entspricht dem kritischen Winkel des Materialübergangs und die Abtastrate wird so gewählt, dass von jedem auf dem Weg liegenden Slot mindestens ein Strahl emittiert wird.

Elektrisch leitende Teile sind prinzipiell mit den bislang erwähnten Grundlagen behandelbar, schließlich sind sie nichts anderes als ein Material mit Kostenfaktor Null. Der kritische Winkel ist in diesem Fall gleich 90 Grad, was bedeutet, dass optimale Strahlen das Material nur im rechten Winkel treffen und verlassen können. Dies ist in der Tat das korrekte Verhalten an leitenden Teilen, allerdings lässt sich dieser Spezialfall wesentlich effizienter behandeln, wenn man das komplette Bauteil als eine Pseudo-Quelle betrachtet, der man einen einzelnen Distanzvektor zuordnet. Wird ein leitendes Bauteil an einer beliebigen Stelle getroffen, so wird der Distanzvektor überschrieben, wenn die zurückgelegte Distanz des Strahles kleiner ist als der momentan am Bauteil gespeicherte Wert. Dazu wird eine Referenz auf den Distanzvektor in eine Liste zur späteren Behandlung gespeichert, wie es schon bei Sattelpunkten, M-Vertices und Reflexionskanten der Fall war. Die Liste der leitenden Teile wird conductor list bezeichnet. Bei deren Abarbeitung wird jeder Eintrag als polygonale Quelle mit Anfangsdistanz behandelt, von der aus in alle Richtungen Sekundärstrahlen geschossen werden.

Wie anfangs erwähnt, beinhaltet die Metrik für Kriechstrecken eine zulässige Ausbreitung des Pfades durch die Luft, was im Folgenden als Sprünge bezeichnet wird. Zunächst werden dazu theoretische Grundlagen der dadurch entstehenden Distanzmetrik beschrieben, die bislang unerforscht waren.

Das bisher entwickelte Verfahren basiert auf der gezielten Ausbreitung einzelner Strahlen unter Berücksichtigung von lokalen Optimalitätskriterien. In Falle eines Übergangs zwischen zwei verschiedenen Klassen von Isolatoren. Zum Beispiel muss der Strahl gemäß dem Snelliusschen Gesetz gebrochen werden, um sich lokal optimal weiter zu bewegen. Bei der Frage nach der lokalen Optimalität eines Sprungs können wir zunächst vier Basistypen unterscheiden.

1. Sprung von Fläche zu Fläche

Trifft ein Strahl auf eine nicht-konvexe Kante, kann die Strecke definitiv durch einen Sprung verkürzt werden. Damit dieser Sprung lokal optimal ist, müssen gewisse Symmetrieeigenschaften erfüllt sein. Zur Berechnung der beiden Sprungpunkte werden ein Winkel ß zwischen den beiden Flächen, ein Winkel $\alpha$ zwischen der Kante und dem ankommenden Strahl sowie eine maximale Sprungweite $_x$ benötigt. Eine Veranschaulichung dieser Parameter wird in FIG 27 gezeigt.

Mit den folgenden Formeln lassen sich die beiden Größen c und $\Delta$ bestimmen, aus denen sich schließlich die beiden Sprungpunkte konstruieren lassen. Der Abstand $\Delta$ ist der Versatz der beiden Pfade entlang der Sprungkante. Der Parameter c entspricht dem Abstand zwischen einer Sprungstelle und dem Schnittpunkt des gegenüberliegenden Pfades mit der Sprungkante.

$$c = \frac{x}{1 + \sqrt{\dfrac{1 - 2\cos\beta}{\cos^2\beta\cos^2\alpha + \sin^2\alpha}}} \qquad \Delta = \frac{c(1 + \cos\beta)}{\sqrt{\cos^2\beta + \tan^2\alpha}}$$

Die nicht-konvexe Kante, die Sprungkante, zwischen den beiden Flächen muss im Allgemeinen nicht unbedingt existieren, wie FIG 28 zeigt. Die für die Berechnung notwendigen Winkel $\alpha$ und ß werden unabhängig von der Existenz der Sprungkante berechnet. Während ß der Winkel zwischen den beiden Flächennormalen $n_1$ und $n_2$ ist, berechnet sich $\alpha$ aus einem Richtungsvektor s des ankommenden Strahles und dem Kreuzprodukt aus den Flächennormalen, was der Richtung der virtuellen Sprungkante entspricht.

$$\alpha = \cos^{-1}\left(s \cdot \left(n_1 \times n_2\right)\right)$$

2. Sprung von Fläche zu Kante

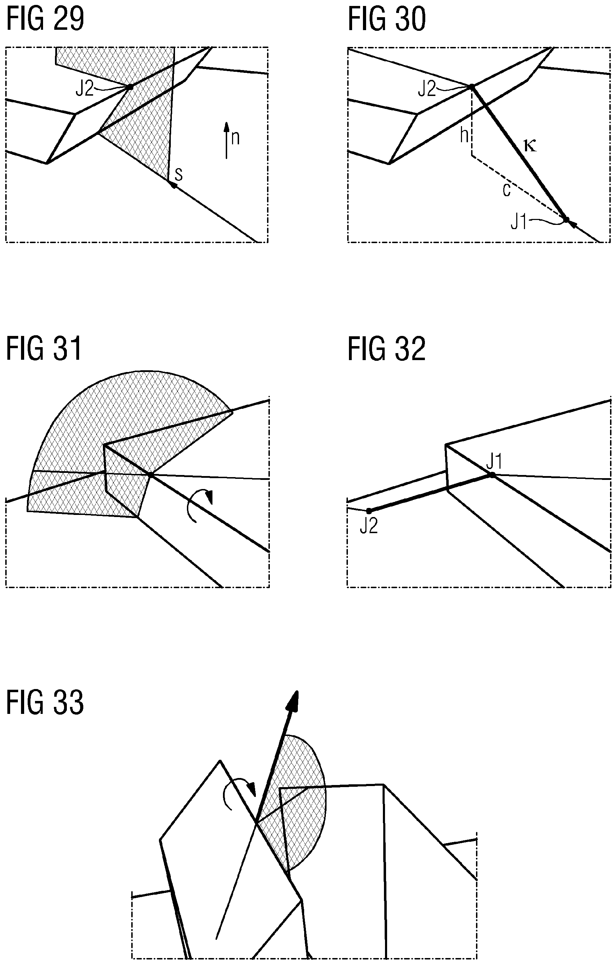

Bei einem optimalen Sprung von einer Fläche zu einer konvexen Kante gelten nicht die Symmetriebedingungen, wie im vorigen Fall, allerdings muss auch hier die komplette Sprungdistanz $\chi$ ausgenutzt werden, um lokale Optimalität zu gewährleisten. Darüber hinaus muss der Sprung in der Ebene liegen, die von der Flächennormale n und der Strahlrichtung s aufgespannt wird und die sogenannte Sprungebene bildet. Mit Hilfe dieses Kriteriums lässt sich ein Landepunkt $J_2$ des Sprunges ermitteln, indem man den Schnittpunkt der Sprungebene mit der konvexen Kante, zu der gesprungen werden soll, bestimmt (FIG 29). Danach lässt sich der Startpunkt $J_1$ des Sprunges konstruieren, indem man h auf die Absprungfläche projiziert und sich die Projektionshöhe h speichert. Vom projizierten Punkt läuft man dann um den Abstand c in negative Strahlrichtung, um schließlich $J_1$ zu erhalten. Der Abstand c berechnet sich gemäß Pythagoras aus

$$c = \sqrt{a^2 + x^2}$$

FIG 30 veranschaulicht die Konstruktion des Absprungpunktes.

3. Sprung von Kante zu Fläche

Dieser Sprungtyp entspricht dem Inversen des vorigen Falles, allerdings gestaltet sich die Behandlung etwas schwieriger. Der Startpunkt h des Sprunges ist trivial gegeben durch den Auftreffpunkt des Strahles und der Kante, von der aus auf eine Fläche gesprungen werden soll. Ein lokal optimaler Sprung muss zwei Kriterien einhalten. Zum einen muss die volle Sprungdistanz $\chi$ entsprechend dem Distanzkriterium ausgenutzt werden und zum anderen muss der Winkel zwischen dem Strahl und der Sprungkante nach dem Sprung entsprechend dem Winkelkriterium erhalten bleiben. Geometrisch gesehen liegen alle Strahlen die von h weiter führen und zur Sprungkante denselben Winkel haben, wie der ankommende Strahl, auf einem Doppelkegel der durch Rotation der Strahlgerade um die Sprungkante entsteht. Dabei ist nur die Hälfte des Doppelkegels zu betrachten, die dem ankommenden Strahl gegenüberliegt. Dieser Kegel ist in FIG 31 dargestellt. Das Distanzkriterium bedeutet geometrisch, dass nur diejenigen Punkte auf dem Kegel betrachtet werden müssen, die von h, also der Kegelspitze, genau um den Abstand $\chi$ entfernt sind. Diese Punkte bilden einen Kreis und der Schnittpunkt dieses Kreises mit der Ebene, auf die gesprungen werden soll ist der gesuchte Auftreffpunkt h, wie in FIG 32 dargestellt.

4. Sprung von Kante zu Kante

Stehen sich zwei konvexe Kanten in hinreichend geringem Abstand gegenüber, so kann direkt zwischen diesen beiden Kanten gesprungen werden. Dabei braucht die Sprungdistanz nicht ausgenutzt werden. Das einzige Kriterium, dass für die lokale Optimalität eingehalten werden muss, ist das bereits im vorigen Fall beschriebene Winkelkriterium. Um einen möglichen Landepunkt eines Sprunges von einer konvexen Kante auf eine andere zu berechnen, muss man den an der Absprungkante entstandenen Ausbreitungskegel mit der anderen Kante schneiden. Der Kegel entsteht dabei wiederum durch Rotation der weiterführenden Strahlgerade um die Ausgangskante, was in FIG 33 veranschaulicht ist. Der Sprung ist nur dann gültig, wenn die Distanz zwischen dem Absprung- und dem ermittelten Landepunkt kleiner oder gleich der maximalen Sprungweite $\chi$ ist.

Die vier Basistypen aus dem vorigen Abschnitt decken den Großteil der möglichen Sprünge bereits ab. Es existiert jedoch noch eine Reihe von Sonderfällen, die bei der Berechnung nicht außer Acht gelassen sollten.

5. Mehrfachsprünge (Bounces)

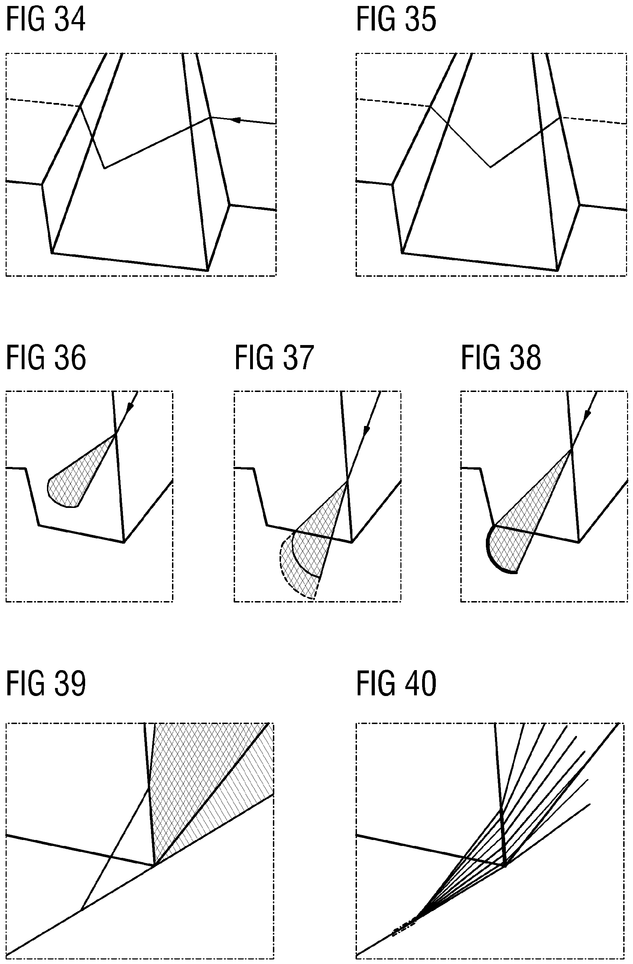

Falls von einem Landepunkt eines Sprunges direkt zu einer anderen Kante oder Fläche gesprungen werden kann, sprechen wir von einem Mehrfachsprung oder Bounce genannt. In diesem Fall führt die lokale Optimalität der einzelnen Sprünge meist nicht zu einem global optimalen Resultat. Ein klassisches Beispiel ist eine Fuge die für einen direkten Sprung von Kante zu Kante geringfügig zu breit ist. In diesem Fall würde ein Pfad an einer der Kanten einen lokal optimalen Sprung zur Bodenfläche der Fuge finden und könnte von diesem Landepunkt aus sofort auf die gegenüberliegende Kante springen, wie in FIG 34 zu sehen ist. Dies wäre jedoch nicht die kürzeste Verbindung zwischen den beiden Kanten. Der global optimale Pfad enthält zwei symmetrische Sprünge durch die Fuge, wie in FIG 35 dargestellt.

Keiner der einzelnen Sprünge ist lokal optimal da die maximale Sprungdistanz nicht ausgenutzt wird, jedoch ist der Pfadverlauf zwischen den beiden Kanten der Fuge aufgrund der Symmetrie der einzelnen Sprünge global optimal.

Es kann vorkommen, dass ein optimaler Pfad auch mehrere Bounces in Folge enthält, zum Beispiel bei einer konkaven Rundung.

6. Sonderfälle zwischen Flächen und Kanten

Der Fall eines einzelnen Sprunges von einer Fläche auf eine Kante oder umgekehrt zählt zu den zuvor diskutierten Basis-Typen. Allerdings tritt hier in beiden Fällen ein Spezialfall auf, falls die Kante senkrecht auf der Fläche steht.

6.1 Von Kante zu Fläche

Trifft ein Pfad auf eine konvexe Kante, kann er diese durch einen Sprung verlassen, solange sich der Winkel zwischen Pfad und der Kante nicht ändert. Ein Sprung auf eine Fläche muss darüber hinaus auch die maximale Sprungdistanz $\chi$ ausnutzen, was die möglichen Landepunkte auf den Kreis beschränkt, der zuvor beschrieben wurde und in FIG 31 dargestellt ist. Falls die Sprungkante senkrecht auf der Fläche steht, so sind die Fläche und die Kreisebene stets parallel. Es kann also nur dann zu einem Schnittpunkt kommen, wenn die Fläche exakt in der Kreisebene liegt. In diesem Fall gibt es jedoch unendlich viele optimale Landepunkte und der entsprechende Absprungpunkt auf der Kante bekommt die Eigenschaften eines Sattelpunktes, an dem sich der Pfad verzweigen kann, ohne seine lokale Optimalität zu verlieren. FIG 36 bis 38 veranschaulichen diese Situation.

6.2 Von Fläche zu Kante

Im umgekehrten Fall, in dem ein Pfad von einer Fläche auf eine konvexe Kante zu läuft, entsteht ein ganzer Verzweigungsbereich. FIG 39 zeigt einen Pfad ausgehend von einer Punktquelle, der einmal knapp rechts und einmal knapp links an einer senkrecht zur Fläche stehenden, konvexen Kante vorbei geht. Dargestellt ist ferner ein toter Bereich, der ohne Sonderbehandlung nicht optimal ausgefüllt werden kann, selbst nicht mit einer herkömmlichen Behandlung des Sattelpunktes (Schnittpunkt der senkrechten Kante und der Fläche). Um diese Situation korrekt zu behandeln, muss der Pfad, der exakt auf den Sattelpunkt zu läuft, in einem bestimmten Bereich abgetastet werden, wobei von jedem Abtastpunkt auf den entsprechenden Punkt der Kante gesprungen wird, der genau um die Sprungdistanz $\chi$ entfernt ist (FIG 40). Die weiterführenden Strahlen dieser Sprünge decken den zuvor toten Bereich vollständig und mit optimalen Distanzwerten ab.

6.3 Pseudo-Sattelpunkte

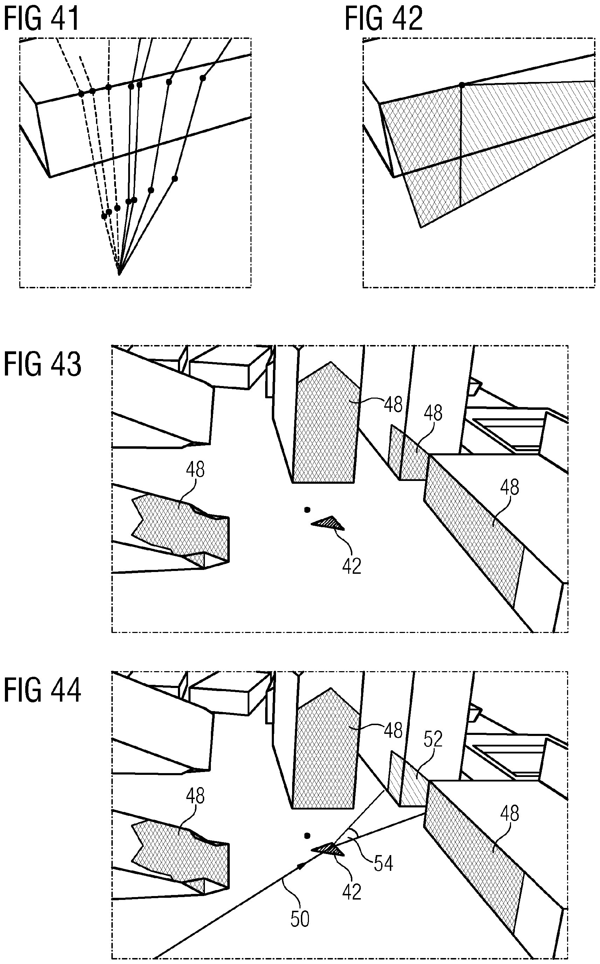

Durch die Tatsache, dass Sprünge nur bis zu einer maximalen Länge $\chi$ möglich sind, können an bestimmten Stellen Sattelpunkte an konvexen Kanten entstehen. Ein Beispiel dafür ist bereits FIG 38 bekannt, und zwar beim Spezialfall eines Sprunges von einer konvexen Kante auf eine senkrecht dazu liegende Fläche. Ein ähnlicher Effekt kann an beliebigen konvexen Kanten entstehen, und zwar immer dann, wenn ein Übergang zwischen zwei Basistypen entsteht. FIG 41 zeigt mehrere von einer Punktquelle ausgehende Pfade, die sich in Richtung einer konvexen Kante bewegen. Die Sprungdistanz sei ohne Beschränkung der Allgemeinheit so gewählt, dass auf die Kante nur dann direkt gesprungen werden kann, wenn der Winkel zwischen Pfad und Kante größer als 60° ist. Bei kleineren Winkeln reicht die Sprungdistanz nicht mehr aus, um direkt auf die Kante zu springen. In diesen Fällen springt der Pfad erst auf die anliegende Fläche, und verläuft dann geodätisch über die Kante hinweg weiter. In FIG 41 sind diejenigen Pfade gezeigt, die einen Winkel größer 60° mit der konvexen Kante bilden und damit direkt auf diese Springen können. Weitere Pfade müssen den Umweg über die anliegende Fläche gehen, da Sprungdistanz in diesem Winkelbereich für einen optimalen Sprung auf die Kante nicht mehr ausreicht. Zwischen diesen beiden Fällen gibt es einen Übergangspunkt auf der Kante und die weiterführenden Strahlen um diesen Punkt weisen einen toten Winkel auf. Dies kann man sich leicht vorstellen, wenn man sich die Proxy-Geometrie veranschaulicht, durch die man die Sprünge ausgehend von dem gegebenen Quellpunkt durch normale Geodätenberechnung simulieren kann. Diese Geometrie ist in FIG 42 dargestellt. Es fällt auf, dass diese am Übergangspunkt einen Sattelpunkt bildet.

Die algorithmische Schwierigkeit an diesem Szenario ist, dass sich diese Pseudo-Sattelpunkte nicht vorausberechnen lassen, da sie abhängig von der ankommenden Strahlenrichtung sind. Diese ist jedoch erst zur Laufzeit des Algorithmus bekannt. Eine Lösung dieses Problems weiter unten vorgestellt.

6.4 Sprünge auf spezielle Geometrien

Die vorgestellten lokalen Optimalitätskriterien gelten für eine weitere Ausbreitung des Strahles nach einem Sprung. Eine weitere Ausbreitung ist jedoch nicht nötig, wenn es sich um Zielgeometrie oder elektrisch leitende Bauteile handelt. In diesen Fällen muss der Sprung so gewählt werden, dass er diese Geometrie auf kürzestem Wege erreicht.

Ein Sprung auf die Oberfläche eines solchen Objektes kann zum Beispiel nur dann optimal sein, wenn die Sprungrichtung senkrecht auf der Oberfläche steht. Ein Sprung auf eine konvexe Kante dieser speziellen Geometrie kann nur optimal sein, wenn dieser orthogonal zur Kante ist.

Ein weiterer Spezialfall, der in der Norm jedoch nicht exakt definiert ist, ist ein Sprung zwischen zwei verschieden Isolatorklassen. Die entscheidende Frage hierbei ist, mit welchem Faktor die in der Luft zurückgelegte Distanz gewichtet werden soll. Diese Frage beeinflusst maßgeblich die Verkürzungen durch die Sprünge und den weiteren Verlauf der Pfade. Man ist jedoch auf der sicheren Seite, wenn man der Sprungstrecke den Wert des schlechteren Isolators zuweist, da in diesem Fall die Strecke kürzer sein wird als in jeder anderen Variante und damit eine Normverletzung nicht fälschlicherweise unerkannt bleiben kann.

Im Folgenden wird die algorithmische Behandlung der Sprünge diskutiert.

Das algorithmische Grundkonzept basiert auf der Ausbreitung von einzelnen Strahlen ausgehend von einer Quelle unter Berücksichtigung lokaler Optimalitätskriterien. Jeder Strahl führt dabei die aktuelle Distanzinformation mit sich und speichert diese während der Ausbreitung an den jeweiligen Kanten- und Vertex-Slots. Bei einer hohen Strahlendichte erhält man ein dichtes Distanzfeld um eine Quell-Geometrie herum und kann jeden Pfad innerhalb dieses Distanzfeldes zur Quelle zurückverfolgen. Hier wird beschrieben, wie die zuvor beschriebenen Sprünge in die Strahlenpropagierung mit einbezogen werden können.

Zunächst ist eine Vorverarbeitung vorgesehen. Der Vorteil bei der bisherigen Berechnung ohne Sprünge war, dass sich ein Strahl nur über benachbarte Dreiecke hinweg ausbreiten konnte, und daher genügte die Kenntnis der lokalen Topologie eines Dreiecks für die effiziente Propagierung. Bezieht man jedoch die Sprünge ein, kann sich ein Pfad auch zwischen zwei topologisch weit entfernten oder sogar unverbundenen Dreiecken entwickeln. Oben wurde beschrieben, wie für zwei geometrische Primitive wie Dreiecke oder konvexe Kanten berechnet werden können, ob und wo es für einen gegebenen Strahl einen optimalen Sprung zwischen den jeweiligen Primitiven gibt.

Möchte man zum Beispiel einen Sprung zwischen zwei Flächen ermitteln, so müsste man das Dreieck, auf dem sich der Pfad momentan befindet, gegen jedes andere Dreieck in der Baueinheit testen und jeweils die vorherigen Berechnungen vollziehen. Dies wäre jedoch extrem ineffizient und lässt sich durch einen Vorverarbeitungsschritt stark vereinfachen, indem man eine Menge von potentiellen Sprungpartnern für jedes Dreieck bestimmt. Es handelt sich dabei um alle anderen Dreiecke, zu denen theoretisch gesprungen werden kann, die also euklidisch nicht weiter entfernt sind, als die maximale in der Norm auftretende Sprungdistanz, und die vom Ausgangsdreieck aus sichtbar sind. FIG 43 zeigt ein Beispiel für ein Dreieck und seine potentiellen Sprung-Dreiecke. Einem Dreieck 42 werden alle Dreiecke 48 als potentielle Sprungpartner zugewiesen. Es handelt sich dabei um Dreiecke 48, zu denen potentiell gesprungen werden kann.

Die gleiche Vorverarbeitung muss natürlich auch für Paare von Dreiecken und konvexen Kanten vollziehen, um auch die anderen Basistypen effizient behandeln zu können.

Im Folgenden wird die Behandlung der Basis-Typen beschrieben. Trifft man während der Strahlenausbreitung auf ein neues Dreieck oder eine konvexe Kante, so werden die Sprungparameter nur für die geometrischen Primitive berechnet, die in der Liste der potentiellen Sprungpartner des Dreiecks oder der Kante stehen. Hat man einen Sprung detektiert, der die lokalen Optimalitätskriterien einhält, wird ein neuer Strahl an der Absprungstelle emittiert. Der alte Strahl wird weiterhin ohne Sprung ausgebreitet, da man an dieser Stelle noch nicht sagen kann, ob der Weg zur Zielgeometrie durch den Sprung wirklich kürzer ist als ohne. Dies wird sich erst herausstellen, wenn alle Möglichkeiten abgelaufen wurden und sich am Ende nur die global kürzesten Pfade durchgesetzt haben.

Im Folgenden wird die Behandlung von Bounces beschrieben. Um einen Bounce zu behandeln, genügt es nicht, die Berechnung auf den nächsten potentiellen Sprungpartner zu) beschränken. Für einen einzelnen Bounce bräuchte man eine Serie von drei geometrischen Primitiven, nämlich den Absprungpunkt, den Bounce und den Landepunkt. Es folgt eine Berechnung, ob ein symmetrischer Sprung vom Start- zum Zielprimitiv über einen Bounce vom dritten Primitiv möglich ist. In der momentanen Implementierung bedeutet dass, das bei der Propagierung eines Strahles nicht nur ein Basissprung auf die potentiellen Sprungpartner des aktuellen geometrischen Primitivs berechnet wird, sondern für jeden der potentiellen Sprungpartner werden, dessen potentiellen Sprungpartner wiederum für einen möglichen Bounce in Betracht gezogen. Die Komplexität für die Berechnung eines einzelnen Sprunges erhöht sich damit von $O(n)$ auf $O(n^2)$, wobei n die Anzahl der potentiellen Sprungpartner eines geometrischen Primitivs ist. Möchte man Serien von i Bounces berechnen, erhöht sich die Komplexität sogar auf $O(n^{i+1})$. Das ist in dieser Form nicht umsetzbar, und es sind ausgeklügeltere Vorberechnungsschritte nötig.

Eine Lösung dieses Problems ist die Aufteilung der potentiellen Sprungpartner in diskrete Winkelbereiche. Bei bekannter Strahlenrichtung kommt nur ein Bruchteil der Sprungpartner für die Berechnungen in Frage, nämlich nur jene, die in der Sprungebene liegen, das heißt, die Ebene, die durch die Strahlrichtung und die Oberflächennormale aufgespannt ist. Da die Stahlrichtung erst zur Laufzeit des Algorithmus bekannt ist, wird zumindest eine Einteilung der potentiellen Sprungpartner in bestimmte Winkelbereiche als Vorberechnungsschritt durchgeführt. Bei der Strahlen-Propagierung werden dann nur die Sprungpartner in Betracht gezogen, die im entsprechenden Winkelbereich der nun bekannten Strahlenrichtung liegen. Dies ist in FIG 44 veranschaulicht. Für eine Berechnung möglicher Sprünge werden für einen ankommenden Strahl 50 nur potentielle Sprungpartner 52 in einem entsprechenden Winkelbereich 54 in Betracht gezogen.

Diese verbesserte Datenstruktur beschleunigt nicht nur die Berechnung der Basistypen, sondern ermöglicht auch die effiziente Behandlung von Bounces.

Im Folgenden wird die Behandlung von Pseudo-Sattelpunkten beschrieben. Wie bereits erwähnt, kann die zuvor angegeben algorithmische Behandlung der Pseudo-Sattelpunkte nicht durch eine Vorberechnung vereinfacht werden, da sowohl Lage als auch der Bereich des toten Winkels von der Richtung der Strahlen abhängen. Allerdings kann man die Pseudo-Sattelpunkte auch während der Strahlenausbreitung nicht bestimmen, da man zu diesem Zeitpunkt zwar die Strahlenrichtung bezüglich der betreffenden konvexen Kante kennt, jedoch hat ein Strahl keine Kenntnis über seine benachbarten Strahlen. Daher ist es unmöglich, den benötigten Übergangspunkt zwischen den beiden Basis-Sprungtypen während der Laufzeit zu ermitteln. Es bleibt also nur, dieses Problem in einem Post-Prozess zu lösen. Dies ist möglich, da in jedem Slot neben der Distanz zur Quelle auch die Informationen über den bis dahin zurückgelegten Weg gespeichert ist. Um einen Pseudo-Sattelpunkt zu ermitteln, sucht man nach vollständiger Berechnung des Distanzfeldes auf den konvexen Kanten nach zwei benachbarten Slots, die unterschiedliche Basistypen als letzten Sprung aufweisen. Von diesen Punkten aus müssen dann in den entsprechenden toten Winkelbereich neue Strahlen emittiert werden.

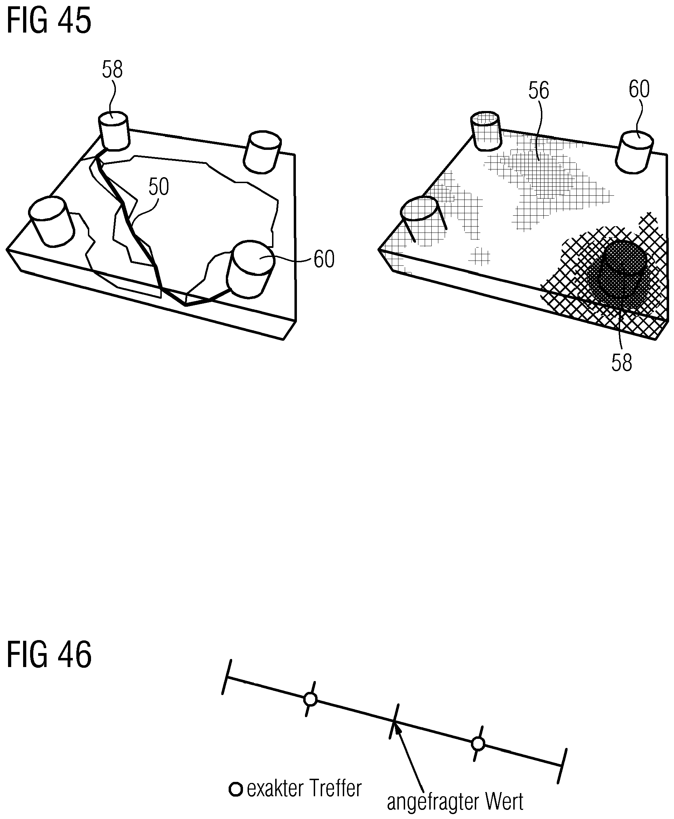

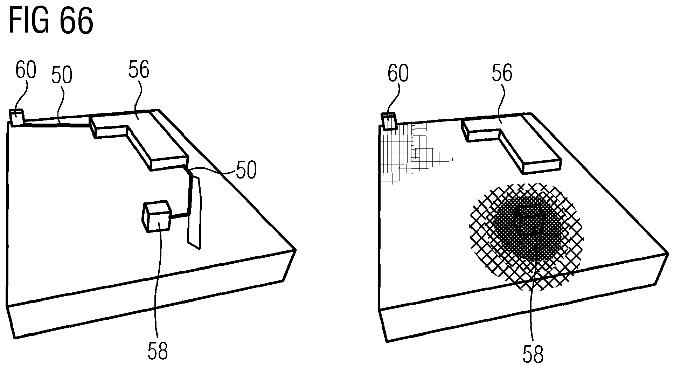

Im Folgenden wird die Zurückverfolgung des kürzesten Pfades beschrieben. Bislang wurde beschrieben, wie man ein Distanzfeld auf Dreiecksnetzen ausgehend von beliebig geformten Quellen 58 unter Berücksichtigung unterschiedlich gewichteter Oberflächen aufbaut. Meist ist jedoch nicht nur der Distanzwert selbst an einem bestimmten Zielpunkt 60 von Interesse, sondern auch der Verlauf des Pfades, der zu diesem Abstand geführt hat. Die gespeicherten Quellinformationen in jedem Distanzvektor erlauben die einfache Zurückverfolgung eines solchen Strahles, das sogenannte back-tracing. Dazu wird zunächst die Quelleninformation gelesen, die im Distanzvektor des Zielpunktes gespeichert ist. Diese beinhaltet nicht etwa den Ausgangspunkt des Strahles an der ursprünglichen Quelle 58, sondern den Ausgangspunkt der letzten Strahlen-Emittierung, was ebenso ein Sattelpunkt, ein M-Vertex, eine Reflexionskante oder ein elektrisch leitendes Teil sein kann. Der darin gespeicherte Distanzvektor verrät wiederum die Quelle 58 des vorherigen Streckenabschnittes, bis irgendwann eine Anfangsdistanz von 0 in der Quelleninformation steht, was auf die ursprüngliche Quelle 58 hinweist. Ein Aneinanderreihen aller gesammelten Quellen 58 liefert eine Streckenbeschreibung des Pfades in Form von Verzweigungspunkten. Da in jedem dieser Punkte auch die Richtung des optimalen Strahles gespeichert ist, kann nun durch einen einzelnen Strahlenschuss in entsprechende Richtung mit einer Maximaldistanz, die der Distanz zur jeweils nächsten Quelle 58 entspricht, die Teilstrecke zwischen den einzelnen Verzweigungspunkten rekonstruiert werden. FIG 45 zeigt Beispiele für rekonstruierte kürzeste Pfade zusammen mit dem jeweiligen Distanzfeld um die Quelle 58. Schematisch sind kürzeste Pfade zwischen einer Quelle 58 und einem Ziel 60 dargestellt. Die Leitfähigkeit von Isolatoren ist durch ihre Helligkeit dargestellt, je heller desto leitfähiger. FIG 45 zeigt zwei nebeneinander angeordnete, schematische Darstellungen für kürzeste Pfade zwischen einer Quelle 58 und einem Ziel 60, wobei die Leitfähigkeit von Isolatoren durch ihre Helligkeit dargestellt ist, je heller desto leitfähiger, wobei elektrisch leitende Objekte als elektrisch leitende Komponenten dargestellt sind, wobei links eine schematisch perspektivische Ansicht und rechts eine zugeordnete gerastert digitalisierte Darstellung gezeigt ist. Weiterhin sind Objekte 56 als elektrisch leitende Komponenten bzw. Bauteile möglich. Dies zeigt FIG 66 in einer schematischen Darstellung wie FIG 45, bei der ergänzend ein elektrisch leitfähiges Bauteil 56 vorgesehen ist.

In der Kriechstreckenanalyse ist es unter anderem wichtig, jede Normverletzung zuverlässig zu erkennen, das heißt, dass der gemessene Abstand unter keinen Umständen größer sein darf als der tatsächliche Abstand. In diesem Abschnitt wird nun gezeigt, dass man mit dem Strahlenschuss Algorithmus jederzeit volle Kenntnis und auch Kontrolle über den maximalen Fehler hat und somit eine solche konservative Distanzmessung möglich ist.

Jeder Punkt, der von einem Primärstrahl getroffen wurde, besitzt den exakten Distanzwert. Des Weiteren kann man mit den vorbeschriebenen Maßnahmen dafür sorgen, dass jeder Slot auf der Zielgeometrie mindestens einmal von einem optimalen Strahl getroffen wurde. Es wird zunächst davon ausgegangen, dass alle Slots der Zielgeometrie ausschließlich von Primärstrahlen getroffen wurden. In diesem Fall ist ein Distanzwert, der an einer beliebigen Stelle einer Zielkante abgefragt wurde, maximal eine Slotlänge vom nächsten exakten Treffer entfernt. FIG 46 zeigt diesen Extremfall.

Im Folgenden wird der Gesamtalgorithmus zur Kriechstreckenberechnung dargestellt. Man kann sich leicht vorstellen, dass der Fehler nur dann auch genau einer Slotlänge entspricht, wenn der Strahl der zu den Distanzwerten geführt hat, exakt auf der Kante entlang verlief. In jedem anderen Fall ist der maximale Fehler kleiner als die Slotlänge, selbst wenn der Fall aus obiger FIG vorliegt. Ein Strahl, der exakt an einer Kante entlang verläuft, kann jedoch nie das Muster aus FIG 46 hinterlassen. Dies folgt unmittelbar aus der Tatsache, dass an jedem Slot letztendlich der Treffer mit der geringsten Distanz zur Quelle dessen Wert bestimmt. Die Annahme, dass der maximale Fehler einer Slotlänge entspricht, ist also selbst im Extremfall eine konservative Fehlerabschätzung. Die Slotgröße ist also der entscheidende Faktor für die Genauigkeit an Kanten auf der Zielgeometrie.

Ein weiterer wichtiger Aspekt ist der maximale Fehler an Vertices, insbesondere an solchen, die eine Verzweigung des Pfades verursachen und somit als Pseudo-Quellen auftreten. Ein Sekundärstrahl, der von so einem Vertex emittiert wird, besitzt zwar stets die exakte Distanz zu seiner Pseudo-Quelle, allerdings trägt er den Fehler mit sich, der bereits an der Pseudo-Quelle selbst gemacht wurde. Für diesen Fehler lässt sich ebenfalls ein Maximalwert angeben, nämlich die Treffungenauigkeit ε, die im Distanzvektor des entsprechenden Vertex gespeichert ist. Der maximale Fehler an einem beliebigen Punkt auf der Kontur der Zielgeometrie setzt sich also zusammen aus:

> 1. Dem Abstand des abgefragten Punktes zum nächsten exakten Treffer. Dieser ist maximal eine Slotlänge.

> 2. Der Addition der Treffungenauigkeiten aller auf dem Pfad liegender Verzweigungspunkte.

Damit der globale Fehler maßgeblich von der Slotgröße bestimmt wird, sollten die Fehler an den Verzweigungspunkten gering im Vergleich zur Slotgröße gehalten werden. Daher wird mit den vorher angegebenen Maßnahmen nach jeder Iteration sichergestellt, dass an Verzweigungspunkten der Fehler bei unter 1/1000 der Slotgröße liegt. Somit hat man durch Einstellen des Slotgröße einen globalen Parameter, der einen Tradeoff zwischen Geschwindigkeit und Genauigkeit bietet.

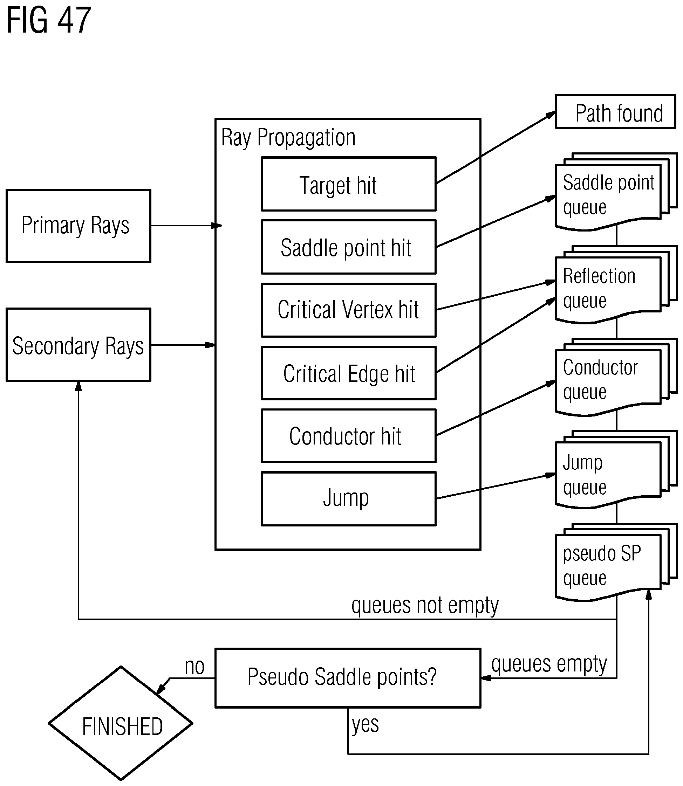

Es wird nun das finale Schema der Kriechstreckenberechnung beschrieben. Der Algorithmus ist so konzipiert, dass die Propagierung eines einzelnen Strahles als eigenständiger, unabhängiger Prozess laufen kann. Jede Verzweigung eines Strahls, sei es durch einen Sattelpunkt, eine kritische Reflexion oder eines Sprunges, bedeutet das Starten eines neuen Propagierungs-Prozesses, es wird also keine rekursive Strahlberechung innerhalb eines laufenden Prozesses ausgeführt. Das heißt wiederum, dass bei jedem Verzweigungspunkt die jeweilige Verzweigung in einer Liste zur späteren Weiterbehandlung gespeichert werden muss. Das Gesamtschema des Algorithmus ist in FIG 47 dargestellt.

Jeder Strahl, ob nun Primär- oder Sekundärstrahl, aktualisiert die entsprechende Liste, falls er während der Ausbreitung auf einen der besonderen Punkte trifft, und er terminiert, falls die Zielgeometrie erreicht wird. Ist man nur an der Ausbreitung einer bestimmten Maximaldistanz interessiert, so kann man auch das Erreichen dieser Distanz als weiteres Abbruchkriterium einfügen. Die einzige Liste, die nicht innerhalb der Strahl-Propagierung aktualisiert werden kann, ist die der Pseudo-Sattelpunkte. Diese ist erst in einem Post-Prozess behandelbar. Diese Behandlung kann den Algorithmus reaktivieren und zu weiteren Aktualisierungen der anderen Listen führen. Erst wenn alle Listen leer sind und keine Pseudo-Sattelpunkte mehr gefunden werden, terminiert der Algorithmus.

Ein weiteres Ausführungsbeispiels beschreibt eine Möglichkeit der Luftstreckenanalyse gemäß der Erfindung.

Das Problem der Luftstreckenanalyse entspricht im Wesentlichen einer im wissenschaftlichen Umfeld bereits bekannten Problemstellung, dem Gummibandproblem, wofür es jedoch keine allgemeine und effiziente Lösung gab. Ein wichtiger Aspekt für die Durchführbarkeit der Luftstreckenanalyse ist Tatsache, dass die minimale Luftstreckendistanz, die zwischen zwei Potentialen erfüllt sein muss (Normgrenze), sehr klein im Vergleich zum vollständigen Bauteil ist. Wie schon bei der Kriechstreckenanalyse, muss das Distanzfeld lediglich bis zur Normgrenze propagiert werden, wodurch die Analyse auch hinsichtlich der Luftstrecken unabhängig von der Gesamtkomplexität der Baugruppe ist. In den folgenden Abschnitten wird der neu entwickelte Algorithmus, auf dem die Erfindung basiert und der das Luftstreckenproblem in einer angemessenen Zeitspanne approximativ löst, beschrieben.

Das allgemeine Lösungskonzept basiert auf einer strahlenförmigen Propagierung von optimalen Pfaden. Die Distanzwerte, die dabei zurückgelegt werden, werden in Slots an konvexen Kanten gespeichert. Das Resultat ist ein homogenes Distanzfeld an konvexen Kanten bzw. an der Zielgeometrie.

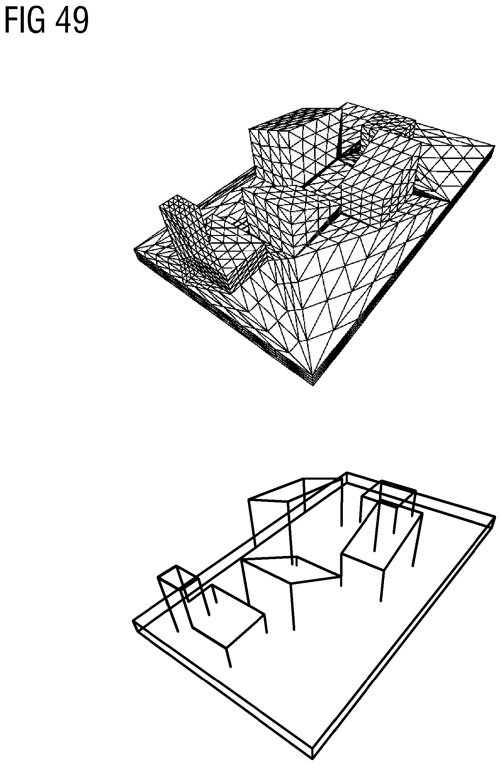

Um die Berechnung eines korrekten Distanzfeld effizient zu gestalten, werden nur Strahlen betrachtet, die bestimmte lokale Optimalitätskriterien einhalten. FIG 49 zeigt das algorithmische Verfahren zur Luftstreckenberechnung gemäß der Erfindung. Dabei durchläuft jeder optimale Pfad diesen Zyklus, in dem zunächst sein optimaler Ausbreitungsbereich festgestellt wird, und anschließend dieser Bereich mit den Silhouettenkanten des Bauteils geschnitten wird. Falls der Sichtbarkeitstest zwischen Anfangs- und Schnittpunkt erfüllt ist, wird erneut der Ausbreitungsbereich für den Schnittpunkt berechnet, falls weder ein Leiter noch die Zielgeometrie erreicht sind. FIG 49 zeigt eine schematische Darstellung einer Reduzierung eines originalen Dreiecksnetzes auf seine konvexen Kanten, ausgehend von einer Dreiecksnetzrasterung in einer oberen Darstellung zu einer Silhouettendarstellung unten.

Analog zur Kriechstreckenanalyse wird auch zur Berechnung der Luftstrecke ein Ansatz gewählt, der auf Ausbreitung einzelner Pfade basiert. Die Problemstellung ist diesmal jedoch nicht, ein vollständiges Distanzfeld auf gewichteten Oberflächen zu erstellen, sondern einen Pfad zu finden, der sich am effizientesten um Hindernisse zwischen einer Quelle und einem Ziel herum bewegt. Dabei entstehen an jedem Hindernis mögliche Verzweigungen des Pfades. Im Folgenden wird beschrieben, wie sich der Bereich einer Verzweigung abhängig von der getroffenen Geometrie einschränken lässt, was letztendlich eine effiziente Berechnung der Luftstrecke ermöglicht.

Der Ansatz der optimalen Pfadfindung kann von 2D um eine Dimension erweitert werden. Dabei ist folgende Beobachtung zu machen:

In 2D kann sich ein optimaler Pfad nur zwischen einzelnen Eckpunkten der polygonalen Hindernisflächen ausbreiten bzw. nur an diesen seine Ausbreitungsrichtung ändern. Zwischen den jeweiligen Eckpunkten wird der Pfad mittels einer geraden Linie beschrieben. In 3D kann die gleiche Aussage getroffen werden, wobei die Wegrichtung des optimalen Pfades sich nicht nur an den Objekteckpunkten sondern auch an deren konvexen Kanten ändern kann. Demnach kann der Suchraum für einen optimalen Pfad auf konvexe Kanten von Hindernissen begrenzt werden, da sich der potentielle Pfad nur über diese ausbreiten kann. FIG 49 zeigt zum einen das Eingangs-Dreiecksnetz und zum anderen die Reduzierung des Netzes auf seine konvexen Kanten, die zur optimalen Pfadfindung benutzt werden. Die FIG 49 zeigt deutlich auf, dass die Anzahl der Kanten drastisch verringert werden kann, da auch Kanten mit gleichen Normalen an anliegenden Dreiecksflächen während der Analyse nicht betrachtet werden müssen.

Trifft ein Pfad auf eines der Elemente dieser vereinfachten Szenendarstellung, ergeben sich je nach Art des Treffpunktes zwei unterschiedliche Ausbreitungsbereiche:

1. Ausbreitungskegel an Kantenpunkten

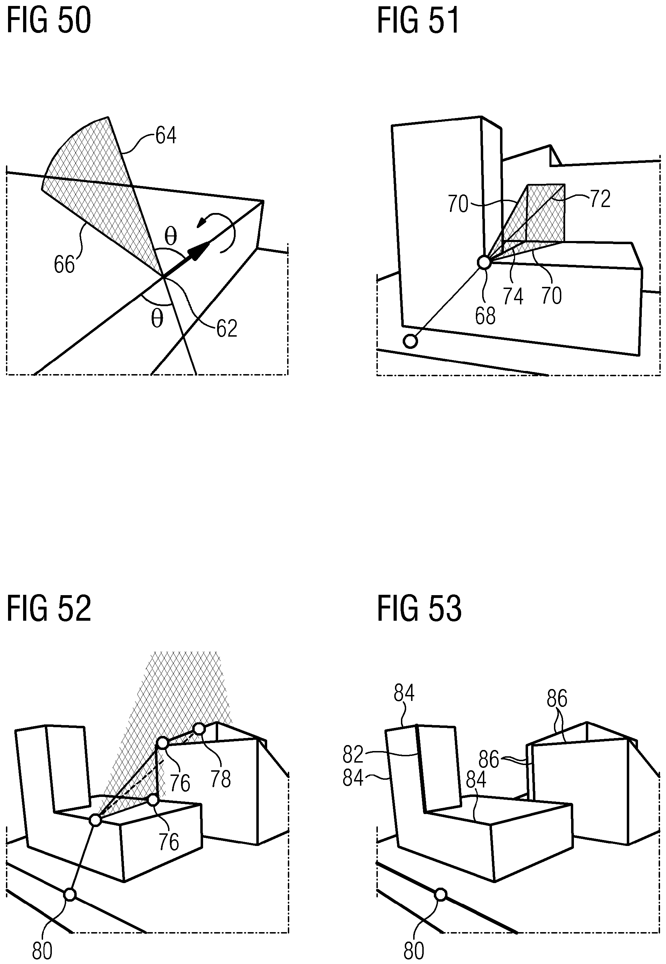

Wurde ein Punkt $p_k$ im Inneren einer konvexen Kante von einem optimalen Pfad getroffen, so muss nun ermittelt werden, wie sich dieser Pfad weiter ausbreiten kann, damit er seine Optimalität beibehält. In diesem Fall ist festzustellen, dass sich der Pfad nur in einem eingeschränkten, zweidimensionalen Bereich weiter ausbreiten kann, dem Ausbreitungskegel. Der Ausbreitungskegel ist eindeutig über den einfallenden Richtungsvektor des optimalen Pfades in $p_k$ und der Richtung der konvexen Kante bestimmt. Der Kegel entsteht durch Rotation des Richtungsvektors des Pfades mit der Kantenrichtung als Rotationsachse. Dadurch erhält man alle möglichen Richtungen, bei denen der Winkel zur Kante konstant bleibt, was das lokale Optimalitätskriterium für eine weitere Ausbreitung am Punkt $p_k$ darstellt. Ein Beispiel für einen Ausbreitungskegel ist in FIG 50 zu sehen.

2. Ausbreitungsfrustum an Sattelpunkten

An Sattelpunkten $p_s$, das heißt, an Punkten deren anliegenden Dreiecke einen Gesamtwinkel von 360° überschreiten, ist die Ausbreitungsrichtung nicht mehr über den Ausbreitungskegel eindeutig gegeben. In diesem Fall sind die Richtungen, in die sich der optimale Pfad ausbreiten kann, von einem Frustum begrenzt. Die Vektoren, die dieses Frustum aufspannen, sind ein weiterführender Richtungsvektor rs = ps + r, Geodäten von rs bezüglich der zwei anliegenden Oberflächen sowie eine Kante zwischen den anliegenden Oberflächen. Nur innerhalb dieses Bereichs kann sich der einfallende Strahl ausbreiten, um weiterhin einen optimalen Pfad zu beschreiben. FIG 51 zeigt ein Beispiel für ein Ausbreitungsfrustum. In der linken FIG ist ein Ausbreitungskegel an einem Kantenpunkt $p_k$ 62 dargestellt. Er wird vom fortgesetzten Vektor r 64 und dessen Geodäte auf einer Oberfläche 66 aufgespannt.

Die rechte FIG zeigt ein Ausbreitungsfrustum an einem Sattelpunkt 68. Eine Linie 72 ist der weiterführende Vektor, Linien 70 sind dessen Geodäten auf den anliegenden Oberflächen und eine Linie 74 beschreibt die Schnittkante der zwei anliegenden Oberflächen.

Nachdem ein Ausbreitungskegel an einem Verzweigungspunkt ermittelt wurde, können an allen Schnittpunkten zwischen dem Kegel und weiteren konvexen Kanten der Szene neue Verzweigungspunkte entstehen. Damit dies der Fall ist, müssen die Schnittpunkte folgende zwei Kriterien erfüllen:

1. Sichtbarkeitskriterium

Dieses Kriterium überprüft die Sichtbarkeit des Schnittpunktes vom jeweiligen Ausbreitungspunkt p. Dazu werden zunächst die einzelnen Strahlen $r_i$ = p - $p_{k,i}$ zwischen dem Ausbreitungspunkt p und den Schnittpunkten $p_{k,i}$ mit konvexen Kanten ermittelt. Danach wird jeder einzelne Strahl $r_i$ auf Schnittpunkte mit der ganzen Szene hin überprüft und der Schnittpunkt mit einem geringsten Distanzwert $\delta$ ermittelt. Entspricht $\delta$ genau dem euklidischen Abstand zwischen p und $p_k$, so ist $p_k$ sichtbar von p aus und $p_k$ liegt auf dem optimalen Pfad. In allen anderen Fällen ist $p_k$ von p aus nicht sichtbar und die Pfadausbreitung kann nicht über pk erfolgen (vgl. FIG 52). FIG 52 zeigt einen Ausbreitungskegel mit zwei sichtbaren Schnittpunkten 76 und einem nicht sichtbaren Schnittpunkt 78 ausgehend von einem Punkt 80. Der Sichtbarkeitstest, wie er hier beschrieben ist, ist mittels Raytracing gelöst. Mit Hilfe von geeigneten Datenstrukturen (Bounding Boxes, kd-Bäumen) wird er effizient auf einer Rechnereinheit wie einer CPU durchgeführt oder komplett auf eine Graphikkarte ausgelagert.

2. Silhouettenkriterium

Das zweite Kriterium, das ein Schnittpunkt erfüllen muss, um ihn als neuen Verzweigungspunkt zu qualifizieren, ist das Silhouettenkriterium. Ein Kantenpunkt $p_k$ befindet sich auf einer Silhouettenkante des Szene, wenn folgendes gilt:

$$\frac{r}{\|r\|} \cdot n_0 \quad <= 0$$

$$\frac{r}{\|r\|} \cdot n_1 \quad > \quad 0$$

wobei $n_0$ und $n_1$ den Normalen der angrenzenden Flächen der Kante entsprechen. Falls der Schnittpunkt nicht auf einer Silhouettenkante liegt, so kann sich der Pfad an diesem Punkt nicht weiter optimal ausbreiten. In diesem Fall muss der Pfad an dieser Stelle abgebrochen werden. FIG 53 zeigt ein Modell, dessen Kanten auf das Sichtbarkeits- und Silhouettenkriterium hin überprüft wurden. Bezüglich des Punktes 80 erfüllen die Kanten 86 nur das Silhouettenkriterium, Kanten 82 nur das Sichtbarkeitskriterium, und Kanten 84 erfüllen beide Kriterien.

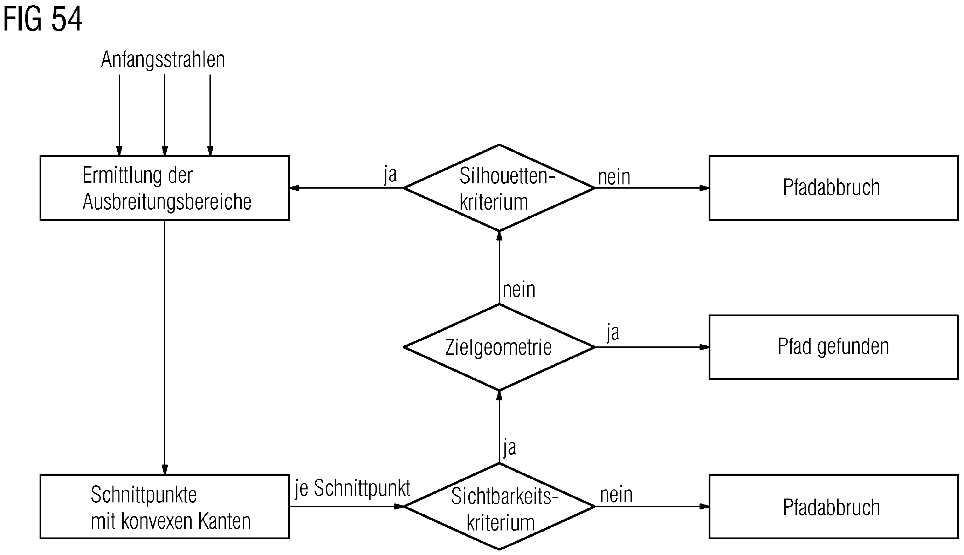

Der algorithmische Lösungsansatz zur Luftstreckenanalyse erfolgt über eine strahlenförmige Ausbreitung des Distanzfeldes. Dazu werden zunächst einzelne Strahlen in alle Richtungen von einer Punktquelle aus emittiert. Die Ausbreitung des Distanzfelds von polygonalen Flächenquellen aus wird weiter unten behandelt. Um die Anzahl der Anfangsstrahlen zu reduzieren, werden von der Quelle aus nur Strahlen emittiert, die auch eine konvexe Kante der Szene schneiden. Diese werden identifiziert, indem zuerst von der Quelle aus Kanten detektiert werden, welche die vorgenannten Kriterien erfüllen. Danach werden die Kanten regelmäßig und fein abgetastet, wobei die Abtastpunkte zusammen mit dem Quellenpunkt die Richtung des jeweiligen Strahls aufweisen. Jeder dieser Strahlen wird anschließend nach den im vorherigen Abschnitt beschriebenen Optimalitätskriterien verfolgt. Hierbei werden die ermittelten Ausbreitungsbereiche (Ausbreitungskegel oder Ausbreitungsfrustum) mit allen konvexen Kanten des Bauteils geschnitten. Im Fall eines Ausbreitungsfrustums werden die Schnittkanten, die innerhalb des Frustums liegen, an diskreten Punkten abgetastet. An den resultierenden Schnittpunkten werden die Sichtbarkeits- und Silhouettenkriterien ausgewertet. Falls beide positiv ausfallen, so wird für diese Schnittpunkte wiederum der Ausbreitungsbereich berechnet. Falls das Sichtbarkeitskriterium erfüllt ist und der Schnittpunkt sich bereits auf der Zielgeometrie befindet, so wird der Pfad abgebrochen und als gültiger Pfad zwischen Start- und Zielgeometrie gekennzeichnet. In allen anderen Fällen wird der Ausbreitungspfad abgebrochen. FIG 54 veranschaulicht die beschriebene Strahlenpropagierung in einem vereinfachten Schema.

Um eine effiziente Speicherung und Rekonstruktion von Pfaden zu ermöglichen, wird während der Strahlenpropagierung eine baumähnliche Datenstruktur aufgebaut. Diese Baumstruktur enthält verschiedene Arten von Knoten, die zueinander mittels Referenzen auf ihre Vorgänger- und Nachfolgerknoten in Beziehung stehen. Bei der Erstellung des Baumes wird sichergestellt, dass alle Knoten zumindest das Sichtbarkeitskriterium bezüglich ihres Vorgängers und Nachfolgers erfüllen. Darüber hinaus wird zwischen drei Knotenarten unterschieden:

1. Wurzelknoten: Quellpunkte, für die ein optimaler Pfad berechnet werden soll.

2. Innere Knoten: Ausbreitungspunkte, die das Silhouettenkriterium bezüglich ihres Vorgängerknotens erfüllen.

3. Blattknoten: Punkte auf der Zielgeometrie sowie Punkte, die zum Pfadabbruch führen.

Wie in FIG 54 angedeutet, führen Schnittpunkte, die das Sichtbarkeits- und/oder das Silhouettenkriterium nicht erfüllen, zu einem Pfadabbruch. Darüber hinaus muss ein Pfad nicht weiterverfolgt werden, falls der Schnittpunkt auf der Zielgeometrie liegt oder falls die Distanz von der Quelle zu dem Schnittpunkt die minimale Luftstreckendistanz bereits überschreitet.

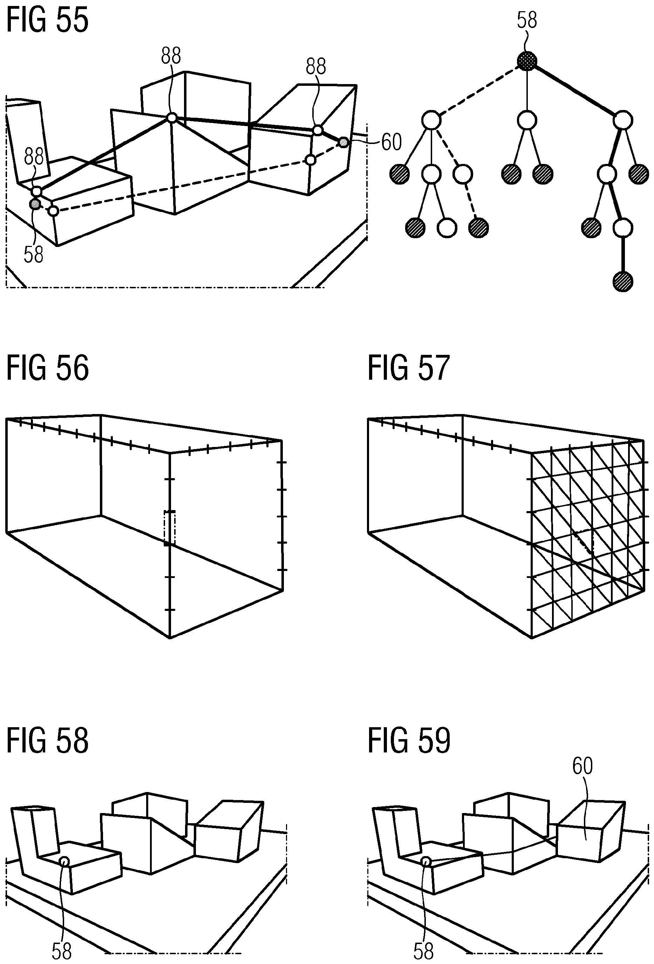

Die erzeugte Baumstruktur stellt einen vereinfachten Sichtbarkeitsgraphen der Szene dar, da jedes benachbarte Knotenpaar das Sichtbarkeitskriterium erfüllt. Mit Hilfe dieser Datenstruktur kann nun von jedem Blattknoten aus der optimale Pfad zur Quelle effizient rekonstruiert werden, indem von dem jeweiligen Blattknoten der Baum zum Wurzelknoten traversiert wird. Dabei entspricht jede Verbindung zwischen zwei Knoten genau der euklidischen Distanz zwischen den korrespondierenden Punkten auf der Baueinheit. FIG 55 zeigt links mögliche Pfadverläufe auf einer Baueinheit und rechts die dazugehörige schematische Baumstruktur. Links sind mögliche Pfadverläufe von der Quelle 58 zum Zielpunkt 60 dargestellt. Rechts ist eine dazugehörige Baumstruktur gezeigt. Die Wurzel entspricht der Quelle 58 und die inneren Knoten 88 sind Schnittpunkte mit konvexen Kanten, die das Sichtbarkeits- und das Silhouettenkriterium erfüllen. Die Blattknoten sind Zielpunkte bzw. Schnittpunkte, die das Silhouettenkriterium nicht erfüllen oder die die maximale Luftstreckendistanz überschritten haben.

Anhand des Konzepts der Strahlenverfolgung kann ein Distanzfeld auf dem zu testenden Bauteil konstruiert werden. Dazu werden alle konvexen Kanten zunächst in diskrete Slot unterteilt, wobei die Slotgröße vom Anwender individuell festgelegt werden kann (vgl. FIG 56). Hierbei ist zu berücksichtigen, dass die Größe der Slots die Performanz direkt beeinflusst und eine Korrelation zwischen Slotgröße und Genauigkeit der berechneten Luftstrecke vorliegt: Je kleiner die Slotgröße, umso genauer die ermittelte Distanz, jedoch desto länger die Laufzeit des Algorithmus.

Wird ein Slot von einem optimalen Strahl erreicht, so werden für diesen Slot folgende Informationen gespeichert:

- die zurückgelegte Distanz bis zur Quelle,

- die 3D Koordinate des Schnittpunktes mit der Slotkante,

- der Vorgängerknoten um den optimalen Pfad zu diesem Slot rekonstruieren zu können .

Wurde ein Slot bereits von einem anderen Strahl getroffen, so wird der Sloteintrag nur dann verändert, falls der neue Distanzwert kleiner ist als der bereits für diesen Slot gespeicherte. Damit wird sichergestellt, dass das Distanzfeld optimal bleibt. Dieses Distanzfeld wird auch das Ausbreitungsdistanzfeld genannt, da es sich nur auf Objektkanten von Hindernissen ausbreiten kann (vgl. FIG 58).

Falls eine Luftstreckenanalyse zu einem polygonalen Objekt durchgeführt werden soll, muss zusätzlich zu dem Ausbreitungsdistanzfeld auf Objektkanten auch ein Distanzfeld auf der Zielgeometrie definiert werden (vgl. FIG 57). Auf der Zielgeometrie ist es wichtig, dass nicht nur die Kanten betrachtet werden, sondern die ganze Oberfläche des Zielobjektes, da der kürzeste Pfad zur Zielgeometrie nicht zwingend auf den Kanten des Objektes liegen muss. Ähnlich wie bei Kanten, wird die Oberfläche in diskrete Flächenelemente unterteilt, die Informationen über die Distanz zur Quelle sowie den Pfad enthalten, der zu diesem Element führte. FIG 59 zeigt ein Ausbreitungsdistanzfeld sowie ein Distanzfeld auf der Zielgeometrie.

Um ein kontinuierliches Distanzfeld gewährleisten zu können, müssen alle Slots bzw. Flächenelemente mindestens einmal von einem optimalen Pfad getroffen werden. Durch die strahlenförmige Ausbreitung muss dies aber nicht immer der Fall sein, da sich mit dem Abstand der Slots zur Quelle die Strahlendichte verringert. Nichtsdestotrotz lassen sich nicht getroffene Slots leicht identifizieren und können beseitigt werden.

Im Folgenden wird die Erweiterung um Polygonale Quellen und leitende Objekte behandelt. Diese werden behandelt, indem gezielt in einem gewissen Bereich neue Strahlen von der Quelle aus emittiert werden. Um den korrekten Bereich zu finden, werden zunächst benachbarte Slots festgestellt, die bereits von einem optimalen Strahl getroffen wurden und zwischen denen sich der leere Slot befindet. Diese Strahlen werden dann bis zur Quelle zurückverfolgt. Anhand der Quelle und der ersten Schnittpunkte mit dem Bauteil kann dann der Bereich festgestellt werden, in dem die Strahlendichte erhöht werden muss. Die neuen Strahlen werden dann wiederum auf ihrem optimalen Pfad auf dem Bauteil ausgebreitet. Dies kann rekursiv wiederholt werden bis alle Slots von mindestens einem optimalen Strahl getroffen wurden. Defekte Slots, das heißt, Slots deren Werte Diskontinuitäten im Distanzfeld erwirken, können ebenfalls auf diese Weise korrigiert werden.

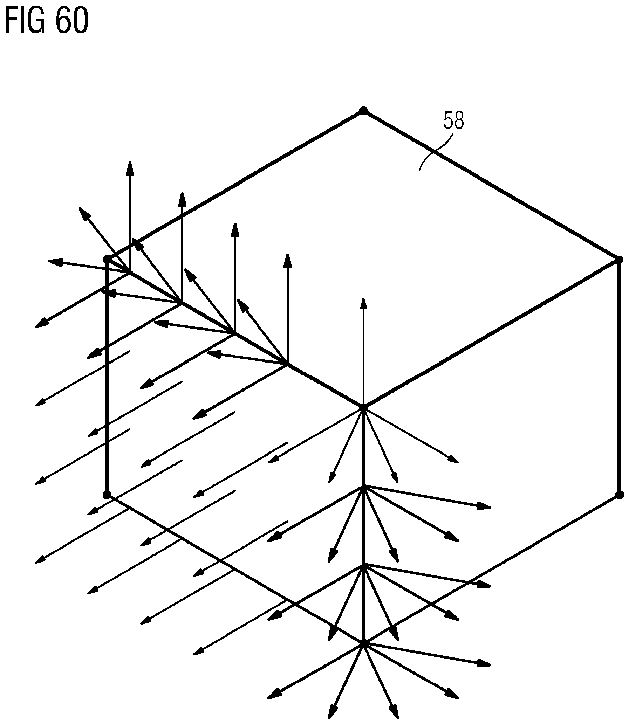

Der Strahlenschuss-Algorithmus kann um polygonale Quellen erweitert werden, indem bereits die Anfangsstrahlen in ihren Ausbreitungsrichtungen begrenzt werden. Die von der polygonalen Quelle ausgehenden Strahlen werden dabei in Kanten-, Eckpunkt- und Flächenstrahlen eingeteilt. Flächenstrahlen können sich einzig in Richtung der Flächennormalen ausbreiten. Dabei wird die Fläche der polygonalen Quelle diskret abgetastet und für jeden Abtastpunkt ein Strahl in Richtung der Flächenormalen emittiert. An Kanten der polygonalen Quelle können Anfangsstrahlen nur eine radiale Ausbreitung erfahren, wobei die radiale Ausbreitung zwischen den zwei Normalen der anliegenden Flächen an der Kante erfolgt. An Eckpunkten können Anfangsstrahlen nur innerhalb eines sphärischen Bereichs emittiert werden, der von den am Eckpunkt anliegenden Flächennormalen begrenzt wird. FIG 60 zeigt eine polygonale Quelle und die Strahlen, die von ihr emittiert werden. In der bei weiterer Ausbreitung resultierenden Baumstruktur setzt sich die polygonale Quelle aus mehreren Wurzelknoten zusammen, die wiederum einen eigenen Teilbaum enthalten.

Elektrisch leitende Objekte können auch leicht in den bestehenden Algorithmus eingebaut werden. Dabei wird ein elektrisches Bauteil sowohl als Ziel- als auch als neues Quellobjekt modelliert. Die Distanz, die der Pfad auf dem elektrischen Leiter zurücklegen würde, wird nicht mit einberechnet und die Luftstrecke ergibt sich aus den Distanzen zwischen Quellobjekt und elektrischem Leiter sowie zwischen elektrischem Leiter und dem Zielobjekt.

Die Vorberechnungen für die Analyse sind für ein Bauteil nur einmal nötig und können für den weiteren Verlauf zwischengespeichert, und bei Bedarf wieder geladen werden. Falls das Bauteil verändert wird, sind jedoch auch die entsprechenden Vorberechnungen zu aktualisieren. Dies kann bei kleinen Änderungen auch lokal geschehen was die Zeit für die Vorberechnungen deutlich verkürzt.

Für die Luftstreckenanalyse werden zwei Vorberechnungen durchgeführt.

Der Hauptbestandteil der Luftstreckenanalyse ist die effiziente Strahlenausbreitung an konvexen Kanten isolierender Bauteile. Bei der Ausbreitung wird für jeden an einer konvexen Kante ankommenden Strahl sein weiterer Wegverlauf ermittelt. Dazu wird ein Kegelschnitt mit allen konvexen Kanten isolierender Teile durchgeführt. Bei großen Datenmengen erhöht sich natürlich die Anzahl an konvexen Kanten und somit die Anzahl der Schnittpunktberechnungen. Um diese Anzahl zu reduzieren, werden während eines Vorberechnungsschrittes, für alle konvexen Kanten alle ihre potentiellen konvexen Kanten von Isolatoren ermittelt, die innerhalb einer vorgegebenen Distanz, zum Beispiel der maximalen Luftstrecke, liegen. Diese potentiellen Ausbreitungspartner werden dann in einer Datei gespeichert. Die Reduktion von möglichen Ausbreitungskanten verringert sich damit auf durchschnittlich etwa 10% aller Isolatorkanten in der gesamten Baueinheit je konvexe Kante. Je kleiner die initiale Distanz gesetzt wird, desto weniger potentielle Ausbreitungspartner pro konvexe Kante und desto effizienter kann die Luftstreckenanalyse durchgeführt werden.

Weitere Besonderheiten können sich bei Ausbreitungspartnern polygonaler Quellen ergeben.

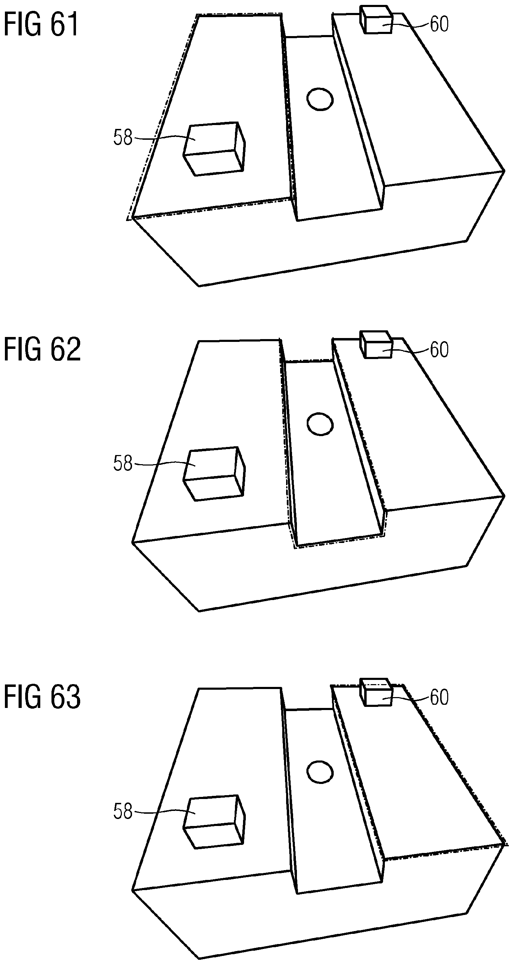

Originalbauteile beinhalten große und sehr komplexe Quellen, von denen sich Luftstrecken ausbreiten können. Solche Quellen bestehen oft aus etwa 10.000 Quellpunkten, die intern wiederum unterteilt werden in Punkt-, Kanten- und Flächenquellen. Die Berechnung der ersten Ausbreitungswelle kann dementsprechend aufwändig sein, da zu jedem Quellpunkt die nächsten konvexen Kanten zunächst ermittelt und danach auf Sichtbarkeit überprüft werden müssen. Da jedoch Quellen während der Analyse oft wieder verwendet werden, wie zum Beispiel bei leitenden Teilen, ist es völlig ausreichend diese Berechnung als Vorverarbeitungsschritt einmal durchzuführen. Dazu wird jede elektrisch leitende Komponente als Quelle definiert und ihre potentiellen konvexen Ausbreitungskanten an isolierenden Teilen berechnet. Danach wird für jede konvexe Isolatorkante eine Liste gespeichert, die die potentiellen Quellpunkte der einzelnen elektrisch leitenden Teile beinhaltet. FIG 61 bis 63 zeigen Ausbreitungspartner polygonaler Quellen auf, wobei die Farben der Kanten der jeweiligen Quelle zugeordnet werden. Hat eine Kante zwei mögliche Quellen, so werden beide in einer Liste gespeichert.

Während der Luftstreckenanalyse wird auf die gespeicherte Information in zwei Fällen zurückgegriffen. Zum einen wird diese Information benutzt, um die Ausbreitung von leitenden Quellen (dies können am Anfang ein Potential und später mehrere Leiter sein) zu beschleunigen, indem die Kanten nicht von neuem gefunden werden müssen. Es müssen lediglich die einzelnen Strahlen gesetzt und ein Sichtbarkeitstest durchgeführt werden. Zum anderen wird die Vorberechnung dazu benutzt effizient ermitteln zu können, ob von einer konvexen Kante aus Ziele wie beispielsweise das Zielpotential bzw. elektrische Leiter in unmittelbarer Nähe erreichbar sind. Dazu muss lediglich die Liste der potentiellen Quellen einer konvexen Kante durchlaufen werden und auf Sichtbarkeit überprüft werden.

Bei Kriechstrecken kann folgender Sachverhalt ergänzend relevant sein. Solange sich die Strecke nur auf der Oberfläche bewegt, kann sich der Pfad effizient über benachbarte Dreiecke hinwegbewegen. Sobald jedoch Sprünge einer bestimmten Distanz erlaubt werden, kann man sich bei der Propagierung nicht mehr nur auf die topologischen Nachbarn beschränken, sondern muss alle Bereiche in Betracht ziehen, die sich im Radius der Sprungdistanz befinden. Diese Berechnung wäre zur Laufzeit sehr aufwändig, weshalb sie vorzugsweise vorberechnet werden kann. Für jedes Dreieck und jede Kante werden alle anderen Dreiecke und Kanten berechnet, die sich in Sprungdistanz befinden. Diese Information wird automatisch in einer Datei gespeichert und kann jederzeit im Programm wieder geladen werden. Der Speicherverbrauch für diese Berechnung liegt für das Testbauteil bei etwa 500 MB und die Vorberechnungszeit beträgt etwa 20 Minuten.

Die voranstehend beschriebenen Ausführungsbeispiele dienen lediglich der Erläuterung der Erfindung und sind für diese nicht beschränkend. Insbesondere können natürlich Merkmale der Ansprüche und der Beschreibung in nahezu beliebiger Weise miteinander kombiniert werden, um zu weiteren Ausgestaltungen gemäß der Erfindung zu gelangen. Darüber hinaus können natürlich Vorrichtungsmerkmale durch entsprechende Verfahrensschritte und umgekehrt realisiert sein.

**Patentansprüche**

1. Datenverarbeitende Einrichtung (18) zum Ermitteln eines kürzesten bestimmungsfremden Strompfades zwischen wenigstens zwei in einem bestimmungsgemäßen Betrieb mit einem unterschiedlichen elektrischen Potential beaufschlagten elektrisch leitfähigen Bauteilen einer eine Mehrzahl von elektrisch leitfähigen und elektrisch isolierenden Bauteilen aufweisenden elektrischen Baueinheit (10), mit:

a) einer Bauteilerfassungseinheit zum Erfassen von allen Bauteilen der Baueinheit (10) und deren Geometrie,
b) einer Anordnungserfassungseinheit zum Erfassen der Anordnung der Bauteile in der Baueinheit (10) zueinander,
c) einer Werkstofferfassungseinheit zum Erfassen von Werkstoffeigenschaften der erfassten Bauteile und/oder Zuordnen von Werkstoffeigenschaften zu den Bauteilen,
d) einer Leitfähigkeitsermittlungseinheit zum Ermitteln der elektrisch leitfähigen Bauteile anhand der Werkstoffeigenschaften sowie deren elektrisches Potential im bestimmungsgemäßen Betrieb,
e) einer Auswähleinheit zum Auswählen eines im bestimmungsgemäßen Betrieb mit einem ersten elektrischen Potential beaufschlagten ersten elektrisch leitfähigen Bauteils,
f) einer Strahlerzeugungseinheit zum Erzeugen einer Mehrzahl von geraden und/oder richtungsändernden Strahlen, deren Startpunkt das erste Bauteil bildet, indem für die digitalisiert gerastert erfassten Bauteile konvexe Bauteilkanten ermittelt werden und die Strahlen ermittelt werden, die unmittelbar eine konvexe Bauteilkante treffen, und wobei ein Punkt des Strahles mit dem kürzesten Abstand zwischen dem ersten elektrischen Bauteil und der konvexen Bauteilkante als Schnittpunkt ermittelt wird, bei dem ein Silhouettkriterium erfüllt ist, wobei das Silhouettkriterium angibt, ob sich ein Kantenpunkt auf einer Silhouettenkante der Szene befindet, wodurch Strahlen leicht ermittelt und von der weiteren Bearbeitung ausschließbar sind, die unmittelbar auf ein Bauteil auftreffen,

g) einer Ermittlungseinheit zum Ermitteln in Abhängigkeit von der Geometrie und Anordnung der erfassten Bauteile, welche der Strahlen ein zweites elektrisches Bauteil der Baueinheit (10) treffen, welches anhand seiner Werkstoffeigenschaften als elektrisch leitfähig klassifiziert ist, wobei die Ermittlungseinheit ausgebildet ist, einen Auftreffpunkt des jeweiligen Strahls am zweiten Bauteil zu ermitteln, sofern es einen gibt,

h) einer Längenermittlungseinheit zum Ermitteln von Streckenlängen vom jeweiligen Startpunkt zum jeweiligen Auftreffpunkt derjenigen Strahlen, die ausgehend vom ersten Bauteil das zweite Bauteil treffen, und

i) einer Auswerteeinheit zum Ermitteln und Ausgeben der kürzesten der ermittelten Streckenlängen als kürzester bestimmungsfremder Strompfad.

2. Verfahren zum Ermitteln eines kürzesten bestimmungsfremden Strompfades zwischen wenigstens zwei in einem bestimmungsgemäßen Betrieb mit einem unterschiedlichen elektrischen Potential beaufschlagten elektrisch leitfähigen Bauteilen einer eine Mehrzahl von elektrisch leitfähigen und elektrisch isolierenden Bauteilen aufweisenden elektrischen Baueinheit (10), mit folgenden Schritten:

a) Erfassen von allen Bauteilen der Baueinheit (10) und deren Geometrie,

b) Erfassen der Anordnung der Bauteile in der Baueinheit (10) zueinander,

c) Erfassen von Werkstoffeigenschaften der erfassten Bauteile und/oder Zuordnen von Werkstoffeigenschaften zu den Bauteilen,

d) Ermitteln der elektrisch leitfähigen Bauteile anhand der Werkstoffeigenschaften sowie deren elektrisches Potential im bestimmungsgemäßen Betrieb,

e) Auswählen eines im bestimmungsgemäßen Betrieb mit einem ersten elektrischen Potential beaufschlagten ersten elektrisch leitfähigen Bauteils,

f) Erzeugen einer Mehrzahl von geraden und/oder richtungsändernden Strahlen, deren Startpunkt das erste Bauteil bildet, indem für die digitalisiert gerastert erfassten Bauteile konvexe Bauteilkanten ermittelt werden und die Strahlen ermittelt werden, die unmittelbar eine konvexe Bauteilkante treffen, und wobei ein Punkt des Strahles mit dem kürzesten Abstand zwischen dem ersten elektrischen Bauteil und der konvexen Bauteilkante als Schnittpunkt ermittelt wird, bei dem ein Silhouettenkriterium erfüllt ist, wobei das Silhouettenkriterium angibt, ob sich ein Kantenpunkt auf einer Silhouettenkante der Szene befindet, wodurch Strahlen leicht ermittelt und von der weiteren Bearbeitung ausgeschlossen werden, die unmittelbar auf ein Bauteil auftreffen,

g) Ermitteln in Abhängigkeit von der Geometrie und Anordnung der erfassten Bauteile, welche der Strahlen ein zweites elektrisches Bauteil der Baueinheit (10) treffen, welches anhand seiner Werkstoffeigenschaften als elektrisch leitfähig klassifiziert ist, wobei ein Auftreffpunkt des jeweiligen Strahls am zweiten Bauteil ermittelt wird, sofern es einen gibt,

h) Ermitteln von Streckenlängen vom jeweiligen Startpunkt zum jeweiligen Auftreffpunkt derjenigen Strahlen, die ausgehend vom ersten Bauteil das zweite Bauteil treffen, und

i) Ermitteln und Ausgeben der kürzesten der ermittelten Streckenlängen als kürzester bestimmungsfremder Strompfad.

3. Verfahren nach Anspruch 2, wobei das zweite elektrische Bauteil eines ist, das im bestimmungsgemäßen Betrieb mit einem zweiten elektrischen Potential beaufschlagt wird.

4. Verfahren nach Anspruch 2 oder 3, wobei jedem erfassten Bauteil ein eindeutiges Identifikationskennzeichen zugeordnet wird.

5. Verfahren nach einem der Ansprüche 2 bis 4, wobei unmittelbar aneinandergrenzende Bauteile mit gleichen Werkstoffeigenschaften zu einem gemeinsamen Bauteil verbunden werden.

6. Verfahren nach einem der Ansprüche 2 bis 5, wobei die Strahlen derart ermittelt werden, sie überwiegend entlang einer Oberfläche wenigstens eines der elektrisch isolierenden Bauteile der elektrischen Baueinheit (10) verlaufen und dass Strahlverläufe der Strahlen unter Berücksichtigung der Werkstoffeigenschaften ermittelt werden.

7. Verfahren nach einem der Ansprüche 2 bis 6, wobei jedem erfassten Bauteil ein CTI-Wert zu geordnet wird.

8. Verfahren nach einem der Ansprüche 2 bis 7, wobei ein elektrisch leitfähiges Bauteil, dass im bestimmungsgemäßen Betrieb elektrisch potentiallos beaufschlagt ist, als Startpunkt zum Erzeugen einer Mehrzahl von weiteren Strahlen dient.

9. Verfahren nach einem der Ansprüche 2 bis 8, wobei bei einem elektrisch isolierenden Bauteil ein Sattelpunkt ermittelt wird.

10. Verfahren nach Anspruch 9, wobei zu einem Sattelpunkt ein toter Winkel ermittelt wird und der Sattelpunkt als Startpunkt zum Erzeugen einer Mehrzahl von Sattelpunktstrahlen in einem durch den toten Winkel bestimmten Bereich dient.

11. Verfahren nach einem der Ansprüche 2 bis 10, wobei beim Ermitteln der kürzesten ermittelten Streckenlänge als kürzester bestimmungsfremder Strompfad ein Sprung mit einer vorgegebenen maximalen Sprungweite berücksichtigt wird.

12. Verfahren nach einem der Ansprüche 2 bis 11, wobei die kürzeste ermittelte Streckenlänge mit einem vorgegeben Vergleichswert verglichen wird und bei Unterschreiten des Vergleichswerts eine Meldung ausgegeben wird.

13. Verfahren nach einem der vorhergehenden Ansprüche, wobei die Strahlen, die das zweite elektrisch leitfähige Bauteil unmittelbar treffen, ermittelt werden.

14. Verfahren nach einem der vorhergehenden Ansprüche, wobei der Schnittpunkt als Startpunkt zum Erzeugen einer Mehrzahl von Kantenstrahlen dient, wobei vorzugsweise nur Strahlen in einem vorgegebenen Bereich erzeugt werden.

15. Verfahren nach Anspruch 14, wobei der vorgegebene Bereich durch einen Ausbreitungskegel oder ein Ausbreitungsfrustum gebildet ist.

16. Rechnerprogrammprodukt umfassend ein Programm für eine Rechnereinheit mit Programmkodeabschnitten eines Programms zum Ausführen der Schritte eines Verfahrens nach einem der Ansprüche 2 bis 15, wenn das Programm durch die Rechnereinheit ausgeführt wird, so dass die Rechnereinheit wenigstens einen kürzesten bestimmungsfremden Strompfad in einer elektrischen Baueinheit (10) ermittelt.

17. Rechnerprogrammprodukt nach Anspruch 16, wobei das Rechnerprogrammprodukt ein rechner-lesbares Medium umfasst, auf welchem die Programmkodeabschnitte gespeichert sind.

18. Rechnerprogrammprodukt nach Anspruch 16 oder 17, wobei das Programm direkt in einen internen Speicher der Rechnereinheit ladbar ist.

**Claims**

1. Data-processing device (18) for determining a shortest improper current path between at least two electrically conductive components, to which a different electrical potential is applied during normal operation, of an electrical assembly (10) having a plurality of electrically conductive and electrically insulating components, with:

a) a component detection unit for detecting all components of the assembly (10) and their geometry,
b) an arrangement detection unit for detecting the arrangement of the components in the assembly (10) relative to one another,
c) a material detection unit for detecting material properties of the detected components and/or assigning material properties to the components,
d) a conductivity determination unit for determining the electrically conductive components on the basis of the material properties and their electrical potential during normal operation,
e) a selection unit for selecting a first electrically conductive component, to which a first electrical potential during normal operation is applied,
f) a beam generation unit for generating a plurality of straight and/or direction-changing beams, the starting point of which forms the first component, by convex component edges being determined for the components detected in a rasterized digital manner and the beams which strike a convex component edge directly being determined, and wherein a point of the beam with the shortest distance between the first electrical component and the convex component edge is determined as a point of intersection, in which a silhouette criterion is fulfilled, wherein the silhouette criterion specifies whether an edge point is located on a silhouette edge of the scene, as a result of which beams which strike a component directly are easily determined and can be excluded from the further processing,

g) a determination unit for determining, as a function of the geometry and arrangement of the detected components, which of the beams strike a second electrical component of the assembly (10), which is classified as electrically conductive on the basis of its material properties, wherein the determination unit is embodied to determine a point of impact of the respective beam on the second component, provided there is one,

h) a length determination unit for determining path lengths from the respective starting point to the respective point of impact of those beams which strike the second component starting from the first component, and

i) an evaluation unit for determining and outputting the shortest of the determined path lengths as the shortest improper current path.

2. Method for determining a shortest improper current path between at least two electrically conductive components, to which a different electrical potential is applied during normal operation, of an electrical assembly having a plurality of electrically conductive and electrically insulating components, with the following steps:

a) detecting all components of the assembly (10) and their geometry,

b) detecting the arrangement of the components in the assembly (10) with respect to one another,

c) detecting material properties of the detected components and/or assigning material properties to the components,

d) determining the electrically conductive components on the basis of the material properties and their electrical potential during normal operation,

e) selecting a first electrically conductive component, to whicha first electrical potential is applied during normal operation,

f) generating a plurality of straight and/or direction-changing beams, the starting point of which forms the first component, by convex component edges being determined for the components detected in a rasterized digital manner, and the beams which strike a convex component edge directly being determined, and wherein a point of the beam with the shortest distance between the first electrical component and the convex component edge is determined as a point of intersection, in which a silhouette criterion is fulfilled, wherein the silhouette criterion specifies whether an edge point is located on a silhouette edge of the scene, as a result of which beams which strike a component directly are easily determined and excluded from the further processing,

g) determining, as a function of the geometry and arrangement of the detected components, which of the beams strike a second electrical component of the assembly (10), which is classified as electrically conductive on the basis of its material properties, wherein a point of impact of the respective beam on the second component is determined, provided there is one,

h) determining path lengths from the respective starting point to the respective point of impact of those beams which strike the second component starting from the first component, and

i) determining and outputting the shortest of the determined path lengths as the shortest improper current path.

3. Method according to claim 2, wherein the second electrical component is one to which a second electrical potential is applied during normal operation.

4. Method according to claim 2 or 3, wherein a unique identification label is assigned to each detected component.

5. Method according to one of claims 2 to 4, wherein components adjoining one another directly are connected with identical material properties to form a shared component.

6. Method according to one of claims 2 to 5, wherein the beams are determined so that they run predominantly along a surface of at least one of the electrically insulating components of the electrical assembly (10) and that beam courses of the beams are determined by taking into account the material properties.

7. Method according to one of claims 2 to 6, wherein a CTI value is assigned to each detected component.

8. Method according to one of claims 2 to 7, wherein an electrically conductive component, which is applied electrically without potential during normal operation, is used as a starting point for generating a plurality of further beams.

9. Method according to one of claims 2 to 8, wherein a saddle point is determined with an electrically insulating component.

10. Method according to claim 9, wherein a dead angle is determined at a saddle point and the saddle point is used as a starting point for generating a plurality of saddle point beams in a region determined by the dead angle.

11. Method according to one of claims 2 to 10, wherein when the shortest determined path length is determined as the shortest improper current path, a jump with a predetermined maximum jump width is taken into account.

12. Method according to one of claims 2 to 11, wherein the shortest determined path length is compared with a predetermined comparison value and a message is output if the comparison value is not met.

13. Method according to one of the preceding claims, wherein the beams which strike the second electrically conductive component directly are determined.

14. Method according to one of the preceding claims, wherein the point of intersection is used as a starting point for generating a plurality of edge beams, wherein beams are preferably only generated in a predetermined region.

15. Method according to claim 14, wherein the predetermined region is formed by a propagation cone or a propagation frustum.

16. Computer program product comprising a program for a computing unit with program code portions of a program for executing the steps of a method according to one of claims 2 to 15 when the program is executed by the computing unit, so that the computing unit determines at least one shortest improper current path in an electrical assembly (10).

17. Computer program product according to claim 16, wherein the computer program product comprises a computer-readable medium, on which the program code portions are stored.

18. Computer program product according to claim 16 or 17, wherein the program can be loaded directly into an internal memory of the computing unit.

**Revendications**

1. Dispositif (18) de traitement de données pour la détermination d'un trajet de courant le plus court, non conforme aux prescriptions, entre au moins deux composants conducteurs électriquement, soumis, dans un fonctionnement conforme aux prescriptions, à un potentiel électrique différent, d'un bloc (10) électrique ayant une pluralité de composants conducteurs électriquement et isolants électriquement, comprenant :

   a) une unité de détection de composant pour la détection de tous les composants du bloc (10) électrique et de leur géométrie,
   b) une unité de détection d'agencement pour la détection de l'agencement des composants dans le bloc (10) électrique les uns par rapport aux autres,
   c) une unité de détection de matériau pour la détection de propriétés de matériaux des composants détectés et/ou pour l'association de propriétés de matériau aux composants,
   d) une unité de détermination de conductivité pour la détermination des composants conducteurs électriquement à l'aide des propriétés de matériau, ainsi que de leur potentiel électrique dans un fonctionnement conforme aux prescriptions,
   e) une unité de sélection pour la sélection d'un premier composant conducteur électriquement soumis dans un fonctionnement conforme aux prescriptions à un premier potentiel électrique,
   f) une unité de production de rayonnement pour la production d'une pluralité de rayonnements rectilignes et/ou dont la direction se modifie, dont le point d'origine forme le premier composant en déterminant pour les composants détectés tramés numériquement, des bords convexes de composants et en déterminant les rayonnements, qui arrivent directement sur un bord convexe du composant et, dans lequel on détermine un point du rayonnement ayant la distance la plus courte entre le premier composant électrique et le bord convexe du composant comme point d'intersection, où un critère de silhouette est satisfait, le critère de silhouette indiquant si un point de bord se trouve sur un bord de silhouette de la scène, grâce à quoi des rayonnements, qui arrivent directement sur un composant, sont déterminés facilement et peuvent être exclus du traitement supplémentaire,
   g) une unité de détermination pour la détermination, en fonction de la géométrie et de l'agencement des composants détectés, des rayonnements, qui arrivent sur un deuxième composant électrique du bloc (10) électrique, deuxième composant qui peut être classé comme conducteur électriquement à l'aide de ses propriétés de matériau, l'unité de détermination étant constituée pour déterminer un point d'arrivée du rayonnement respectif sur le deuxième composant dans la mesure où il y en a un,
   h) une unité de détermination de longueur pour la détermination de longueurs de chemin du point d'origine respectif au point d'arrivée respectif des rayonnements qui, en partant du premier composant, arrivent sur le deuxième composant, et

i) une unité d'exploitation pour l'exploitation et l'émission de la plus courte des longueurs de chemin déterminées comme trajet du courant le plus court non conforme aux prescriptions.

**2.** Procédé de détermination d'un trajet de courant le plus court, non conforme aux prescriptions, entre au moins deux composants conducteurs électriquement, soumis, dans un fonctionnement conforme aux prescriptions, à un potentiel électrique différent, d'un bloc (10) électrique ayant une pluralité de composants conducteurs électriquement et isolants électriquement, comprenant les stades suivants :

a) détermination de tous les composants du bloc (10) électrique et de leur géométrie,

b) détection de l'agencement des composants dans le bloc (10) électrique les uns par rapport aux autres,

c) détection de propriété de matériau des composants détectés et/ou de l'association de propriétés de matériau aux composants,

d) détermination des composants conducteurs électriquement à l'aide des propriétés de matériau ainsi que de leur potentiel électrique en fonctionnement conforme aux prescriptions.

e) sélection d'un premier composant conducteur électriquement soumis à un premier potentiel électrique en fonctionnement conforme aux prescriptions,

f) production d'une pluralité de rayonnements rectilignes et/ou dont la direction se modifie, dont le point d'origine forme le premier composant, en déterminant, pour les composants détectés tramés numériquement, des bords convexes de composant et en déterminant les rayonnements, qui arrivent directement sur un bord convexe du composant et dans lequel on détermine un point du rayonnement ayant la distance la plus courte entre le premier composant électrique et le bord convexe du composant comme point d'intersection, où un critère de silhouette est satisfait, le critère de silhouette indiquant si un point de bord se trouve sur un bord de silhouette de la scène, grâce à quoi des rayonnements, qui arrivent directement sur un composant sont déterminés facilement et peuvent être exclus du traitement supplémentaire,

g) détermination, en fonction de la géométrie et de l'agencement des composants détectés, des rayonnements, qui arrivent sur un deuxième composant électrique du bloc (10) électrique, deuxième composant qui peut être classé comme conducteur électriquement à l'aide de ses propriétés de matériau, l'unité de détermination étant constituée pour déterminer un point d'arrivée du rayonnement respectif sur le deuxième composant dans la mesure où il y en a un,

h) détermination de longueurs de chemin du point d'origine respectif au point d'arrivée respectif des rayonnements, qui, en partant du premier composant, arrivent sur le deuxième composant, et

i) détermination de la plus courte des longueurs de chemin déterminées comme trajet de courant le plus court non conforme aux prescriptions.

**3.** Procédé suivant la revendication 2, dans lequel le deuxième composant électrique est un composant que l'on soumet en fonctionnement conforme aux prescriptions à un deuxième potentiel électrique.

**4.** Procédé suivant la revendication 2 ou 3, **caractérisé en ce que** l'on associe une caractéristique d'identification univoque à chaque composant détecté.

**5.** Procédé suivant l'une des revendications 2 à 4, **caractérisé en ce que** l'on relie en un composant commun des composants directement voisins ayant des mêmes propriétés de matériau.

**6.** Procédé suivant l'une des revendications 2 à 5, dans lequel on détermine les rayonnements qui, d'une manière prépondérante, s'étendent le long d'une surface d'au moins l'un des composants isolants électriquement du bloc (10) électrique et en ce que l'on détermine des trajets des rayonnements en tenant compte des propriétés de matériau.

**7.** Procédé suivant l'une des revendications 2 à 6, **caractérisé en ce que** l'on associe une valeur CTI à chaque composant détecté.

**8.** Procédé suivant l'une des revendications 2 à 7, **caractérisé en ce qu'**un composant conducteur électriquement, qui en fonctionnement conforme aux prescriptions n'est pas soumis à un potentiel électrique, sert de point d'origine pour la production d'une pluralité d'autres rayonnements.

**9.** Procédé suivant l'une des revendications 2 à 8, dans lequel on détermine un point hyperbolique pour un composant isolant électriquement.

**10.** Procédé suivant la revendication 9, dans lequel on détermine un angle mort par rapport à un point hyperbolique et le point hyperbolique sert de point d'origine pour la production d'une pluralité de rayonnements de points hyperboliques dans une partie déterminée par l'angle mort.

**11.** Procédé suivant l'une des revendications 2 à 10, dans lequel, lors de la détermination de la longueur de chemin déterminée la plus courte comme trajet de courant le plus court non conforme aux prescriptions, on tient compte d'un saut d'une largeur maximum donnée à l'avance.

**12.** Procédé suivant l'une des revendications 2 à 11, dans lequel on compare la longueur de chemin déterminée la plus courte à une valeur de comparaison donnée à l'avance et, si l'on passe en dessous de la valeur de comparaison, on émet un message.

**13.** Procédé suivant l'une des revendications précédentes, dans lequel on détermine les rayonnements qui arrivent directement sur le deuxième composant conducteur électriquement.

**14.** Procédé suivant l'une des revendications précédentes, dans lequel le point d'intersection sert de point d'origine pour la production d'une pluralité de rayonnements de bord, de préférence seulement des rayonnements dans une partie donnée à l'avance étant produits.

**15.** Procédé suivant la revendication 14, dans lequel la partie donnée à l'avance est formée par un cône de propagation ou un tronc de cône de propagation.

**16.** Produit de programme d'ordinateur, comprenant un programme pour une unité informatique ayant des parties de code d'un programme pour l'exécution des stades d'un procédé suivant l'une des revendications 2 à 15, lorsque le programme est réalisé par l'unité informatique, de sorte que l'unité informatique détermine au moins un trajet de courant le plus court non conforme aux prescriptions dans un bloc (10) électrique.

**17.** Produit de programme d'ordinateur suivant la revendication 16, dans lequel le produit de programme d'ordinateur comprend un support déchiffrable par ordinateur, sur lequel sont mémorisées les parties de code de programme.

**18.** Produit de programme d'ordinateur suivant la revendication 16 ou 17, dans lequel le programme peut être chargé directement dans une mémoire interne de l'unité informatique.

FIG 1

FIG 2

FIG 3

FIG 4

FIG 5

FIG 6

FIG 7

FIG 8

FIG 9

FIG 10

FIG 11

FIG 12

## FIG 13

## FIG 14

unverschmolzen

## FIG 15

## FIG 16

58

## FIG 17

90

FIG 18

50

92

94

FIG 19

96

180°

180°

50

# FIG 20

# FIG 21

FIG 22

FIG 23

## FIG 24

## FIG 25

FIG 26

FIG 27

FIG 28

## FIG 29

## FIG 30

## FIG 31

## FIG 32

## FIG 33

FIG 34

FIG 35

FIG 36

FIG 37

FIG 38

FIG 39

FIG 40

FIG 41

FIG 42

FIG 43

FIG 44

## FIG 45

## FIG 46

o exakter Treffer    angefragter Wert

# FIG 47

Primary Rays

Secondary Rays

Ray Propagation

Target hit

Saddle point hit

Critical Vertex hit

Critical Edge hit

Conductor hit

Jump

Path found

Saddle point queue

Reflection queue

Conductor queue

Jump queue

pseudo SP queue

queues not empty

Pseudo Saddle points?

no

FINISHED

queues empty

yes

# FIG 48

FIG 49

FIG 50

FIG 51

FIG 52

FIG 53

# FIG 54

Anfangsstrahlen

Ermittlung der
Ausbreitungsbereiche

Silhouettenkriterium

ja

nein

Pfadabbruch

nein

Zielgeometrie

ja

Pfad gefunden

Schnittpunkte
mit konvexen Kanten

je Schnittpunkt

Sichtbarkeitskriterium

ja

nein

Pfadabbruch

EP 2 953 042 B1

FIG 55

FIG 56

FIG 57

FIG 58

FIG 59

FIG 60

58

FIG 61

58

60

FIG 62

58

60

FIG 63

58

60

## FIG 64

## FIG 65

verschmolzen

FIG 66

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20040254749 A1

- US 20060282811 A1

**In der Beschreibung aufgeführte Nicht-Patentliteratur**

- **DIRK MÜLLER et al.** Elektronikpraxis. electronica Magazine, Januar 2010, 12-14

- FINDING THE SHORTEST PATH FOR QUALITY ASSURANCE OF ELECTRIC COMPONENTS. *Proceedings of DETC'02 ASME 2002 Design Engineering Technical Conference*